(19) Europäisches Patentamt
European Patent Office
Office européen des brevets

(11) **EP 4 586 235 A1**

(12) **EUROPEAN PATENT APPLICATION**
published in accordance with Art. 153(4) EPC

(43) Date of publication:
**16.07.2025   Bulletin 2025/29**

(21) Application number: **23951218.9**

(22) Date of filing: **08.09.2023**

(51) International Patent Classification (IPC):
**G09G 3/3208** (2016.01)

(52) Cooperative Patent Classification (CPC):
**G09G 3/3208**

(86) International application number:
**PCT/CN2023/117826**

(87) International publication number:
**WO 2025/050399 (13.03.2025 Gazette 2025/11)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.
Beijing 100015 (CN)**
• **Chengdu BOE Optoelectronics Technology Co.,
Ltd.
Chengdu, Sichuan 611731 (CN)**

(72) Inventors:
• **FANG, Fei
Beijing 100176 (CN)**
• **SHI, Ling
Beijing 100176 (CN)**
• **YAN, Zhenglong
Beijing 100176 (CN)**
• **ZHANG, Yuxin
Beijing 100176 (CN)**

(74) Representative: **Durán-Corretjer, S.L.P.
Còrsega, 329
(Paseo de Gracia/Diagonal)
08037 Barcelona (ES)**

(54)   **DISPLAY SUBSTRATE AND DISPLAY APPARATUS**

(57)   A display substrate, comprising a first display area (A1), the first display area (A1) comprising a plurality of display island areas (A11) and a plurality of light-transmitting areas (A12) arranged in an array. The first display area (A1) satisfies at least one of the following: the display island areas (A11) and the light-transmitting areas (A12) are alternately arranged in the row direction, and the display island areas (A11) and the light-transmitting areas (A12) are alternately arranged in the column direction. Each display island area (A11) comprises: at least one first pixel circuit (11) and at least one first light-emitting element (13), wherein the at least one first pixel circuit (11) is electrically connected to the at least one first light-emitting element (13), and is configured to drive the at least one first light-emitting element (13) to emit light.

FIG. 5

EP 4 586 235 A1

**Description**

Technical Field

The present disclosure relates to, but is not limited to, the field of display technologies, in particular to a display substrate and a display device.

Background

An Organic Light Emitting Diode (OLED) and a Quantum-dot Light Emitting Diode (QLED) are active light emitting display devices and have advantages of self-luminescence, wide viewing angle, high contrast ratio, low power consumption, very high response speed, lightness and thinness, bendability, and low cost, etc.

Summary

The following is a summary of subject matter described herein in detail. This summary is not intended to limit the protection scope of claims.

Embodiments of the present disclosure provide a display substrate and a display device.

In one aspect, an embodiment provides a display substrate, including: a first display area, the first display area including: a plurality of display island regions and a plurality of light-transmitting regions arranged in an array. The first display area satisfies at least one of: the display island regions and the light-transmitting regions are arranged alternately in a row direction, and the display island regions and the light-transmitting regions are arranged alternately in a column direction. A display island region includes: at least one first pixel circuit and at least one first light emitting element, wherein the at least one first pixel circuit is electrically connected to the at least one first light emitting element and configured to drive the at least one first light emitting element to emit light.

In some exemplary implementations, in the row direction, the display island regions and the light-transmitting regions are arranged alternately and aligned; and in the column direction, the plurality of display island regions are arranged continuously in a staggered manner, or the plurality of display island regions are arranged continuously and aligned, or the display island regions and the light-transmitting regions are arranged alternately and aligned.

In some exemplary implementations, for a column of display island regions, display island regions in odd-numbered rows are aligned, and display island regions in even-numbered rows are aligned; and adjacent display island regions in a column of display island regions are arranged in a staggered manner.

In some exemplary implementations, one of the display island regions includes: a first pixel circuits arranged sequentially in the row direction, where a is an integer greater than 1. A misalignment distance in the row direction between adjacent display island regions in a column of display island regions is greater than or equal to a length of one first pixel circuit in the row direction and smaller than or equal to lengths of a-1 first pixel circuits in the row direction.

In some exemplary implementations, each display island region in a j-th column has a first edge close to a (j-1)-th column of display island regions and a second edge close to a (j+1)-th column of display island regions in the row direction; a centerline of a display island region in an i-th row and the j-th column in the row direction is aligned with a first edge of a display island region in an (i+1)-th row and the j-th column; and a centerline of a display island region in the (i+1)-th row and the j-th column in the row direction is aligned with a second edge of a display island region in the i-th row and the j-th column, wherein i and j are each an integer greater than 0.

In some exemplary implementations, in the column direction, one of the light-transmitting regions is aligned with a half of an adjacent display island region.

In some exemplary implementations, the plurality of display island regions include: a plurality of first display island regions and a plurality of second display island regions; display island regions in odd-numbered columns include a plurality of first display island regions arranged sequentially in the column direction, and display island regions in even-numbered columns include a plurality of second display island regions arranged sequentially in the column direction; and an arrangement order of a plurality of first light emitting elements included in a first display island region is different from an arrangement order of a plurality of first light emitting elements included in a second display island region.

In some exemplary implementations, light-transmitting regions adjacent in the column direction are arranged in a staggered manner in the row direction.

In some exemplary implementations, a misalignment distance in the row direction between light-transmitting regions adjacent in the column direction is greater than or equal to a length of one first pixel circuit in the row direction and smaller than or equal to lengths of a-1 first pixel circuits in the row direction.

In some exemplary implementations, one of the display island regions includes a plurality of first light emitting elements, and the plurality of first light emitting elements in the plurality of display island regions are arranged in a same manner.

In some exemplary implementations, in the row direction, the display island regions and the light-transmitting regions are arranged alternately and aligned, and in the column direction, the display island regions and the light-transmitting regions are arranged alternately and aligned; and the plurality of display island regions include: a plurality of first display island regions and a plurality of second display island regions. Display island regions in odd-numbered columns include: a plurality of first display island regions arranged alternately with light-transmitting regions in the column direction, and display island regions in even-numbered columns include: a plurality of second display island regions arranged alternately with light-transmitting regions in the column direction. An arrangement order of a plurality of first light emitting elements included in a first display island region is different from an arrangement order of a plurality of first light emitting elements included in a second display island region.

In some exemplary implementations, each display island region includes four first pixel circuits arranged sequentially in the row direction, and four first light emitting elements electrically connected to the four first pixel circuits in one-to-one correspondence, and an orthographic projection of a first light emitting element on a base substrate is at least partially overlapped with an orthographic projection of a first pixel circuit to which the first light emitting element is connected on the base substrate. The four first light emitting elements include: a first light emitting element emitting light of a first color, a first light emitting element emitting light of a second color, and two first light emitting elements emitting light of a third color. An arrangement order of first light emitting elements emitting light of the first color and first light emitting elements emitting light of the second color in a first display island region is opposite to an arrangement order of first light emitting elements emitting light of the first color and first light emitting elements emitting light of the second color in a second display island region.

In some exemplary implementations, in the row direction, the display island regions and the light-transmitting regions are arranged alternately and aligned, and in the column direction, the display island regions and the light-transmitting regions are arranged alternately and aligned. Each display island region includes one first pixel circuit and one first light emitting element. The plurality of display island regions include: a plurality of third display island regions, a plurality of fourth display island regions, and a plurality of fifth display island regions; display island regions in odd-numbered rows include: a plurality of third display island regions and a plurality of fourth display island regions arranged alternately; and display island regions in even-numbered rows include: a plurality of fifth display island regions. The first light emitting elements in the third display island regions, the fourth display island regions, and the fifth display island regions emit light of different colors.

In some exemplary implementations, one of the third display island regions includes: one first light emitting element emitting light of the first color; one of the fourth display island regions includes: one first light emitting element emitting light of the second color; and one of the fifth display island regions includes: one first light emitting element emitting light of the third color.

In some exemplary implementations, the display substrate further includes: a second display area located on at least one side of the first display area, wherein the second display area includes: at least one second pixel circuit and at least one second light emitting element, and the at least one second pixel circuit is electrically connected to the at least one second light emitting element and configured to drive the at least one second light emitting element to emit light. An arrangement density of first pixel circuits in the first display area is smaller than an arrangement density of second pixel circuits in the second display area.

In some exemplary implementations, an arrangement density of first pixel circuits in the first display area in the row direction is 1/2 or 1/3 of an arrangement density of second pixel circuits in the second display area in the row direction.

In some exemplary implementations, in a direction perpendicular to the display substrate, the display substrate includes: a base substrate, and a circuit structure layer and a light emitting structure layer located on the base substrate; the circuit structure layer includes: a plurality of first pixel circuits, one of the first pixel circuits includes: at least one first-type transistor, at least one second-type transistor, and a storage capacitor. The circuit structure layer at least includes: a first semiconductor layer, a first conductive layer, a second conductive layer, a second semiconductor layer, a third conductive layer, and a fourth conductive layer arranged on the base substrate; the first semiconductor layer at least includes: an active layer of the at least one first-type transistor of the first pixel circuit; the first conductive layer at least includes: a gate electrode of the at least one first-type transistor of the first pixel circuit, and a first electrode of the storage capacitor; the second conductive layer at least includes: a second electrode of the storage capacitor of the first pixel circuit, and a bottom gate of the at least one second-type transistor; the second semiconductor layer at least includes: an active layer of the at least one second-type transistor of the first pixel circuit; the third conductive layer at least includes: a gate electrode of the at least one second-type transistor of the first pixel circuit; and the fourth conductive layer at least includes: a plurality of connection electrodes.

In some exemplary implementations, the circuit structure layer further includes: a fifth conductive layer and a sixth conductive layer located on a side of the fourth conductive layer away from the base substrate; the fifth conductive layer at least includes: a plurality of data lines; the sixth conductive layer at least includes: a voltage transmission line; or, the fifth conductive layer at least includes: a voltage transmission line, and the sixth conductive layer at least includes: a plurality of data lines.

In some exemplary implementations, the circuit structure layer further includes: a shielding layer located on a side of the first semiconductor layer close to the base substrate. An orthographic projection of the shielding layer on the base substrate covers an orthographic projection of the first semiconductor layer on the base substrate; or, the orthographic projection of the shielding layer on the base substrate covers orthographic projections of the first semiconductor layer and the second semiconductor layer on the base substrate.

In another aspect, an embodiment provides a display device, including the display substrate described above, and a sensor located on a non-display side of the display substrate, and an orthographic projection of the sensor on the display substrate is at least partially overlapped with the first display area of the display substrate.

In another aspect, an embodiment provides a display substrate, including: a first display area, and a second display area located on at least one side of the first display area, a light transmittance of the first display area being greater than a light transmittance of the second display area. The first display area includes: a plurality of display island regions and a plurality of light-transmitting regions arranged in an array; in a row direction, the display island regions and the light-transmitting regions are arranged alternately, or in a column direction, the display island regions and the light-transmitting regions are arranged alternately. One of the display island regions at least includes: n first pixel circuits arranged in the row direction, with n being a positive integer greater than 0; first pixel circuits in adjacent display island regions in the column direction are arranged in a staggered manner, and a misalignment distance in the row direction between adjacent display island regions is greater than or equal to a length of one first pixel circuit in the row direction and smaller than or equal to lengths of n first pixel circuits in the row direction.

In some exemplary implementations, in the column direction, one of the light-transmitting regions is aligned with a half of an adjacent display island region.

In some exemplary implementations, each display island region further includes: n first light emitting elements electrically connected to the n first pixel circuits in one-to-one correspondence; the plurality of display island regions include: a plurality of first display island regions and a plurality of second display island regions; display island regions in odd-numbered columns include: a plurality of first display island regions arranged sequentially in the column direction, and display island regions in even-numbered columns include: a plurality of second display island regions arranged sequentially in the column direction; and an arrangement order of the n first light emitting elements included in a first display island region is different from an arrangement order of the n first light emitting elements included in a second display island region.

Other aspects may be comprehended after the drawings and the detailed descriptions are read and understood.

Brief Description of Drawings

Accompanying drawings are used for providing an understanding of technical solutions of the present application and form a part of the specification, are used for explaining the technical solutions of the present application together with embodiments of the present application, and do not constitute a limitation on the technical solutions of the present application.

FIG. 1 is a schematic diagram of a display substrate according to at least one embodiment of the present disclosure.

FIG. 2 is an equivalent circuit diagram of a pixel circuit according to at least one embodiment of the present disclosure.

FIG. 3 is a working timing diagram of the pixel circuit provided in FIG. 2.

FIG. 4 is a partial schematic diagram of a second display area according to at least one embodiment of the present disclosure.

FIG. 5 is a partial schematic diagram of a first display area according to at least one embodiment of the present disclosure.

FIG. 6 is a partial schematic diagram of a first pixel circuit and a first light emitting element in a first display area according to at least one embodiment of the present disclosure.

FIG. 7 is a partial top view of a first display area according to at least one embodiment of the present disclosure.

FIG. 8A is a schematic diagram of the first display area after a shielding layer is formed in FIG. 7.

FIG. 8B is a schematic diagram of one first display island region in FIG. 8A.

FIG. 9A is a schematic diagram of the first display area after a first semiconductor layer is formed in FIG. 7.

FIG. 9B is a schematic diagram of one first display island region in FIG. 9A.

FIG. 10A is a schematic diagram of the first display area after a first conductive layer is formed in FIG. 7.

FIG. 10B is a schematic diagram of the first conductive layer in FIG. 10A.

FIG. 10C is a schematic diagram of one first display island region in FIG. 10A.

FIG. 11A is a schematic diagram of the first display area after a second conductive layer is formed in FIG. 7.

FIG. 11B is a schematic diagram of the second conductive layer in FIG. 11A.

FIG. 11C is a schematic diagram of one first display island region in FIG. 11A.

FIG. 12A is a schematic diagram of the first display area after a second semiconductor layer is formed in FIG. 7.

FIG. 12B is a schematic diagram of one first display island region in FIG. 12A.

FIG. 13A is a schematic diagram of the first display area after a third conductive layer is formed in FIG. 7.

FIG. 13B is a schematic diagram of the third conductive layer in FIG. 13A.

FIG. 13C is a schematic diagram of one first display island region in FIG. 13A.

FIG. 14 is a schematic diagram of one first display island region after a fifth insulating layer is formed in FIG. 7.

FIG. 15A is a schematic diagram of the first display area after a fourth conductive layer is formed in FIG. 7.

FIG. 15B is a schematic diagram of the fourth conductive layer in FIG. 15A.

FIG. 15C is a schematic diagram of one first display island region in FIG. 15A.

FIG. 16 is a schematic diagram of one first display island region after a seventh insulating layer is formed in FIG. 7.

FIG. 17A is a schematic diagram of the first display area after a fifth conductive layer is formed in FIG. 7.

FIG. 17B is a schematic diagram of the fifth conductive layer in FIG. 17A.

FIG. 17C is a schematic diagram of one first display island region in FIG. 17A.

FIG. 18 is a schematic diagram of one first display island region after an eighth insulating layer is formed in FIG. 7.

FIG. 19A is a schematic diagram of the first display area after a sixth conductive layer is formed in FIG. 7.

FIG. 19B is a schematic diagram of the sixth conductive layer in FIG. 19A.

FIG. 19C is a schematic diagram of one first display island region in FIG. 19A.

FIG. 20 is a schematic diagram of one first display island region after a ninth insulating layer is formed in FIG. 7.

FIG. 21 is a schematic diagram of the first display area after an anode layer is formed in FIG. 7.

FIG. 22 is another partial schematic diagram of a first display area according to at least one embodiment of the present disclosure.

FIG. 23 is a partial top view of a first display area according to at least one embodiment of the present disclosure.

FIG. 24 is a schematic diagram of the first display area after a shielding layer is formed in FIG. 23.

FIG. 25 is a schematic diagram of the first display area after a first semiconductor layer is formed in FIG. 23.

FIG. 26A is a schematic diagram of the first display area after a first conductive layer is formed in FIG. 23.

FIG. 26B is a schematic diagram of the first conductive layer in FIG. 26A.

FIG. 27A is a schematic diagram of the first display area after a second conductive layer is formed in FIG. 23.

FIG. 27B is a schematic diagram of the second conductive layer in FIG. 27A.

FIG. 28 is a schematic diagram of the first display area after a second semiconductor layer is formed in FIG. 23.

FIG. 29A is a schematic diagram of the first display area after a third conductive layer is formed in FIG. 23.

FIG. 29B is a schematic diagram of the third conductive layer in FIG. 29A.

FIG. 30A is a schematic diagram of the first display area after a fourth conductive layer is formed in FIG. 23.

FIG. 30B is a schematic diagram of the fourth conductive layer in FIG. 30A.

FIG. 31 is a schematic diagram of the first display area after a seventh insulating layer is formed in FIG. 23.

FIG. 32A is a schematic diagram of the first display area after a fifth conductive layer is formed in FIG. 23.

FIG. 32B is a schematic diagram of the fifth conductive layer in FIG. 32A.

FIG. 33 is a schematic diagram of the first display area after an eighth insulating layer is formed in FIG. 23.

FIG. 34A is a schematic diagram of the first display area after a sixth conductive layer is formed in FIG. 23.

FIG. 34B is a schematic diagram of the sixth conductive layer in FIG. 34A.

FIG. 35 is a schematic diagram of the first display area after a ninth insulating layer is formed in FIG. 23.

FIG. 36 is a schematic diagram of the first display area after an anode layer is formed in FIG. 23.

FIG. 37 is another partial schematic diagram of a first display area according to at least one embodiment of the present disclosure.

FIG. 38 is another partial schematic diagram of a first display area according to at least one embodiment of the present disclosure.

FIG. 39 is another partial schematic diagram of a first display area according to at least one embodiment of the present disclosure.

FIG. 40 is another partial schematic diagram of a first display area according to at least one embodiment of the present disclosure.

FIG. 41 is another partial schematic diagram of a first display area according to at least one embodiment of the present disclosure.

FIG. 42 is a schematic diagram of a display device according to at least one embodiment of the present disclosure.

Detailed Description

The embodiments of the present disclosure will be described below with reference to the drawings in detail.

Implementations may be implemented in a plurality of different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limits in numbers but only to avoid confusion between constituent elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the constituent elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements are changed as appropriate according to a direction where the constituent elements are described. Therefore, appropriate replacements based on situations are allowed, which is not limited to the expressions in the specification.

In the specification, unless otherwise specified and defined, terms "mounting", "mutual connection", and "connection" should be understood in a broad sense. For example, a connection may be a fixed connection, a detachable connection, or an integral connection; it may be a mechanical connection or a connection; it may be a direct connection, an indirect connection through a middleware, or an internal communication inside two elements. Those of ordinary skills in the art may understand meanings of the aforementioned terms in the present disclosure according to situations.

In the specification, "electrical connection" includes connection of constituent elements through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, another element with a plurality of functions, etc.

In the specification, a transistor refers to an element which at least includes three terminals, i.e., a gate electrode, a drain electrode, and a source electrode. The transistor has a channel region between the drain electrode (drain electrode terminal, drain electrode region, or drain) and the source electrode (source electrode terminal, source electrode region, or source), and a current can flow through the drain electrode, the channel region, and the source electrode. In the specification, the channel region refers to a region through which a current mainly flows.

In the specification, a first electrode may be a drain electrode and a second electrode may be a source electrode, or, a first electrode may be a source electrode and a second electrode may be a drain electrode. In a case that transistors with opposite polarities are used, or in a case that a direction of a current is changed during operation of a circuit, or the like, functions of the "source" and the "drain" are sometimes interchangeable. Therefore, the "source electrode" and the "drain electrode" are interchangeable in the specification. In addition, the gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In this specification, a circle, oval, triangle, rectangle, trapezoid, pentagon or hexagon, etc. is not strictly speaking, but may be an approximate circle, oval, triangle, rectangle, trapezoid, pentagon or hexagon, etc. Some small deformations due to tolerances may exist, for example, guide angles, curved edges and deformations thereof may exist.

A "light transmittance" in the present disclosure refers to an ability of light to pass through a medium, and is a percentage of luminous flux passing through a transparent or translucent body to its incident luminous flux.

In the present disclosure, "about" and "substantially" refer to that a boundary is not defined strictly and a case within a range of process and measurement errors is allowed. In the present disclosure, "identical" may include completely identical and substantially identical cases, and "substantially identical" refers to a case where an exponential value differs by less than 10%.

In the present disclosure, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along another direction. "A extends in in the B direction" in the present disclosure means "the main body portion of A extends in the B direction".

With continuous development of display technologies, a camera is usually installed on a display device to meet the needs of shooting or face recognition. In order to maximize a screen-to-body ratio, technologies such as notch screen, waterdrop notch screen and punch- hole screen have successively came into being. These technologies reduce an area occupied by a camera by digging a hole locally in a display area and placing the camera under the punch- hole region, thus increasing the screen-to-body ratio. However, the above technologies require digging out part of the display area, which will cause some regions in a display picture to be unable to be displayed, and make it impossible to further improve the screen-to-body ratio. In order to avoid punching holes in the display area and under a premise of ensuring practicability of the display substrate, it is possible to achieve a true full-screen by adopting a pixel circuit built-out mode or a pixel circuit built-in mode in the full display with camera (FDC) region.

The pixel circuit built-out method means that the pixel circuits connected with the light emitting elements in the FDC region is provided in the normal display area, and the light transmittance of the FDC region is improved by arranging the light emitting elements and the pixel circuits separately. Because the pixel circuit is not provided in the FDC region, there is no light-shielding layer other than the anodes of the light emitting elements in this region, and a higher light transmittance can be realized. However, in this mode, the pixel circuits and the light emitting elements need to be electrically connected through conductive connection lines, the size (e.g., aperture) of the FDC region of the display substrate using the pixel circuit built-out method is limited due to the limitation of the space for the arrangement of the conductive connection lines. Increasing the aperture of the FDC region usually requires an increased mask process of the conductive connection lines, resulting in increased cost. Moreover, the material of the conductive connection line is usually a transparent conductive material, such as indium tin oxide (ITO). Due to the large square resistance of ITO, the load of the conductive connection line is large, which easily affects the brightness of the light emitting elements in the FDC region and reduces the brightness of the FDC region, which leads to a display defect in the FDC region, such as a vertical display defect (Mura). Moreover, the use of conductive connection wires tends to introduce more via holes, which will result in a decrease in the aperture ratio of the FDC region, and is not conducive to optimization of light transmittance of the FDC region.

The pixel circuit built-in method refers to the provision of light emitting elements and the pixel circuit connected with the light emitting elements in the FDC region. Compared with the pixel circuit built-out method, the built-in method eliminates the need for long conductive connection lines for the electric connection between the pixel circuits and the light emitting elements in the FDC region, which can avoid the display defect of the FDC region caused by the conductive connection lines. Moreover, the built-in method does not limit the size of the FDC region and can support the FDC region with large aperture. However, for complex pixel circuits, due to the large number of wires, it is difficult to improve the light transmittance of the FDC region through layout compression of the pixel circuits, resulting in a failure to meet the light transmittance required for functions such as under-screen camera or under-screen face recognition.

Embodiments provide a display substrate and a display device, which can improve the light transmittance of an FDC region of a display substrate adopting a pixel circuit built-in method, while satisfying display white balance.

An embodiment provides a display substrate, including: a first display area, the first display area including: a plurality of display island regions and a plurality of light-transmitting regions arranged in an array. The first display area satisfies at least one of: the display island regions and the light-transmitting regions being arranged alternately in a row direction, and the display island regions and the light-transmitting regions being arranged alternately in a column direction. A display island region includes at least one first pixel circuit and at least one first light emitting element, the at least one first pixel circuit being electrically connected to the at least one first light emitting element and configured to drive the at least one first light emitting element to emit light.

In some examples, in the first display area, display island regions and light-transmitting regions can be arranged alternately in the row direction; or, display island regions and light-transmitting regions can be arranged alternately in the column direction; or, display island regions and light-transmitting regions can be arranged alternately in the row direction, and display island regions and light-transmitting regions can be arranged alternately in the column direction. The row direction can be perpendicular to the column direction.

In this example, A and B being arranged alternately in direction C means that A and B are arranged at intervals in direction C, i.e., they are arranged periodically in a manner of AB in direction C. A and B being aligned in direction C means that A and B substantially coincide along a centerline in a direction perpendicular to direction C, and edge extension lines of A and B substantially coincide. A and B being arranged in a staggered manner in direction C means that A and B are substantially parallel and do not coincide along a centerline in a direction perpendicular to direction C.

In some examples, the plurality of display island regions in the first display area may be the same in shape and size. The plurality of light-transmitting regions may be the same in shape and size. A light-transmitting region may be formed by deleting a first pixel circuit and a first light emitting element, and the number of corresponding deleted first pixel circuits of the light-transmitting region may be smaller than or equal to the number of first pixel circuits included in a display island region.

In some examples, each display island region may include one first pixel circuit and one first light emitting element, and the first pixel circuit may be electrically connected to the first light emitting element to drive the first light emitting element to emit light. In some other examples, each display island region may include a plurality of first pixel circuits and a plurality of first light emitting elements, for example, may include four first pixel circuits and four first light emitting elements, or may include three first pixel circuits and three first light emitting elements. The plurality of first pixel circuits and the plurality of first light emitting elements within each display island region may be electrically connected in one-to-one correspondence. However, the present embodiment is not limited thereto. In some other examples, within a display island region, the number of first pixel circuits may be smaller than the number of first light emitting elements, and at least one first pixel circuit may be electrically connected to a plurality of first light emitting elements.

In the display substrate provided by this embodiment, a pixel circuit built-in method is employed, and display island regions and light-transmitting regions are arranged alternately in the row direction or the column direction within the first display area, so that the light transmittance of the first display area can be improved, and with the display white balance being met, the under-screen functional requirements can be satisfied, for example, an aperture of the first display area can be expanded, and functional requirements such as under-screen camera or under-screen face recognition can be satisfied synchronously.

In some exemplary implementations, in the row direction, the display island regions and the light-transmitting regions may be arranged alternately and aligned; and in the column direction, a plurality of display island regions may be arranged continuously in a staggered manner, or a plurality of display island regions may be arranged continuously and aligned, or the display island regions and the light-transmitting regions may be arranged alternately and aligned. The arrangement of the display island regions and the light-transmitting regions of the first display area in this example can be advantageous in improving the light transmittance of the first display area.

In some exemplary implementations, for a column of display island regions, display island regions in odd-numbered rows may be aligned, and display island regions in even-numbered rows may be aligned; and adjacent display island regions in a column of display island regions may be arranged in a staggered manner. In this example, the display island regions of the first display area may be arranged continuously in the column direction, and adjacent display island regions are arranged in a staggered manner, which may improve the light transmittance of the first display area, while ensuring the display white balance.

In this example, odd-numbered rows refer to rows whose row numbers are odd numbers; and even-numbered rows refer to rows whose row numbers are even numbers. Odd-numbered columns refer to columns whose column numbers are odd numbers; and even-numbered columns refer to columns whose column numbers are even numbers.

In some exemplary implementations, a display island region may include: a first pixel circuits arranged sequentially in the row direction, a being an integer greater than 1. A misalignment distance in the row direction between adjacent display island regions in a column of display island regions may be greater than or equal to a length of one first pixel circuit in the row direction and smaller than or equal to lengths of a-1 first pixel circuits in the row direction. For example, a display island region may include: four first pixel circuits sequentially arranged in the row direction. A misalignment distance in the row direction between adjacent display island regions in one column of display island regions may be approximately lengths of two first pixel circuits in the row direction. The staggered arrangement of the display island regions in this example is conducive to ensuring the display white balance.

In some exemplary implementations, each display island region in a j-th column may have a first edge close to a (j-1)-th column of display island regions and a second edge close to a (j+1)-th column of display island regions in the row direction. A centerline of a display island region in an i-th row and the j-th column in the row direction may be aligned with a first edge of a display island region in an (i+1)-th row and the j-th column; and a centerline of a display island region in the (i+1)-th row and the j-th column in the row direction may be aligned with a second edge of a display island region in the i-th row and the j-th column, wherein i and j are each an integer greater than 0. The staggered arrangement of the display island regions in this example is conducive to ensuring the display white balance.

In some exemplary implementations, the display substrate may further include: a second display area located on at least one side of the first display area, wherein the second display area includes: at least one second pixel circuit and at least one second light emitting element, the at least one second pixel circuit being electrically connected to the at least one second light emitting element and configured to drive the at least one second light emitting element to emit light. An arrangement density of first pixel circuits in the first display area may be smaller than an arrangement density of second pixel circuits in the second display area. In some examples, an arrangement density of first pixel circuits in the first display area in the row direction may be 1/2 or 1/3 of an arrangement density of second pixel circuits in the second display area in the row direction. In this example, by deleting pixel circuits of the first display area, the light transmittance of the first display area can be improved, with the display white balance being ensured.

Solutions of the embodiments will be described below through some examples.

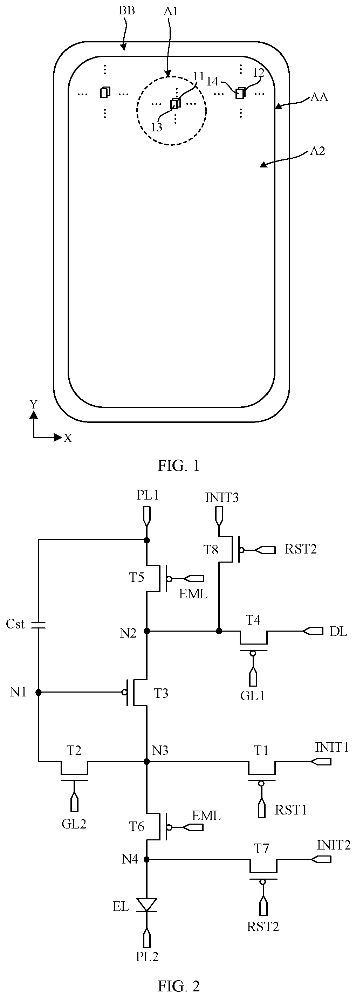

FIG. 1 is a schematic diagram of a display substrate according to at least one embodiment of the present disclosure. In some examples, as shown in FIG. 1, the display substrate may include a display area AA and a peripheral region BB located at a periphery of the display area AA. The display area AA of the display substrate may at least include a first display area A1 and a second display area A2. The second display area A2 may at least partially surround the first display area A1. For Example, the second display area A2 may surround the first display area A1. The peripheral region BB may surround the second display area A2. However, the present embodiment is not limited thereto.

In some examples, as shown in FIG. 1, the first display area A1 may be a light transmitting display area and may also be referred to as a Full Display with Camera (FDC) region. The second display area A2 may also be referred to as a normal display area. A light transmittance of the first display area A1 is greater than a light transmittance of the second display area A2. For example, an orthographic projection of a sensor (such as a camera and other hardware) on the display substrate may be located within the first display area A1 of the display substrate. In some examples, as shown in FIG. 1, the first display area A1 may be circular, and a size of an orthographic projection of the sensor on the display substrate may be less than or equal to a size of the first display area A1. However, the present embodiment is not limited thereto. In some other examples, the first display area A1 may be rectangular, and a size of the orthographic projection of the sensor on the display substrate may be less than or equal to a size of an inscribed circle of the first display area A1.

In some examples, as shown in FIG. 1, the first display area A1 may be located at a middle position of the top of the display area AA. The second display area A2 may surround a periphery of the first display area A1. However, the present embodiment is not limited thereto. For example, the first display area A1 may be located in other positions such as an upper left corner, a lower left corner, a lower right corner or an upper right corner of the display area AA. For example, the second display area A2 may surround at least one side of the first display area A1.

In some examples, as shown in FIG. 1, the display area AA may be in a shape of a rectangle, e.g., a rounded rectangle. The first display area A1 may be circular or elliptical. However, the present embodiment is not limited thereto. For example, the first display area A1 may be rectangular, semicircular, pentagonal, or another shape.

In some examples, the display area AA may be provided with a plurality of sub-pixels. At least one sub-pixel may include a pixel circuit and a light emitting element. The pixel circuit may be configured to drive a light emitting element connected thereto. For example, the pixel circuit may be configured to provide a drive current for driving the light emitting element to emit light. The pixel circuit may include a plurality of transistors and at least one capacitor. For example, the pixel circuit may be a circuit of a 3T1C, 4T1C, 5TIC, 5T2C, 6T1C, 7T1C, or 8T1C structure. Herein, in the above circuit structure, T refers to a thin film transistor, C refers to a capacitor, a number before T represents a quantity of thin film transistors in the circuit, and a number before C represents a quantity of capacitors in the circuit.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected to a corresponding pixel circuit. However, the present embodiment is not limited thereto.

FIG. 2 is an equivalent circuit diagram of a pixel circuit according to at least one embodiment of the present disclosure. The pixel circuit of this example is described by taking a 8T1C structure as an example. In some examples as, shown in FIG. 2, the pixel circuit of this example may include eight transistors (i.e., a first transistor T1 to an eighth transistor T8) and one storage capacitor Cst. The first transistor T1 may also be referred to as a first reset transistor, the second transistor T2 may also be referred to as a threshold compensation transistor, the third transistor T3 may also be referred to as a drive transistor, the fourth transistor T4 may also be referred to as a data writing transistor, the fifth transistor T5 may also be referred to as a first light emitting control transistor, the sixth transistor T6 may also be referred to as a second light emitting control transistor, the seventh transistor T7 may also be referred to as a second reset transistor, and the eighth transistor T8 may also be referred to as a third reset transistor. The light emitting element EL may include an anode, a cathode and an organic emitting layer arranged between the anode and the cathode.

In some examples, the first transistor T1, the third transistor T3 to the eighth transistor T8 may be first type transistors, which may be, for example, P-type transistors, and the second transistor T2 may be a second type transistor, which may be, for example, an N-type transistor. However, the present embodiment is not limited thereto. For example, the multiple transistors of the pixel circuit may be all P-type transistors, or all N-type transistors.

In some examples, for first type transistors (e.g., including the first transistor T1 and the third transistor T3 to the eighth transistor T8) of the pixel circuit, a low temperature poly silicon thin film transistor may be adopted, and for a second type transistor (e.g., including the second transistor T2) of the pixel circuit, an oxide thin film transistor may be adopted. Low Temperature Poly Silicon (LTPS) is used for an active layer of a low temperature poly silicon thin film transistor and an oxide semiconductor (Oxide) is used for an active layer of an oxide thin film transistor. A low temperature poly silicon thin film transistor has advantages such as a high mobility rate and fast charging, and an oxide thin film transistor has advantages such as a low leakage current. The low temperature poly silicon thin film transistor and the oxide thin film transistor are integrated on one display substrate to form a Low Temperature Polycrystalline Oxide (LTPS + Oxide) display substrate, and advantages of both the low temperature poly silicon thin film transistor and the oxide thin film transistor may be utilized, which may achieve low-frequency drive, reduce power consumption, and improve display quality.

In some examples, as shown in FIG. 2, the pixel circuit may be electrically connected with a first scan line GL1, a second scan line GL2, a data line DL, a first power supply line PL1, a second power supply line PL2, a light emitting control line EML, a first initial signal line INIT1, a second initial signal line INIT2, a third initial signal line INIT3, a first reset control line RST1, and a second reset control line RST2. The first power supply line PL1 may be configured to provide a constant first voltage signal VDD to the pixel circuit, the second power supply line PL2 may be configured to provide a constant second voltage signal VSS to the pixel circuit, and the first voltage signal VDD is greater than the second voltage signal VSS. The first scan line GL1 may be configured to provide a first scan signal SCAN1 to the pixel circuit. The second scan line GL2 may be configured to provide a second scan signal SCAN2 to the pixel circuit. The data line DL may be configured to provide a data signal to the pixel circuit. The light emitting control line EML may be configured to provide a light emitting control signal EM to the pixel circuit. The first reset control line RST1 may be configured to provide a first reset control signal RESET1 to the pixel circuit. The second reset control line may be configured to provide a second reset control signal RESET2 to the pixel circuit.

In some examples, as shown in FIG. 2, a gate of the third transistor T3 is electrically connected with a first node N1, a first electrode of the third transistor T3 is electrically connected with a second node N2, and a second electrode of the third transistor T3 is electrically connected with a third node N3. A gate of the fourth transistor T4 is electrically connected with the first scan line GL1, a first electrode of the fourth transistor T4 is electrically connected with the data line DL, and a second electrode of the fourth transistor T4 is electrically connected with the second node N2. A gate of the second transistor T2 is connected to the second scan signal line GL2, a first electrode of the second transistor T2 is electrically connected with the first node N1, and a second electrode of the second transistor T2 is electrically connected with the third node N3. A gate of the fifth transistor T5 is electrically connected with the light emitting control line EML, a first electrode of the fifth transistor T5 is electrically connected with the first power supply line PL1, and a second electrode of the fifth transistor T5 is electrically connected with the second node N2. A gate of the sixth transistor T6 is electrically connected with the light emitting control line EML, a first electrode of the sixth transistor T6 is electrically connected with the third node N3, and a second electrode of the sixth transistor T6 is electrically connected with a fourth node N4. A gate of the first transistor T1 is electrically connected with the first reset control line RST1, a first electrode of the first transistor T1 is electrically connected with the first initial signal line INIT1, and a second electrode of the first transistor T1 is electrically connected with the third node N3. The first transistor T1 may be configured to reset the third node N3. A gate of the seventh transistor T7 is electrically connected with the second reset control line RST2, a first electrode of the seventh transistor T7 is electrically connected with the second initial signal line INIT2, and a second electrode of the seventh transistor T7 is electrically connected with the fourth node N4. The seventh transistor T7 may be configured to reset the fourth node N4. A gate of the eighth transistor T8 is electrically connected with the second reset control line RST2, a first electrode of the eighth transistor T8 is electrically connected with the third initial signal line INIT3, and a second electrode of the eighth transistor T8 is electrically connected with the second node N2. The eighth transistor T8 may be configured to reset the second node N2. A first electrode of the storage capacitor Cst is electrically connected with the first node N1, and a second electrode of the storage capacitor Cst is electrically connected with the first power supply line PL1.

In the example, the first node N1 is a connection point of the storage capacitor Cst, the second transistor T2, and the third transistor T3, the second node N2 is a connection point of the fifth transistor T5, the fourth transistor T4, the eighth transistor T8, and the third transistor T3, the third node N3 is a connection point of the first transistor T1, the third transistor T3, the second transistor T2, and the sixth transistor T6, and the fourth node N4 is a connection point of the sixth transistor T6, the seventh transistor T7, and the light emitting element EL.

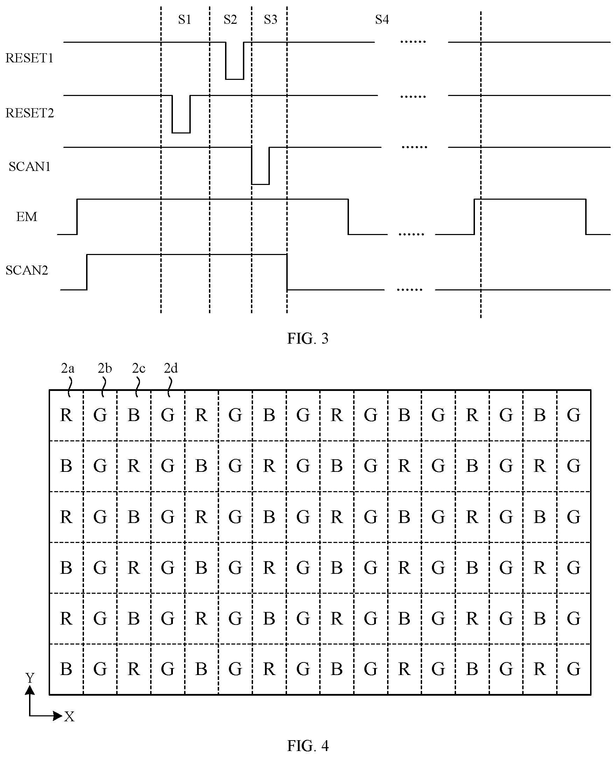

FIG. 3 is a working timing diagram of the pixel circuit provided in FIG. 2. An operating process of the pixel circuit shown in FIG. 2 will be described below with reference to FIG. 3. Herein, the first transistor T1, the third transistor T3 to the eighth transistor T8 of the pixel circuit are P-type transistors, and the second transistor T2 is an N-type transistor.

In some examples, as shown in FIG. 2 and FIG. 3, during one frame of display period, the working process of the pixel circuit may at least include a first stage S1, a second stage S2, a third stage S3, and a fourth stage S4.

The first stage S1 is referred to as a first reset stage. In the first stage S1, the second reset control signal RESET2 provided by the second reset control line RST2 is a low level signal to turn on the seventh transistor T7 and the eighth transistor T8, and the second scan signal SCAN2 provided by the second scan line GL2 is a high level signal to turn on the second transistor T2. The eighth transistor T8 is turned on so that the third initial signal provided by the third initial signal line INIT3 is provided to the second node N2. The seventh transistor T7 is turned on so that the second initial signal provided by the second initial signal line INIT2 is provided to the fourth node N4 to initialize the fourth node N4. The first scan signal SCAN1 provided by the first scan line GL1 is a high level signal, the first reset control signal RESET1 provided by the first reset control line RST1 is a high level signal, and the light emitting control signal EM provided by the light emitting control line EML is a high level signal, so that the fourth transistor T4, the first transistor T1, the fifth transistor T5 and the sixth transistor T6 are turned off. In this stage, the light emitting element EL does not emit light.

The second stage S2 is referred to as a second reset stage. In the second stage S2, the first reset control signal RESET1 provided by the first reset control line RST1 is a low level signal, and the first transistor T1 is turned on. The second scan signal SCAN2 provided by the second scan line GL2 is a high level signal, and the second transistor T2 is turned on. The first transistor T1 and the second transistor T2 are turned on such that a first initial signal line provided by the first initial signal line INIT1 is provided to the first node N1 to initialize the first node N1. The second reset control signal RESET2 provided by the second reset control line RST2 is a high level signal, the first scan signal SCAN1 provided by the first scan line GL1 is a high level signal, and the light emitting control signal EM provided by the light emitting control line EML is a high level signal, so that the seventh transistor T7, the eighth transistor T8, the fourth transistor T4, the fifth transistor T5 and the sixth transistor T6 are turned off. In this stage, the light emitting element EL does not emit light.

The third stage S3 is referred to as a data writing stage or a threshold compensation stage. In the third stage S3, the first scan signal SCAN1 provided by the first scan line GL1 is a low level signal, and the fourth transistor T4 is turned on. The second scan signal SCAN2 provided by the second scan line GL2 is a high level signal, and the second transistor T2 is turned on. At this stage, the first electrode of the storage capacitor Cst is at a low level and the third transistor T3 is turned on. The second transistor T2, the fourth transistor T4 and the fourth transistor T3 are turned on, so that a data voltage Vdata output by the data line DL is provided to the first node N1 through the second node N2, the turned-on third transistor T3, the third node N3, and the turned-on second transistor T2, and the storage capacitor Cst is charged with a difference between the data voltage Vdata output by the data line DL and a threshold voltage of the third transistor T3. A voltage of the first electrode (i.e., the first node N1) of the storage capacitor Cst is Vdata-|Vth|, wherein Vdata is the data voltage output by the data line DL, and Vth is the threshold voltage of the third transistor T3. The first reset control signal RESET1 provided by the first reset control line RST1 is a high level signal, the second reset control signal RESET2 provided by the second reset control line RST2 is a high level signal, and the light emitting control signal EM provided by the light emitting control line EML is a high level signal, so that the first transistor T1, the seventh transistor T7, the eighth transistor T8, the fifth transistor T5 and the sixth transistor T6 are turned off.

In the fourth stage S4, the light emitting control signal EM provided by the light emitting control line EML can be switched from the high level signal to a low level signal, so that the fifth transistor T5 and the sixth transistor T6 are turned on. The second scan signal SCAN2 provided by the second scan line GL2 is a low level signal, so that the second transistor T2 is turned off. The first scan signal SCAN1 provided by the first scan line GL1, the first reset control signal RESET1 provided by the first reset control line RST1, and the second reset control signal RESET2 provided by the second reset control line RST2 are high level signals, so that the fourth transistor T4, the first transistor T1, the seventh transistor T7, and the eighth transistor T8 are turned off. The first voltage signal VDD outputted by the first power supply line PL1 may provide a drive voltage to the anode of the light emitting element EL through the turned-on fifth transistor T5, the third transistor T3, and the sixth transistor T6, driving the light emitting element EL to emit light.

In a driving process of the pixel circuit, a drive current flowing through the third transistor T3 is determined by a voltage difference between the gate and the first electrode of the third transistor T3. Since the voltage of the first node N1 is Vdata-|Vth|, the drive current of the third transistor T3 is as follows.

$$I=K\times(Vgs-Vth)^2=K\times[(VDD-Vdata+|Vth|)-Vth]^2=K\times[VDD-Vdata]^2$$

Herein, I is the drive current flowing through the third transistor T3, that is, a drive current for driving the light emitting element, K is a constant, Vgs is the voltage difference between the gate and the first electrode of the third transistor T3, Vth is the threshold voltage of the third transistor T3, Vdata is the data voltage outputted by the data line DL, and VDD is the first voltage signal outputted by the first power supply line PL1.

It may be seen from the above formula that a current flowing through the light emitting element is independent of the threshold voltage of the third transistor T3. Therefore, the pixel circuit according to this embodiment may better compensate the threshold voltage of the third transistor T3. Moreover, the pixel circuit provided in this embodiment can improve poor display caused by low frequency and improve a display effect of the light emitting element.

FIG. 4 is a partially schematic diagram of a second display area according to at least one embodiment of the present disclosure. In some examples, as shown in FIGS. 1 and 4, the second display area A2 may include: a plurality of second sub-pixels arranged in an array. The plurality of second sub-pixels of the second display area A2 may include: a plurality of second sub-pixels 2a emitting light of a first color, a plurality of second sub-pixels 2c emitting light of a second color, and a plurality of second sub-pixels 2b and 2d emitting light of a third color. In some examples, light of the first color may be red light (R), light of the second color may be blue light (B), and light of the third color may be green light (G). The present embodiment is not limited thereto.

In some examples, a plurality of second sub-pixels of the second display area A2 may be arrayed in an array in a first direction X and a second direction Y. A plurality of second sub-pixels arranged continuously in the first direction X may be called a row of second sub-pixels, and the first direction X may be parallel to the row direction; a plurality of second sub-pixels arranged continuously in the second direction Y may be called a column of second sub-pixels, and the second direction Y may be parallel to the column direction.

In some examples, each second sub-pixel may include: a second pixel circuit 12 and a second light emitting element 14 electrically connected to the second pixel circuit 12. The second pixel circuit 12 may be configured to drive the connected second light emitting element 14 to emit light. An orthographic projection of the second light emitting element 14 on the base substrate may be at least partially overlapped with an orthographic projection of the connected second pixel circuit 12 on the base substrate.

In some examples, one pixel unit of the second display area A2 may include: four second sub-pixels, i.e., including one second sub-pixel 2a emitting light of the first color, one second sub-pixel 2c emitting light of the second color, and two second sub-pixels 2b and 2d emitting light of the third color. For example, within a single pixel unit, the second sub-pixels 2a, 2b, 2c, and 2d may be arranged sequentially in the first direction X, or the second sub-pixels 2c, 2d, 2a, and 2b may be arranged sequentially in the first direction X.

In some examples, a plurality of second sub-pixels 2a emitting light of the first color and a plurality of second sub-pixels 2c emitting light of the second color may be arranged in one column and arranged alternately in the second direction Y. A plurality of second sub-pixels 2b and 2d emitting light of the third color may be arranged in one column and arranged alternately in the second direction Y. A plurality of second pixel circuits in the second display area may be continuously arranged in the row direction and the column direction. The second display area is not provided with a light-transmitting region. A light transmittance of the second display area is smaller than that of the first display area.

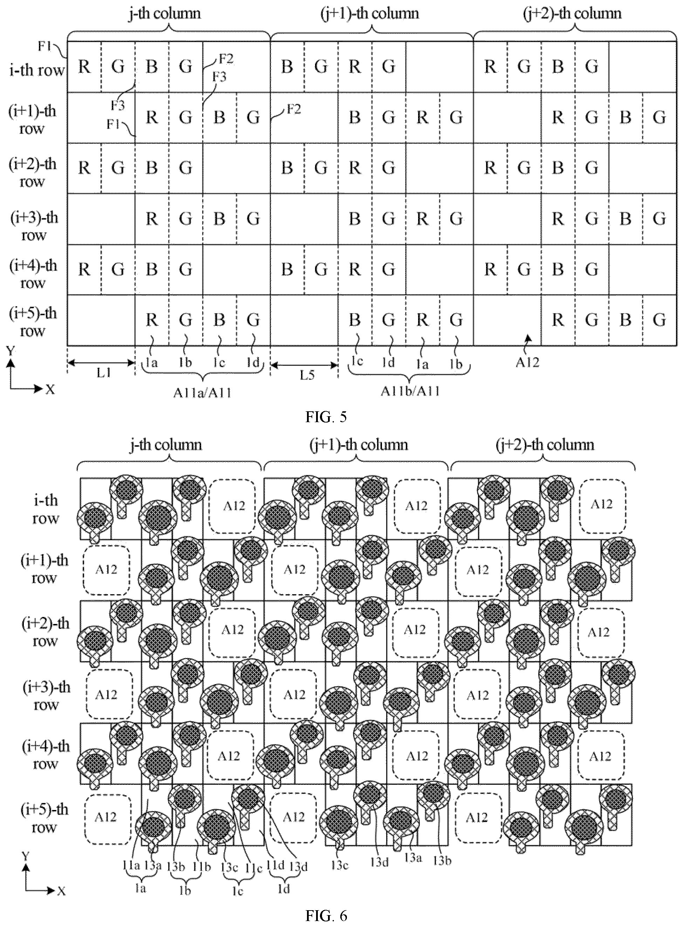

FIG. 5 is a partial schematic diagram of a first display area according to at least one embodiment of the present disclosure. FIG. 6 is a partial schematic diagram of a first pixel circuit and a first light emitting element in a first display area according to at least one embodiment of the present disclosure. FIGS. 5 and 6 show six rows (e.g., an i-th row to an (i+5)-th row) and three columns (e.g., a j-th column to a (j+2)-th column) of display island regions. Here, i and j are each an integer greater than 0.

In some examples, as shown in FIGS. 1, 5, and 6, the first display area A1 may include: a plurality of display island regions A11 and a plurality of light-transmitting regions A12 arranged in an array. The display island regions A11 and the light-transmitting regions A12 may be alternately arranged in the first direction X (parallel to the row direction). The plurality of display island regions A11 may be arranged continuously in the second direction Y (parallel to the column direction). For one column of display island regions, display island regions A11 in odd-numbered rows may be aligned, display island regions A11 in even-numbered rows may be aligned, and adjacent display island regions A11 in one column of display island regions may be arranged in a staggered manner. The plurality of light-transmitting regions A12 may be substantially the same in shape and size. The plurality of display island regions A11 may be substantially the same in shape and size.

In some examples, the plurality of display island regions A11 of the first display area A1 may include: a plurality of first display island regions A11a and a plurality of second display island regions A11b. In the first direction X, the first display island regions A11a, the light-transmitting regions A12, the second display island regions A11b, and the light-transmitting regions A12 may be periodically arranged in this order. In each row of display island regions, the first display island regions A11a and the second display island regions A11b may be arranged alternately, and a light-transmitting region A12 is arranged between adjacent display island regions. The display island regions in odd-numbered columns (e.g., a j-th column, a (j+2)-th column) may include a plurality of first display island regions A11a sequentially arranged in the second direction Y, and the display island regions in even-numbered columns (e.g., a (j+1)-th column) may include a plurality of second display island regions A11b sequentially arranged in the second direction Y. However, the present embodiment is not limited thereto. For example, the odd-numbered columns may include a plurality of first display island regions, and the even-numbered columns may include a plurality of second display island regions.

In some examples, as shown in FIG. 5, taking a j-th column of display island regions as an example, a first display island region A11a in an i-th row and the j-th column and a first display island region A11a in an (i+2)-th row and the j-th column may be aligned in the second direction Y, a first display island region A11a in an (i+1)-th row and the j-th column and a first display island region A11a in an (i+3)-th row and the j-th column may be aligned in the second direction Y, and a display island region in the i-th row and the j-th column and a display island region in the (i+1)-th row and the j-th column may be arranged in a staggered manner. Each first display island region A11a in the j-th column may have a first edge F1 close to a (j-1)-th column of display island regions and a second edge F2 close to a (j+1)-th column of display island regions in the first direction X. A centerline F3 in the first direction X of the first display island region A11a in the i-th row and the j-th column is aligned with a first edge F1 of the first display island region A11a in the (i+1)-th row and the j-th column; and a centerline F3 in the first direction X of the first display island region A11a in the (i+1)-th row and the j-th column is aligned with a second edge F2 of the first display island region A11a in the i-th row and the j-th column.

In some examples, for a column of display island regions, a second edge of a display island region in an odd-numbered row may coincide with an extension line of a centerline in the row direction of an adjacent display island region in an even-numbered row, and an extension line of a centerline in the row direction of a display island region in an odd-numbered row may coincide with a first edge of an adjacent display island region in an even-numbered row. An extension line of a second edge of a display island region in an even-numbered row in a column of display island regions may coincide with an extension line of a first edge of a display island region in an odd-numbered row in a right-side adjacent column of display island regions. Alternatively, for a column of display island regions, a second edge of a display island region in an even-numbered row may coincide with an extension line of a centerline in the row direction of an adjacent display island region in an odd-numbered row, and an extension line of a centerline in the row direction of a display island region in an even-numbered row may coincide with a first edge of an adjacent display island region in an odd-numbered row. An extension line of a second edge of a display island region in an odd-numbered row in a column of display island regions may coincide with an extension line of a first edge of a display island region in an odd-numbered row in a right-side adjacent column of display island regions.

In some examples, in the second direction Y, a light-transmitting region A12 is aligned with a half of an adjacent display island region A11. A centerline of a light-transmitting region A12 in the first direction X may coincide with a centerline of a half of an adjacent display island region A11 in the second direction Y (i.e., a quarter line of the display island region A11).

In some examples, a first display island region A11a and a second display island region A11b may each include: four first sub-pixels sequentially arranged in the first direction X. A first display island region A11a may include: a first sub-pixel 1a emitting light of a first color, a first sub-pixel 1b emitting light of a third color, a first sub-pixel 1c emitting light of a second color, and a first sub-pixel 1d emitting light of a third color, which are sequentially arranged in the first direction X. A second display island region A11b may include: a first sub-pixel 1c emitting light of the second color, a first sub-pixel 1d emitting light of the third color, a first sub-pixel 1a emitting light of the first color, and a first sub-pixel 1b emitting light of the third color, which are sequentially arranged in the first direction X. A first display island region A11a and a second display island region A12 have different arrangement orders of first sub-pixels.

In some examples, each first sub-pixel may include: a first pixel circuit, and a first light emitting element electrically connected to the first pixel circuit. Each display island region in this example may include: four first pixel circuits and four first light emitting elements. As shown in FIG. 6, the four first pixel circuits within each display island region may be sequentially arranged in the first direction X. The four first light emitting elements within each display island region may include: a first light emitting element 13a emitting light of the first color, a first light emitting element 13c emitting light of the second color, and first light emitting elements 13b and 13d emitting light of the third color. The first sub-pixel 1a may include: a first pixel circuit 11a and a first light emitting element 13a connected to each other, the first sub-pixel 1b may include: a first pixel circuit 11b and a first light emitting element 13b connected to each other, the first sub-pixel 1c may include: a first pixel circuit 11c and a first light emitting element 13c connected to each other, and the first sub-pixel 1d may include: a first pixel circuit 11d and a first light emitting element 13d connected to each other. In a first display island region A11a, four first pixel circuits 11a, 11b, 11c, and 11d may be arranged sequentially in the first direction X; and in a second display island region A11b, four first pixel circuits 11c, 11d, 11a, and 11b may be arranged sequentially in the first direction X. In each display island region, the first light emitting elements 13a and 13c may be arranged in a same row, the first light emitting elements 13b and 13d may be arranged in a same row, the first light emitting elements 13a and 13b may be arranged in different rows, and the first light emitting elements 13a, 13b, 13c, and 13d may be arranged in different columns. In a first display island region A11a, the first light emitting elements 13a, 13b, 13c, and 13d are sequentially arranged in the first direction X; and in a second display island region A11b, the first light emitting elements 13c, 13d, 13a, and 13b are sequentially arranged in the first direction X. An arrangement order of four first light emitting elements in a first display island region A11a is different from an arrangement order of four first light emitting elements in a second display island region A11b.

In some examples, a misalignment distance between adjacent display island regions A11 in each column of display island regions may be the same, for example, may be approximately a length of a light-transmitting region A12 in the first direction X. For example, a misalignment distance L1 between adjacent first display island regions A11a in a j-th column of display island regions may be equal to a misalignment distance L5 between adjacent second display island regions A11b in a (j+1)-th column of display island regions. The four first pixel circuits within each display island region may have a same length in the first direction X. A misalignment distance in the first direction between adjacent display island regions in a column of display island regions may be greater than or equal to a length of one first sub-pixel in the first direction, and smaller than or equal to lengths of three first sub-pixels in the first direction. As shown in FIG. 6, the misalignment distance (for example, the misalignment distance L1 shown in FIG. 5) in the first direction X between adjacent display island regions in a column of display island regions may be approximately the lengths of two first pixel circuits in the first direction X. A length of a light-transmitting region A12 in the first direction X may be smaller than or equal to lengths of two first pixel circuits in the first direction X.

In some examples, as shown in FIGS. 4 and 5, a pixel density (PPI, Pixels Per Inch) of the first display area may be smaller than a pixel density of the second display area. An arrangement density of first pixel circuits in the first display area may be smaller than an arrangement density of second pixel circuits in the second display area. For example, the arrangement density of the first pixel circuits in the first display area in the first direction may be 1/3 of the arrangement density of the second pixel circuits in the second display area in the first direction. Compared with the second display area, in this example, in the first display area, the display island regions in the odd-numbered columns take RGBG as a repeating unit, the display island regions in the even-numbered columns take BGRG as a repeating unit, and RG units or BG units between adjacent columns are deleted at intervals, so that the first sub-pixels deleted in the first display area account for one-third of the total first sub-pixels, and light-transmitting regions are formed at positions where the first sub-pixels are deleted, thereby improving the light transmittance of the first display area, while meeting the display white balance.

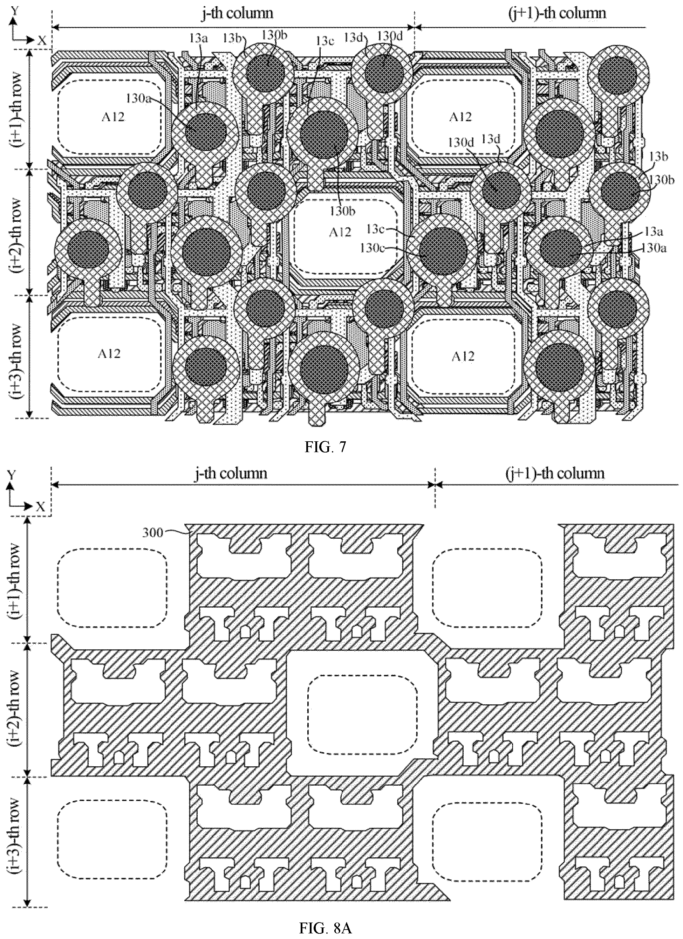

FIG. 7 is a partial top view of a first display area according to at least one embodiment of the present disclosure.

FIG. 7 is a partial top view of three rows (e.g., an (i+1)-th row to an (i+3)-th row) and two columns (e.g., a j-th column and a (j+1)-th column) of display island regions. In some examples, as shown in FIG. 7, the first display area may include: a plurality of display island regions and a plurality of light-transmitting regions A12. A light-transmitting region A12 may be surrounded by display island regions in the first direction X and the second direction Y.

In some examples, in a direction perpendicular to the display substrate, the display substrate may include a base substrate, and a circuit structure layer and a light emitting structure layer disposed on the base substrate. The light emitting structure layer may be located on a side of the circuit structure layer away from the base substrate. The circuit structure layer of the first display area may include multiple first pixel circuits, and the light emitting structure layer of the first display area may include multiple first light emitting elements.

In some examples, the circuit structure layer may include: a first semiconductor layer, a first conductive layer, a second conductive layer, a second semiconductor layer, a third conductive layer, a fourth conductive layer, a fifth conductive layer, and a sixth conductive layer disposed on the base substrate. A first insulating layer may be arranged between the first semiconductor layer and the first conductive layer, a second insulating layer may be arranged between the first conductive layer and the second conductive layer, a third insulating layer may be arranged between the second conductive layer and the second semiconductor layer, a fourth insulating layer may be arranged between the second semiconductor layer and the third conductive layer, a fifth insulating layer may be arranged between the third conductive layer and the fourth conductive layer, a sixth insulating layer and a seventh insulating layer may be arranged between the fourth conductive layer and the fifth conductive layer, an eighth insulating layer may be arranged between the fifth conductive layer and the sixth conductive layer, and a ninth insulating layer may be arranged on a side of the sixth conductive layer away from the base substrate. In some examples, the first insulating layer to the sixth insulating layer may be inorganic insulating layers, and the seventh insulating layer to the ninth insulating layer may be organic insulating layers. The present embodiment is not limited thereto. In some other examples, an insulating layer may be arranged between the fourth conductive layer and the fifth conductive layer. In some other examples, two insulating layers may be arranged on a side of the sixth conductive layer away from the base substrate to improve the flattening effect of an anode layer.

In some examples, the light emitting structure layer may include an anode layer, a pixel definition layer, an organic light emitting layer, and a cathode layer disposed sequentially on the circuit structure layer. The anode layer may be electrically connected with a pixel circuit of the circuit structure layer, the organic light emitting layer may be connected with the anode layer, the cathode layer may be connected with the organic light emitting layer, and the organic light emitting layer may emit light of corresponding colors under drive of the anode layer and the cathode layer.

A structure of the display substrate will be described below through an example of a manufacturing process of the display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. If the "thin film" does not need to be processed through a patterning process in the entire manufacturing process, the "thin film" may also be called a "layer". If the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B are disposed in a same layer" in the present disclosure means that A and B are formed simultaneously through a same patterning process, or distances between surfaces of A and B close to a base substrate and the base substrate are substantially the same, or the surfaces of A and B close to the base substrate are in direct contact with a same film layer. A "thickness" of a film is a dimension of the film in a direction perpendicular to the display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B. The "shape of A" in the present disclosure refers to a shape of an orthographic projection of A on the base substrate.

Film layers of the circuit structure layer are described below by taking four first pixel circuits (for example, the first pixel circuits 11a, 11b, 11c, and 11d) of a first display island region (for example, the first display island region in the (i+1)-th row and the j-th column) in the first display area as an example. The structure of film layers of a second display island region is similar to that of the first display island region, so it will not be described here in detail. The example is explained by taking a case that a first pixel circuit is of the aforementioned 8T1C structure. The first pixel circuit 11a may include: a first transistor 31a, a second transistor 32a, a third transistor 33a, a fourth transistor 34a, a fifth transistor 35a, a sixth transistor 36a, a seventh transistor 37a, an eighth transistor 38a, and a storage capacitor; and the first pixel circuit 11b may include: a first transistor 31b, a second transistor 32b, a third transistor 33b, a fourth transistor 34b, a fifth transistor 35b, a sixth transistor 36b, a seventh transistor 37b, an eighth transistor 38b, and a storage capacitor. A connection relationship between eight transistors and a storage capacitor in each first pixel circuit may be referred to the equivalent circuit diagram shown in FIG. 2.

In some examples, the preparing process of the display substrate may include the following operations.

(1) A base substrate is provided. In some examples, the base substrate may be a rigid substrate or a flexible substrate. For example, the rigid substrate may be made of, but not limited to, one or more of glass and quartz. The flexible substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible substrate may include a first flexible material layer, a first inorganic material layer, a second flexible material layer, and a second inorganic material layer which are stacked. The first flexible material layer and the second flexible material layer may be made of a material such as polyimide (PI), polyethylene terephthalate (PET), or a surface-treated polymer soft film, and a material of the first inorganic material layer and the second inorganic material layer may be silicon nitride (SiNx, x>0) or silicon oxide (SiOy, y>0), etc., which are used to improve resistance to water and oxygen of the base substrate.

(2) A shielding layer is formed. In some examples, a shielding thin film is deposited on the base substrate, and the shielding thin film is patterned by a patterning process to form a shielding layer arranged on the base substrate. In some examples, the shielding layer may also be referred to as a Bottom Shielding Metal (BSM).

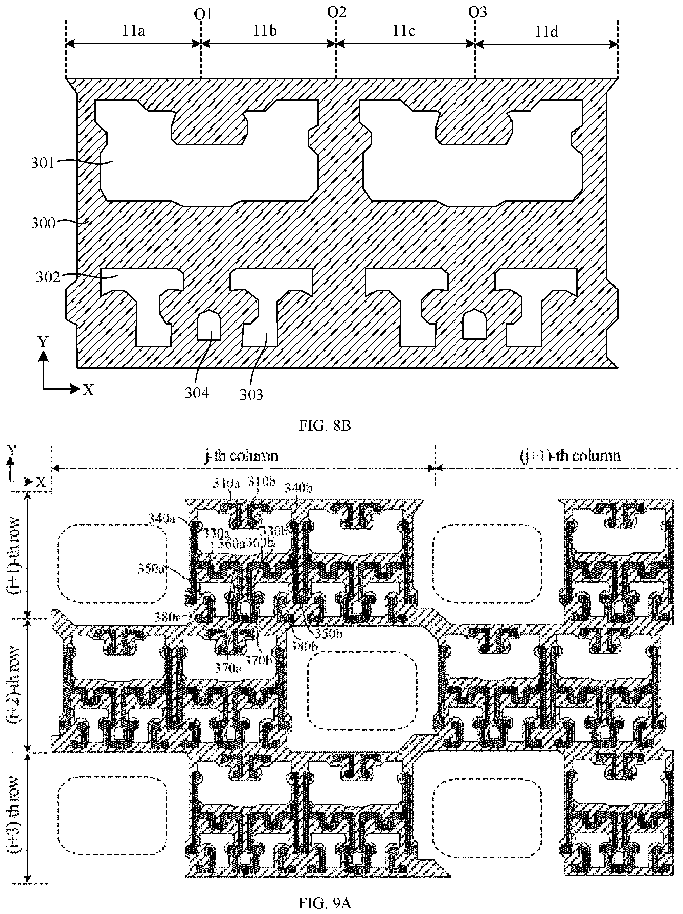

FIG. 8A is a schematic diagram of the first display area after a shielding layer is formed in FIG. 7. FIG. 8B is a schematic diagram of one first display island region in FIG. 8A. In some examples, as shown in FIGS. 8A and 8B, the shielding layer of the first display area may at least include: a shielding block 300 located in a display island region. Each display island region may be provided with one shielding block 300. Shielding blocks 300 of adjacent display island regions in a column of display island regions may be connected to each other to form an integrated structure. In adjacent columns of display island regions, the shielding blocks 300 of display island regions in adjacent rows may be connected to each other to form an integrated structure. A plurality of shielding blocks 300 in the first display area may be connected to each other to form an integrated structure.

In some examples, as shown in FIG. 8B, the shielding block 300 in the first display island region may include: two first hollow portions 301, two second hollow portions 302, two third hollow portions 303, and two fourth hollow portions 304. The shielding block 300 may be substantially symmetrical with respect to a second centerline O2. The two first hollow portions 301 may be substantially symmetrical with respect to the second centerline O2, and a single first hollow portion 301 may be substantially symmetrical with respect to a first centerline O1 or a third centerline O3. A second hollow portion 302, a third hollow portion 303, and a fourth hollow portion 304 may be located on a side of a first hollow portion 301 in an opposite direction of the second direction Y, and the fourth hollow portion 304 may be located between the second hollow portion 302 and the third hollow portion 303 in the first direction X. One second hollow portion 302 and one third hollow portion 303 may be substantially symmetrical with respect to the first centerline O1, and the other second hollow portion 302 and the other third hollow portion 303 may be substantially symmetrical with respect to the third centerline O3. One fourth hollow portion 304 may be substantially symmetrical with respect to the first centerline O1, and the other fourth hollow portion 304 may be substantially symmetrical with respect to the third centerline O3. In this example, arranging a light-shielding block in a display island region can provide a light-shielding effect for a transistor of a first pixel circuit in the display island region, and by arranging a hollow portion in the light-shielding block, it is possible to avoid parasitic capacitance with other metal film layers, which affects the display effect, due to the use of a large area of metal.

In some examples, the shielding layer may extend to a peripheral region and be electrically connected to a first power supply line in the peripheral region to connect to a first voltage signal to avoid affecting other signal wirings.

(3) A first semiconductor layer is formed. In some examples, a first semiconductor thin film is deposited on the base substrate on which the aforementioned pattern is formed, and the first semiconductor thin film is patterned by a patterning process to form a first semiconductor layer arranged on the base substrate. In some examples, a material of the first semiconductor layer may be amorphous silicon (a-Si), polycrystalline silicon (p-Si), hexathiophene or polythiophene, or other materials.

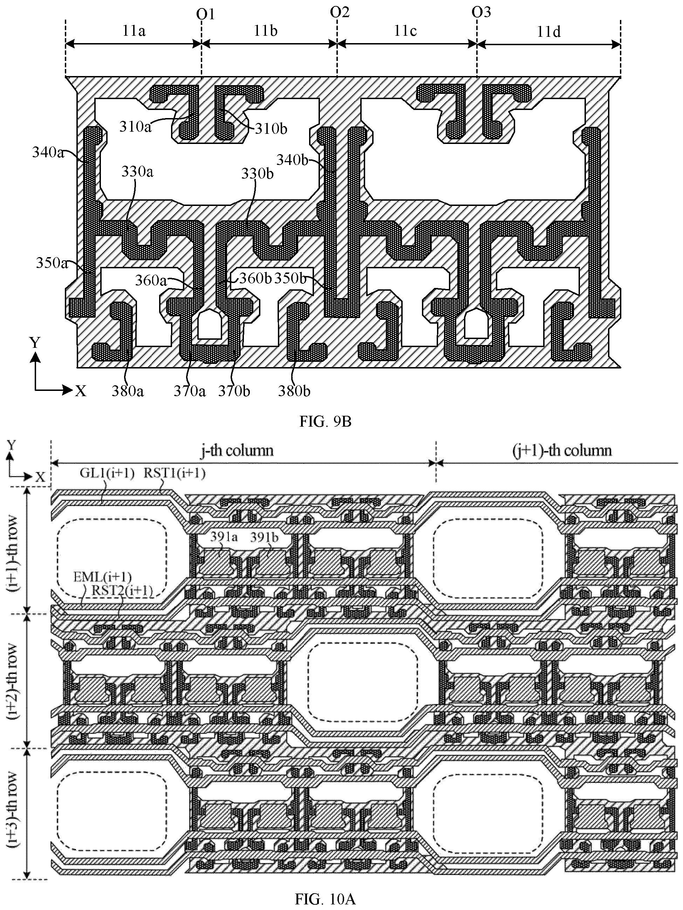

FIG. 9A is a schematic diagram of the first display area after a first semiconductor layer is formed in FIG. 7. FIG. 9B is a schematic diagram of one first display island region in FIG. 9A. In some examples, as shown in FIGS. 9A and 9B, the first semiconductor layer of the first display area may at least include: active layers of a plurality of first-type transistors of a plurality of first pixel circuits (e.g., including: a first active layer 310a of a first transistor of the first pixel circuit 11a, a third active layer 330a of a third transistor of the first pixel circuit 11a, a fourth active layer 340a of a fourth transistor of the first pixel circuit 11a, a fifth active layer 350a of a fifth transistor of the first pixel circuit 11a, a sixth active layer 360a of a sixth transistor of the first pixel circuit 11a, a seventh active layer 370a of a seventh transistor of the first pixel circuit 11a, and an eighth active layer 380a of an eighth transistor of the first pixel circuit 11a; and a first active layer 310b of a first transistor of the first pixel circuit 11b, a third active layer 330b of a third transistor of the first pixel circuit 11b, a fourth active layer 340b of a fourth transistor of the first pixel circuit 11b, a fifth active layer 350b of a fifth transistor of the first pixel circuit 11b, a sixth active layer 360b of a sixth transistor of the first pixel circuit 11b, a seventh active layer 370b of a seventh transistor of the first pixel circuit 11b, and an eighth active layer 380b of an eighth transistor of the first pixel circuit 11b).

In some examples, as shown in FIG. 9B, within a first display island region, the patterns of the first semiconductor layers of the first pixel circuits 11a and 11b may be substantially symmetrical with respect to the first centerline O1, the patterns of the first semiconductor layers of the first pixel circuits 11b and 11c may be substantially symmetrical with respect to the second centerline O2, and the patterns of the first semiconductor layers of the first pixel circuits 11c and 11d may be substantially symmetrical with respect to the third centerline O3. The patterns of the first semiconductor layers of the first pixel circuits 11a and 11b and the patterns of the first semiconductor layers of the first pixel circuits 11c and 11d may be substantially symmetrical with respect to the second centerline O2. As shown in FIG. 9A, the patterns of the first semiconductor layers in different display island regions may be independent of each other.

In some examples, as shown in FIG. 9B, the third active layers, the fourth active layers, the fifth active layers, the sixth active layers, and the seventh active layers of the four first pixel circuits within a first display island region may be connected to each other to form an integrated structure. The seventh active layer 370a of the first pixel circuit 11a and the seventh active layer 370b of the first pixel circuit 11b may be directly connected, the fifth active layer 350b of the first pixel circuit 11b and the fifth active layer of the first pixel circuit 11c may be directly connected, and the seventh active layer of the first pixel circuit 11c and the seventh active layer of the first pixel circuit 11d may be directly connected.

In some examples, as shown in FIG. 9B, the pattern of the first semiconductor layer of the first pixel circuit 11a is taken as an example for description. In the first pixel circuit 11a, the first active layer 310a and the fourth active layer 340a may be located on a side of the third active layer 330a in the second direction Y, and the fifth active layer 350a, the sixth active layer 360a, the seventh active layer 370a, and the eighth active layer 380a may be located on a side of the third active layer 330a in an opposite direction of the second direction Y. The first active layer 310a, the sixth active layer 360a, and the seventh active layer 370a may be aligned in the second direction Y.

In some examples, the third active layer 330a may be substantially u-shaped, the fourth active layer 340a may be substantially I-shaped, and the fifth active layer 350a, the sixth active layer 360a, the seventh active layer 370a, and the eighth active layer 380a may be substantially L-shaped. However, the present embodiment is not limited thereto. An arrangement and a shape of the pattern of the first semiconductor layer of the first pixel circuits 11b, 11c, and 11d are similar to an arrangement and a shape of the pattern of the first semiconductor layer of the first pixel circuit 11a and therefore will not be repeated here.

In some examples, an active layer of each transistor may include: a first region, a second region, and a channel region located between the first region and the second region. Among them, a material of the first semiconductor layer may include, for example, polysilicon. The channel region may not be doped with an impurity, and has characteristics of a semiconductor. The first region and the second region may be doped regions on both sides of the channel region, and are doped with impurities, and thus have conductivity. The impurities may be changed according to a type of a transistor. In some examples, a doped region of the active layer may be interpreted as a source or a drain of a transistor. A part of the active layer between the transistors may be interpreted as a wiring doped with an impurity, and may be used for electrically connecting the transistors. The present embodiment is not limited thereto.

In some examples, as shown in FIG. 9A, an orthographic projection of the shielding layer of the first display area on the base substrate may cover an orthographic projection of the first semiconductor layer on the base substrate. As shown in FIG. 9B, an orthographic projection of the shielding block 300 of the first display island region on the base substrate may cover orthographic projections of the first semiconductor layers of the four first pixel circuits of the first display island region on the base substrate. In this example, by arranging a shielding layer to shield the first semiconductor layer, external light can be prevented from affecting the transistor of the pixel circuit, thereby ensuring the performance of the transistor.

(4) A first conductive layer is formed. In some examples, a first insulation thin film and a first conductive thin film are deposited sequentially on the base substrate on which the aforementioned structures are formed, and the first conductive thin film is patterned through a patterning process to form a first insulating layer and a first conductive layer arranged on the first insulating layer. In some examples, the first conductive layer may also be referred to as a first gate metal layer and the first insulating layer may also be referred to as a first gate insulating layer.

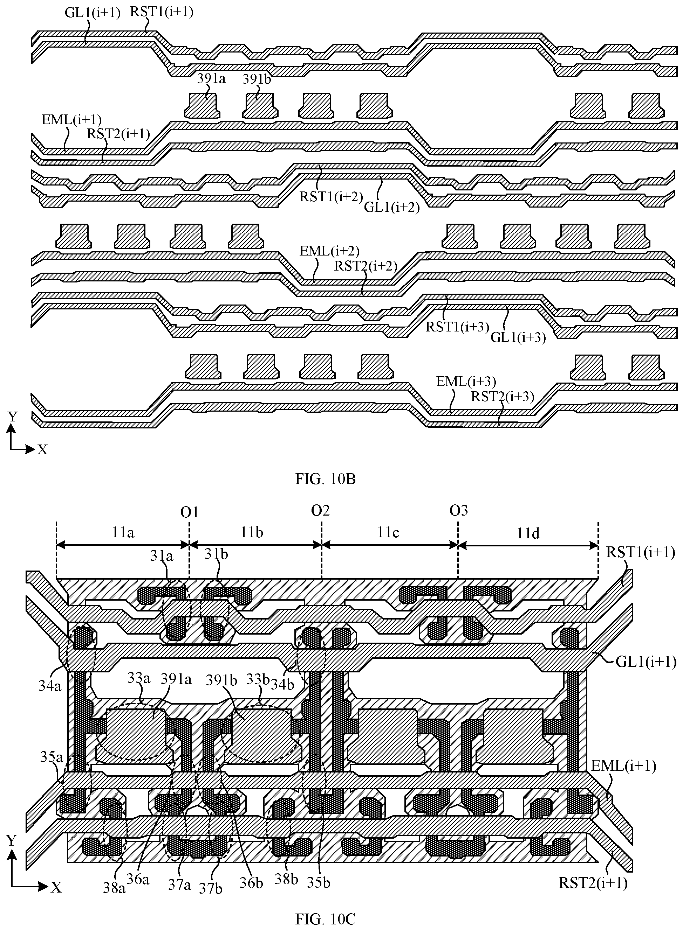

FIG. 10A is a schematic diagram of a first display area after a first conductive layer is formed in FIG. 7. FIG. 10B is a schematic diagram of the first conductive layer in FIG. 10A. FIG. 10C is a schematic diagram of one first display island region in FIG. 10A. In some examples, as shown in FIGS. 10A to 10C, the first conductive layer of the first display area may at least include: a plurality of first scan lines (e.g., including first scan lines GL1(i+1), GL1(i+2), and GL(i+3)), a plurality of light emitting control lines (e.g., including light emitting control lines EML(i+1), EML(i+2), and EML(i+3)), a plurality of first reset control lines (e.g., including first reset control lines RST1(i+1), RST1(i+2), and RST1(i+3)), a plurality of second reset control lines (e.g., including second reset control lines RST2(i+1), RST2(i+2), and RST2(i+3)), and first electrodes of storage capacitors of a plurality of first pixel circuits (e.g., including first electrodes 391a and 391b).

In some examples, the first scan line GL1(i+1) may be located on a side of the first electrode (e.g., the first electrodes 391a and 391b) of the storage capacitor of the first pixel circuit in the second direction Y, and the first reset control line RST1(i+1) may be located on a side of the first scan line GL1(i+1) in the second direction Y. The light emitting control line EML(i+1) may be located on a side of the first electrode (e.g., the first electrodes 391a and 391b) of the storage capacitor of the first pixel circuit in the opposite direction of the second direction Y, and the second reset control line RST2(i+1) may be located on a side of the light emitting control line EML(i+1) in the opposite direction of the second direction Y.

In some examples, the first reset control line RST1(i+1), the first scan line GL1(i+1), the second reset control line RST2(i+1), and the light emitting control line EML(i+1) may be bent to bypass the light-transmitting region. For example, the first reset control line RST1(i+1) and the first scan line GL1(i+1) may bypass the light-transmitting region along a side in the second direction Y, and the second reset control line RST2(i+1) and the light-emitting control line EML(i) may bypassed the light-transmitting region along a side in the opposite direction of the second direction Y. In this example, by bending the wires of the first conductive layer to bypass the light-transmitting region, it is conducive to increasing the area of the light-transmitting region, thereby improving the light transmittance of the first display area.

In some examples, the first reset control line RST1(i+1) may be substantially in a shape of a bend line extending in the first direction X. In a first display island region, overlapping areas of the first reset control line RST1(i+1) with first active layers of four first pixel circuits may serve as gate electrodes of first transistors of the four first pixel circuits (e.g., including a gate electrode of the first transistor 31a, and a gate electrode of the first transistor 31b).

In some examples, the first scan line GL1(i+1) may be substantially in a shape of a bend line extending in the first direction X. In a first display island region, overlapping areas of the first scan line GL1(i+1) with fourth active layers of four first pixel circuits may serve as gate electrodes of fourth transistors of the four first pixel circuits (e.g., including a gate electrode of the fourth transistor 34a, and a gate electrode of the fourth transistor 34b).

In some examples, the light emitting control line EML(i+1) may be substantially in a shape of a bend line extending in the first direction X. In a first display island region, overlapping areas of the light emitting control line EML(i+1) with fifth active layers of four first pixel circuits may serve as gate electrodes of fifth transistors of the four first pixel circuits (e.g., including gate electrodes of the fifth transistors 35a and 35b), and overlapping areas of the light emitting control line EML(i+1) with sixth active layers of the four first pixel circuits may serve as gate electrodes of sixth transistors of the four first pixel circuits (e.g., including gate electrodes of the sixth transistors 36a and 36b).

In some examples, the second reset control line RST2(i+1) may be substantially in a shape of a bend line extending in the first direction X. In a first display island region, overlapping areas of the second reset control line RST2(i+1) with seventh active layers of four first pixel circuits may serve as gate electrodes of seventh transistors of the four first pixel circuits (e.g., including gate electrodes of the seventh transistors 37a and 37b), and overlapping areas of the second reset control line RST2(i+1) with eighth active layers of the four first pixel circuits may serve as gate electrodes of eighth transistors of the four first pixel circuits (e.g., including gate electrodes of the eighth transistors 38a and 38b).

In some examples, the first electrode 391a of the storage capacitor of the first pixel circuit 11a may simultaneously serve as a gate electrode of the third transistor 33a, and the first electrode 391b of the storage capacitor of the first pixel circuit 11b may simultaneously serve as a gate electrode of the third transistor 33b. Orthographic projections of the first electrodes 391a and 391b on the base substrate may be substantially rectangular. The present embodiment is not limited thereto.

(5) A second conductive layer is formed. In some examples, a second insulation thin film and a second conductive thin film are deposited sequentially on the base substrate on which the aforementioned structures are formed, and the second conductive thin film is patterned through a patterning process to form a second insulating layer and a second conductive layer arranged on the second insulating layer. In some examples, the second conductive layer may also be referred to as a second gate metal layer and the second insulating layer may also be referred to as a second gate insulating layer.

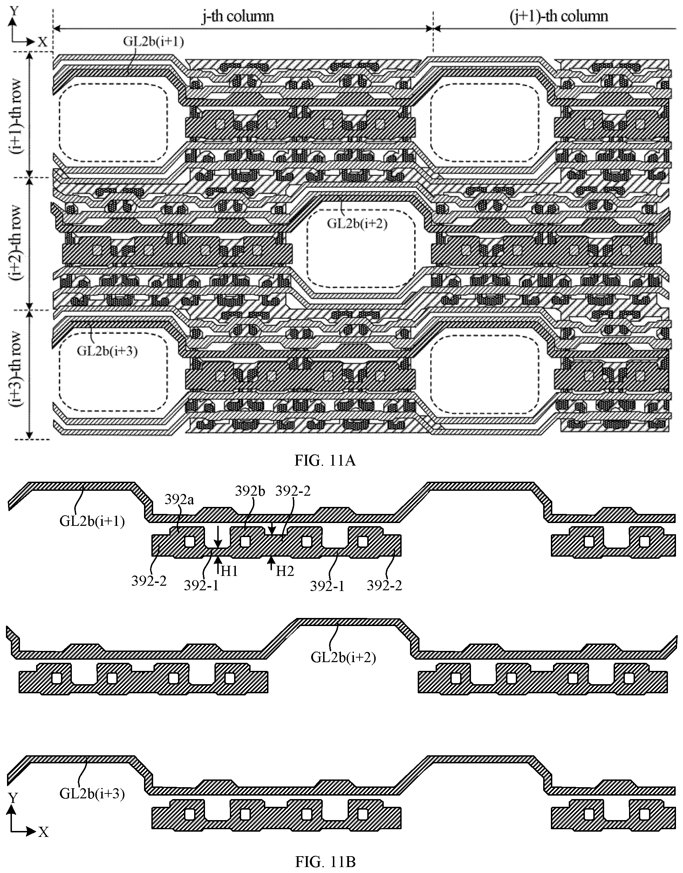

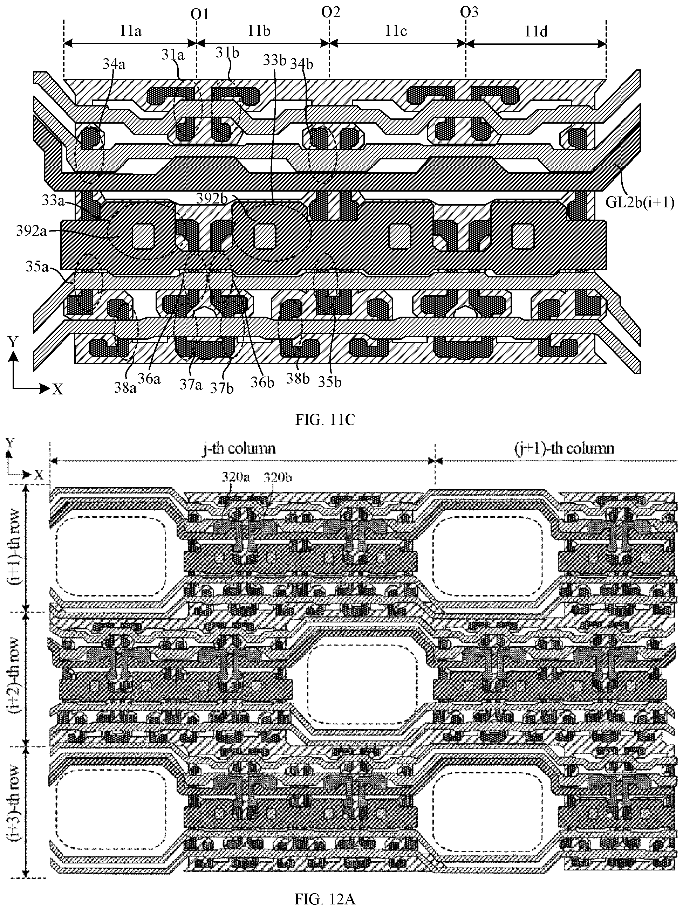

FIG. 11A is a schematic diagram of a first display area after a second conductive layer is formed in FIG. 7. FIG. 11B is a schematic diagram of the second conductive layer in FIG. 11A. FIG. 11C is a schematic diagram of one first display island region in FIG. 11A. In some examples, as shown in FIGS. 11A to 11C, the second conductive layer of the first display area may at least include: a plurality of second scan auxiliary lines (e.g., including second scan auxiliary lines GL2b(i+1), GL2b(i+2), and GL2b(i+3)), and second electrodes of storage capacitors of a plurality of first pixel circuits (e.g., including second electrodes 392a and 392b).

In some examples, the second scan auxiliary line GL2b(i+1) may be substantially in a shape of a bend line extending in the first direction X. In a first display island region, the second scan auxiliary line GL2b(i+1) may be located on a side of the second electrode (e.g., the second electrodes 392a and 392b) of the storage capacitor of the first pixel circuit in the second direction Y. The second scan auxiliary line GL2b(i+1) may bypass a light-transmitting region from a side in the second direction Y, and is located on a side of the first scan line GL1(i+1) in the opposite direction of the second direction Y.

In some examples, within a first display island region, an orthographic projection of the second electrode of the storage capacitor of each first pixel circuit on the base substrate may be substantially a rectangular structure having a hollow region, an orthographic projection of the hollow region on the base substrate may be substantially in a shape of a rectangle, and the rectangle may have rounded corners or chamfers. The second electrode 392a of the storage capacitor of the first pixel circuit 11a and the second electrode 392b of the storage capacitor of the first pixel circuit 11b may be electrically connected through a first plate connection block 392-1, the second electrode 392b of the storage capacitor of the first pixel circuit 11b and the second electrode of the storage capacitor of the first pixel circuit 11c may be electrically connected through a second plate connection block 392-2, and the second electrode of the storage capacitor of the first pixel circuit 11c and the second electrode of the storage capacitor of the first pixel circuit 11d may be electrically connected through another first plate connection block 392-1. A side of the second electrode 392a of the storage capacitor of the first pixel circuit 11a away from the first pixel circuit 11b may be connected to one second plate connection block 392-2, and a side of the second electrode of the storage capacitor of the first pixel circuit 11d away from the first pixel circuit 11c may be electrically connected to another second plate connection block 392-2. A length H1 of the first plate connection block 392-1 in the second direction Y may be smaller than a length H2 of the second plate connection block 392-2 in the second direction Y. The second electrode of the storage capacitor may subsequently be electrically connected to the first power supply line through a second plate connection block. In this example, the second electrodes of the storage capacitors of the four first pixel circuits of a first display island region may be connected to each other to form an integrated structure, which is conducive to ensuring uniform transmission of the first voltage signal in the first direction X.

(6) A second semiconductor layer is formed. In some examples, a third insulation thin film and a second semiconductor thin film are sequentially deposited on the base substrate on which the aforementioned patterns are formed, and the second semiconductor thin film is patterned through a patterning process to form a third insulating layer and a second semiconductor layer arranged on the third insulating layer. In some examples, a material of the second semiconductor layer may include Indium Gallium Zinc Oxide (IGZO). In some examples, the third insulating layer may also be referred to as a third gate insulating layer.

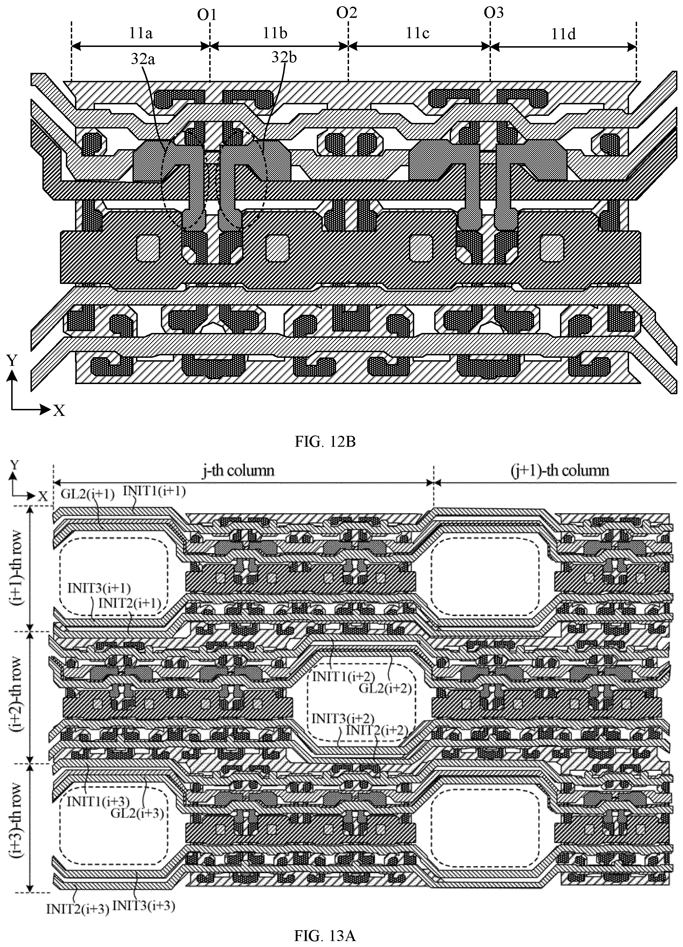

FIG. 12A is a schematic diagram of a first display area after a second semiconductor layer is formed in FIG. 7. FIG. 12B is a schematic diagram of one first display island region in FIG. 12A. In some examples, as shown in FIGS. 12A and 12B, the second semiconductor layer of the first display area may at least include: active layers of second-type transistors of a plurality of first pixel circuits (e.g., including: the second active layer 320a of the second transistor 32a of the first pixel circuit 11a, and the second active layer 320b of the second transistor 32b of the first pixel circuit 11b).

In some examples, within a first display island region, the patterns of the second semiconductor layers of the first pixel circuits 11a and 11b may be substantially symmetrical with respect to the first centerline O1, the patterns of the second semiconductor layers of the first pixel circuits 11b and 11c may be substantially symmetrical with respect to the second centerline O2, and the patterns of the second semiconductor layers of the first pixel circuits 11c and 11d may be substantially symmetrical with respect to the third centerline O3. The patterns of the second semiconductor layers of the first pixel circuits 11a and 11b and the patterns of the second semiconductor layers of the first pixel circuits 11c and 11d may be substantially symmetrical with respect to the second centerline O2.

In some examples, the second active layers 320a and 320b may be substantially in an inverted L-shape. An overlapping area of the second scan auxiliary line GL2b(i+1) with the second active layer 320a may serve as a bottom gate of the second transistor 32a, and an overlapping area of the second scan auxiliary line GL2b(i+1) with the second active layer 320b may serve as a bottom gate of the second transistor 32b.

In some examples, an orthographic projection of the second semiconductor layer on the base substrate and an orthographic projection of the shielding layer on the base substrate may not overlap. For example, orthographic projections of the second active layers 320a and 320b on the base substrate may be located within an orthographic projection of a first hollow region 301 on the base substrate.

(7) A third conductive layer is formed. In some examples, a fourth insulation thin film and a third conductive thin film are sequentially deposited on the base substrate on which the aforementioned patterns are formed, and the third conductive thin film is patterned through a patterning process to form a fourth insulating layer and a third conductive layer arranged on the fourth insulating layer. In some examples, the third conductive layer may also be referred to as a third gate metal layer and the fourth insulating layer may also be referred to as a fourth gate insulating layer.

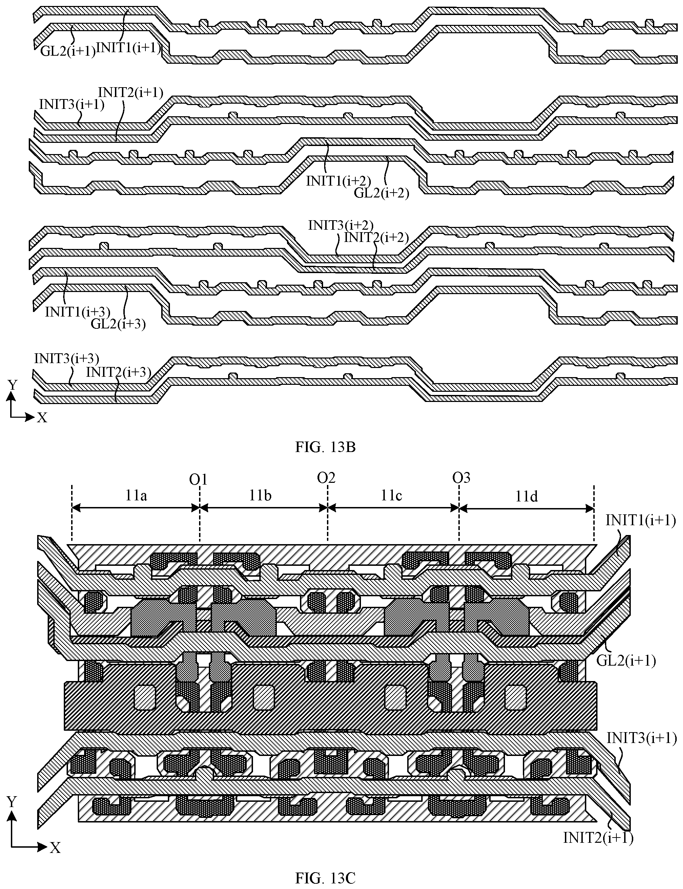

FIG. 13A is a schematic diagram of a first display area after a third conductive layer is formed in FIG. 7. FIG. 13B is a schematic diagram of the third conductive layer in FIG. 13A. FIG. 13C is a schematic diagram of one first display island region in FIG. 13A. In some examples, the third conductive layer of the first display area may at least include: a plurality of second scan lines (e.g., including second scan lines GL2(i+1), GL2(i+2), and GL2(i+3)), a plurality of first initial signal lines (e.g., including first initial signal lines INIT1(i+1), INIT1(i+2), and INIT1(i+3)), a plurality of second initial signal lines (e.g., including second initial signal lines INIT2(i+1), INIT2(i+2), and INIT2(i+3)), and a plurality of third initial signal lines (e.g., including third initial signal lines INIT3(i+1), INIT3(i+2), and INIT3(i+3)). Shapes of the first initial signal lines, the second scan lines, the second initial signal lines, and the third initial signal lines may each be substantially a polyline shape extending along the first direction X.

In some examples, in a first display island region, the first initial signal line INIT1(i+1) and the second scan line GL2(i+1) may be located on a side of the storage capacitor in the second direction Y, and the second initial signal line INIT2(i+1) and the third initial signal line INIT3(i+1) may be located on a side of the storage capacitor in the opposite direction of the second direction Y. The first initial signal line INIT1(i+1) may be located on a side of the second scan line GL2(i+1) in the second direction Y, the third initial signal line INIT3(i+1) and the second initial signal line INIT2(i+1) may be located on a side of the second scan line GL2(i+1) in the opposite direction of the second direction Y, and the second initial signal line INIT2(i+1) may be located on a side of the third initial signal line INIT3(i+1) in the opposite direction of the second direction Y.

In some examples, the first initial signal line INIT1(i+1), the second scan line GL2(i+1), the second initial signal line INIT2(i+1), and the third initial signal line INIT3(i+1) may be bent to bypass a light-transmitting region. For example, the first initial signal line INIT1(i+1) and the second scan line GL2(i+1) may be bypassed a light-transmitting region from a side in the second direction Y, and the second initial signal line INIT2(i+1) and the third initial signal line INIT3(i+1) may bypass a light-transmitting region from a side in the opposite direction of the second direction Y. In this example, by bending the wires of the third conductive layer to bypass the light-transmitting region, the area of the light-transmitting region can be increased, which is conducive to improving the light transmittance of the first display area.

In some examples, an orthographic projection of the first initial signal line INIT1(i+1) on the base substrate may at least partially overlap an orthographic projection of the first reset control line RST1(i+1) on the base substrate. For example, the orthographic projection of the first initial signal line INIT1(i+1) on the base substrate may contain the orthographic projection of the first reset control line RST1(i+1) on the base substrate. An orthographic projection of the second scan line GL2(i+1) on the base substrate may at least partially overlap an orthographic projection of the second scan auxiliary line GL2b(i+1) on the base substrate. For example, the orthographic projection of the second scan line GL2(i+1) on the base substrate may contain the orthographic projection of the second scan auxiliary line GL2b(i+1) on the base substrate. An orthographic projection of the third initial signal line INIT3(i+1) on the base substrate may at least partially overlap an orthographic projection of the light emitting control line EML(i+1) on the base substrate. For example, the orthographic projection of the third initial signal line INIT3(i+1) on the base substrate may contain the orthographic projection of the light emitting control line EML(i+1) on the base substrate. An orthographic projection of the second initial signal line INIT2(i) on the base substrate may at least partially overlap an orthographic projection of the second reset control line RST2(i+1) on the base substrate. For example, the orthographic projection of the second initial signal line INIT2(i+1) on the base substrate may contain the orthographic projection of the second reset control line RST2(i+1) on the base substrate. In the example, traces of different conductive layers (for example, the first conductive layer, the second conductive layer, and the third conductive layer) are stacked to avoid occupying too much trace space, which is beneficial to saving wiring space, thereby improving a light transmittance of the first display area.

(8) A fifth insulating layer is formed. In some examples, a fifth insulation thin film is deposited on the base substrate on which the aforementioned patterns are formed, and the fifth insulation thin film is patterned through a patterning process to form a fifth insulating layer. In some examples, the fifth insulating layer may also be referred to as an interlayer dielectric layer.

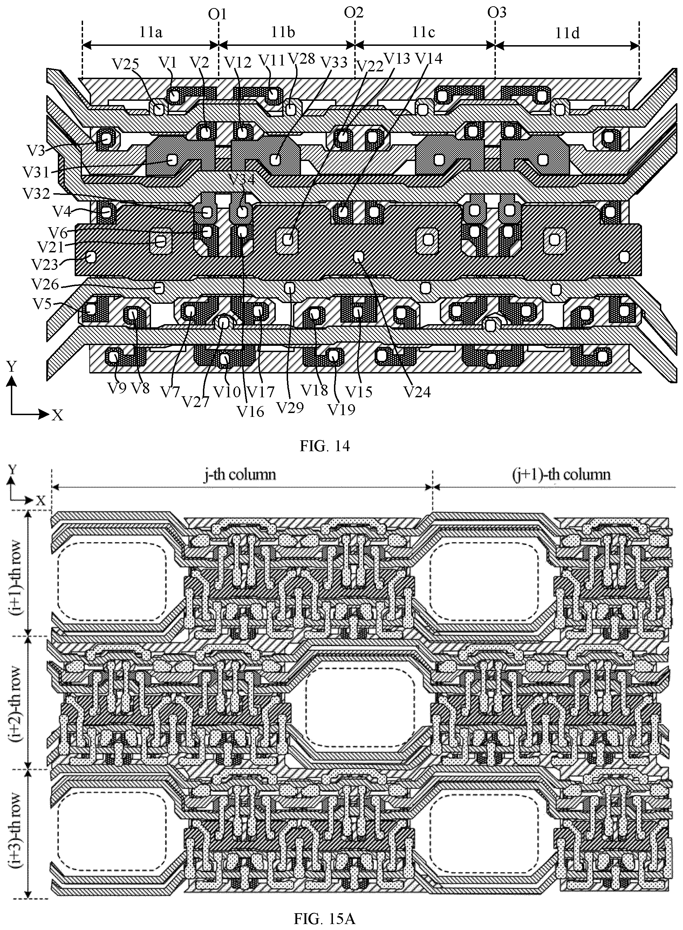

FIG. 14 is a schematic diagram of one first display island region after a fifth insulating layer is formed in FIG. 7. In some examples, as shown in FIG. 14, the fifth insulating layer of the first display area may be provided with a plurality of via holes, which, for example, may include a first via hole V1 to a nineteenth via hole V19, a twenty-first via hole V21 to a twenty-second via hole V22, a twenty-third via hole V23 to a twenty-fourth via hole V24, a twenty-fifth via hole V25 to a twenty-ninth via hole V29, and a thirty-first via hole V31 to a thirty-fourth via hole V34.

In some examples, the fifth insulating layer, the fourth insulating layer, the third insulating layer, the second insulating layer, and the first insulating layer within the first via hole V1 to the nineteenth via hole V19 may be removed, exposing part of a surface of the first semiconductor layer. The fifth insulating layer, the fourth insulating layer, the third insulating layer, and the second insulating layer within the twenty-first via hole V21 and the twenty-second via hole V22 may be removed, exposing part of a surface of the first conductive layer. The fifth insulating layer, the fourth insulating layer, and the third insulating layer within the twenty-third via hole V23 and the twenty-fourth via hole V24 may be removed, exposing part of a surface of the second conductive layer. The fifth insulating layer within the twenty-fifth via hole V25 to the twenty-ninth via hole V29 may be removed, exposing part of a surface of the third conductive layer. The fifth insulating layer and the fourth insulating layer within the thirty-first via hole V31 to the thirty-fourth via hole V34 may be removed, exposing a surface of the second semiconductor layer.

(9) A fourth conductive layer is formed. In some examples, a fourth conductive thin film is deposited on the base substrate on which the aforementioned patterns are formed, and the fourth insulation thin film is patterned through a patterning process to form a fourth conductive layer on the fifth insulating layer. In some examples, the fourth conductive layer may also be referred to as a first source-drain metal layer.

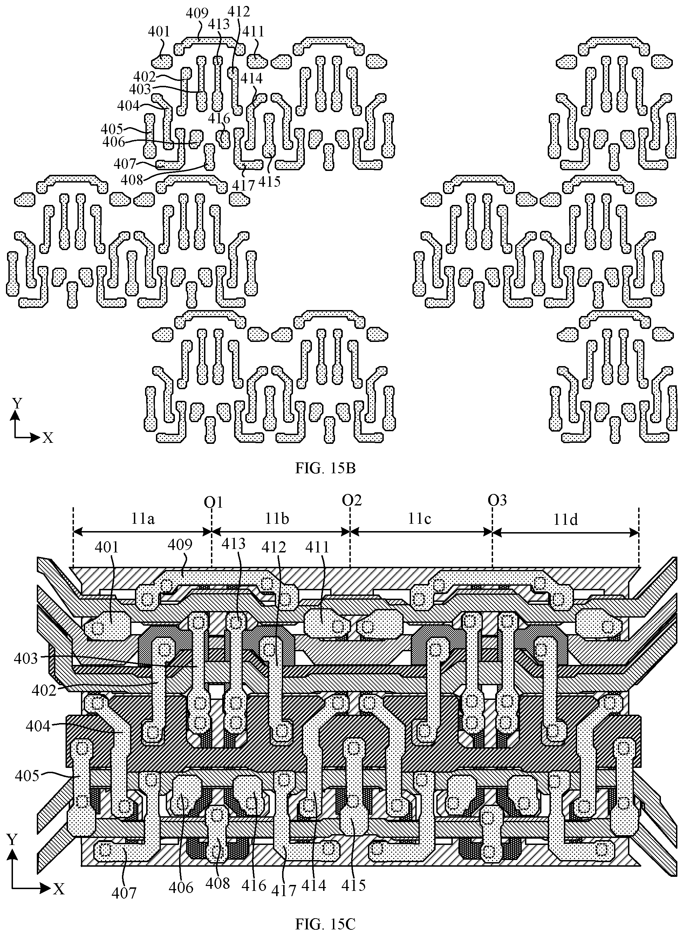

FIG. 15A is a schematic diagram of a first display area after a fourth conductive layer is formed in FIG. 7. FIG. 15B is a schematic diagram of a fourth conductive layer in FIG. 15A. FIG. 15C is a schematic diagram of one first display island region in FIG. 15A. In some examples, as shown in FIGS. 15A to 15C, the fourth conductive layer of the first display area may at least include: a plurality of connection electrodes (for example, including a first connection electrode 401 to a ninth connection electrode 409, and an eleventh connection electrode 411 to a seventeenth connection electrode 417).

In some examples, a shape of the first connection electrode 401 may be substantially a rectangle. The first connection electrode 401 may be electrically connected to the fourth active layer 340a of the fourth transistor 34a of the first pixel circuit 11a through the third via hole V3.

In some examples, the second connection electrode 402 may be substantially in a shape of a strip extending in the second direction Y. One end of the second connection electrode 402 may be electrically connected to the second active layer 320a of the second transistor 32a of the first pixel circuit 11a through the thirty-first via hole V31, and the other end of the second connection electrode 402 may be electrically connected to the first electrode 391a of the storage capacitor through the twenty-first via hole V21. The second connection electrode 402 is electrically connected to the gate electrode of the third transistor 33a, the first electrode 391a of the storage capacitor, and the first electrode of the second transistor 32a, and the second connection electrode 402 may serve as a first node of the first pixel circuit 11a.

In some examples, the third connection electrode 403 may be substantially in a shape of a strip extending in the second direction Y. One end of the third connection electrode 403 may be electrically connected to the first active layer 310a of the first transistor 31a of the first pixel circuit 11a through the second via hole V2, and the other end of the third connection electrode 403 may be electrically connected to the second active layer 320a of the second transistor 32a through the thirty-second via hole V32, and may also be electrically connected to the third active layer of the third transistor 33a through the sixth via hole V6. The third connection electrode 403 may serve as a third node of the first pixel circuit 11a.

In some examples, the fourth connection electrode 404 may be substantially in a shape of a bend line extending in the second direction Y. The fourth connection electrode 404 may be electrically connected to the fourth active layer 340a of the fourth transistor 34a of the first pixel circuit 11a through the fourth via hole V4, and may also be electrically connected to the eighth active layer 380a of the eighth transistor 38a through the eighth via hole V8.

In some examples, the fifth connection electrode 405 may be substantially in a shape of a strip extending in the second direction Y. The fifth connection electrode 405 may be electrically connected to the fifth active layer 350a of the fifth transistor 35a of the first pixel circuit 11a through the fifth via hole V5, and may also be electrically connected to the second plate connection block 392-2 through the twenty-third via hole V23, thereby realizing electrical connection to the second electrode 392a of the storage capacitor.

In some examples, a shape of the sixth connection electrode 406 may be substantially a rectangle. The sixth connection electrode 406 may be electrically connected to the sixth active layer 360a of the sixth transistor 36a of the first pixel circuit 11a through the seventh via hole V7.

In some examples, the seventh connection electrode 407 may be substantially L-shaped. The seventh connection electrode 407 may be electrically connected to the eighth active layer 380a of the eighth transistor 38a of the first pixel circuit 11a through the ninth via hole V9, and may also be electrically connected to the third initial signal line INIT3(i) through the twenty-sixth via hole V26.

In some examples, the eighth connection electrode 408 may be substantially in a shape of a strip extending in the second direction Y. The eighth connection electrode 408 may be electrically connected to the seventh active layer 370a of the seventh transistor 37a of the first pixel circuit 11a through the tenth via hole V10, and may also be electrically connected to the second initial signal line INIT2(i) through the twenty-seventh via hole V27.

In some examples, the ninth connection electrode 409 may be substantially in a shape of an arch extending in the second direction Y. One end of the ninth connection electrode 409 may be electrically connected to the first active layer 310a of the first transistor 31a of the first pixel circuit 11a through the first via hole V1, and may also be electrically connected to the first initial signal line INIT1(i) through the twenty-fifth via hole V25, and the other end of the ninth connection electrode 409 may be electrically connected to the first active layer 310b of the first transistor 31b of the first pixel circuit 11b through the eleventh via hole V11, and may also be electrically connected to the first initial signal line INIT1(i) through the twenty-eighth via hole V28.

In some examples, the eleventh connection electrode 411 may be substantially in a shape of a rectangle. The eleventh connection electrode 411 may be electrically connected to the fourth active layer 340b of the fourth transistor 34b of the first pixel circuit 11b through the thirteenth via hole V13.

In some examples, the twelfth connection electrode 412 may be substantially in a shape of a strip extending in the second direction Y. One end of the twelfth connection electrode 412 may be electrically connected to the second active layer 320b of the second transistor 32b of the first pixel circuit 11b through the thirty-third via hole V31, and the other end of the twelfth connection electrode 412 may be electrically connected to the first electrode 391b of the storage capacitor through the twenty-second via hole V22. The twelfth connection electrode 412 is electrically connected to the gate electrode of the third transistor 33b, the first electrode 391b of the storage capacitor, and the first electrode of the second transistor 32b. The twelfth connection electrode 412 may serve as a first node of the first pixel circuit 11b.

In some examples, the thirteenth connection electrode 413 may be substantially in a shape of a strip extending in the second direction Y. One end of the thirteenth connection electrode 413 may be electrically connected to the first active layer 310b of the first transistor 31b of the first pixel circuit 11b through the twelfth via hole V12, and the other end of the thirteenth connection electrode 413 may be electrically connected to the second active layer 320b of the second transistor 32b through the thirty-fourth via hole V34, and may also be electrically connected to the third active layer 330b of the third transistor 33b through the sixteenth via hole V16. The thirteenth connection electrode 413 may serve as a third node of the first pixel circuit 11b.

In some examples, the fourteenth connection electrode 414 may be substantially in a shape of a bend line extending in the second direction Y. The fourteenth connection electrode 414 may be electrically connected to the fourth active layer 340b of the fourth transistor 34b of the first pixel circuit 11b through the fourteenth via hole V14, and may also be electrically connected to the eighth active layer 380b of the eighth transistor 38b through the eighteenth via hole V18.

In some examples, the fifteenth connection electrode 415 may be substantially in a shape of a strip extending in the second direction Y. The fifteenth connection electrode 415 may be electrically connected to the fifth active layer 350b of the fifth transistor 35b of the first pixel circuit 11b through the fifteenth via hole V15, and may also be electrically connected to another second plate connection block 392-2 through the twenty-fourth via hole V24, thereby realizing electrical connection to the second electrode 392b of the storage capacitor.

In some examples, a shape of the sixteenth connection electrode 416 may be substantially a rectangle. The sixteenth connection electrode 416 may be electrically connected to the sixth active layer 360b of the sixth transistor 36b of the first pixel circuit 11b through the seventeenth via hole V17.

In some examples, the seventeenth connection electrode 417 may be generally L-shaped. The seventeenth connection electrode 417 may be electrically connected to the eighth active layer 380b of the eighth transistor 38b of the first pixel circuit 11b through the nineteenth via hole V19, and may also be electrically connected to the third initial signal line INIT3(i) through the twenty-ninth via hole V29.

In some examples, within a first display island region, the first pixel circuits 11a and 11b may be substantially symmetrical with respect to the second centerline O2, the first pixel circuits 11c and 11d may be substantially symmetrical with respect to the third centerline O3, and the first pixel circuits 11a and 11b, and the first pixel circuits 11c and 11d may be substantially symmetrical with respect to the first centerline O1.

(10) A sixth insulating layer and a seventh insulating layer are formed. In some examples, a sixth insulating thin film is deposited on the base substrate on which the aforementioned patterns are formed, then a seventh insulating thin film is coated, and the seventh insulating thin film and the sixth insulating thin film are patterned by a patterning process to form a sixth insulating layer and a seventh insulating layer. In some examples, the sixth insulating layer may also be referred to as a passivation layer and the seventh insulating layer may also be referred to as a first planarization layer.

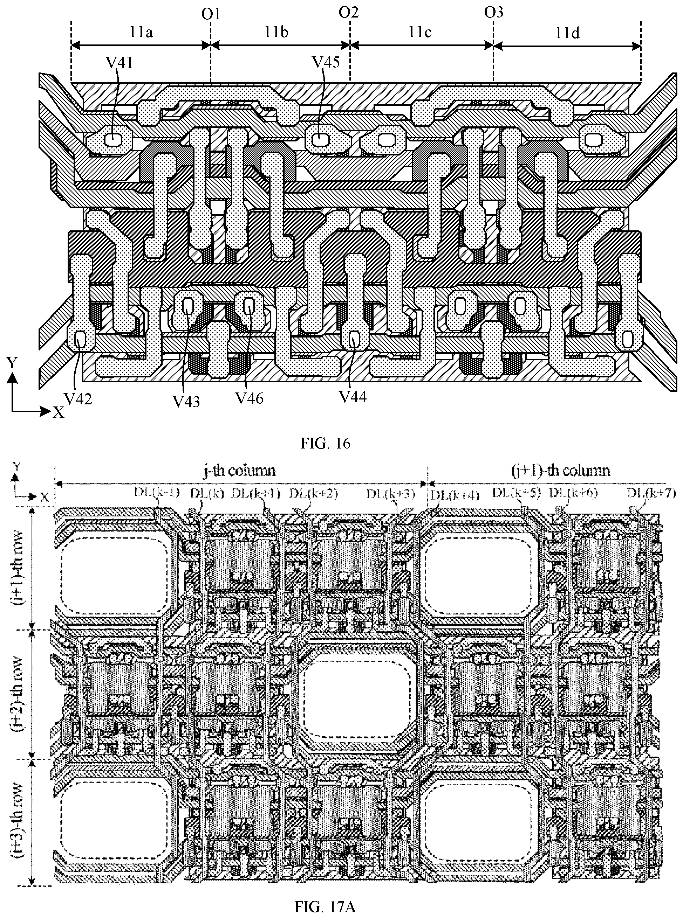

FIG. 16 is a schematic diagram of one first display island region after a seventh insulating layer is formed in FIG. 7. In some examples, as shown in FIG. 16, the seventh insulating layer of the first display area may be provided with a plurality of via holes, which, for example, may include a forty-first via hole V41 to a forty-sixth via hole V46. The seventh insulating layer and the sixth insulating layer within the forty-first via hole V41 to the forty-sixth via hole V46 may be removed, exposing part of a surface of the fourth conductive layer.

(11) A fifth conductive layer is formed. In some examples, a fifth conductive thin film is deposited on the base substrate on which the aforementioned patterns are formed, and the fifth conductive thin film is patterned through a patterning process to form a fifth conductive layer on the seventh insulating layer. In some examples, the fifth conductive layer may also be referred to as a second source-drain metal layer.

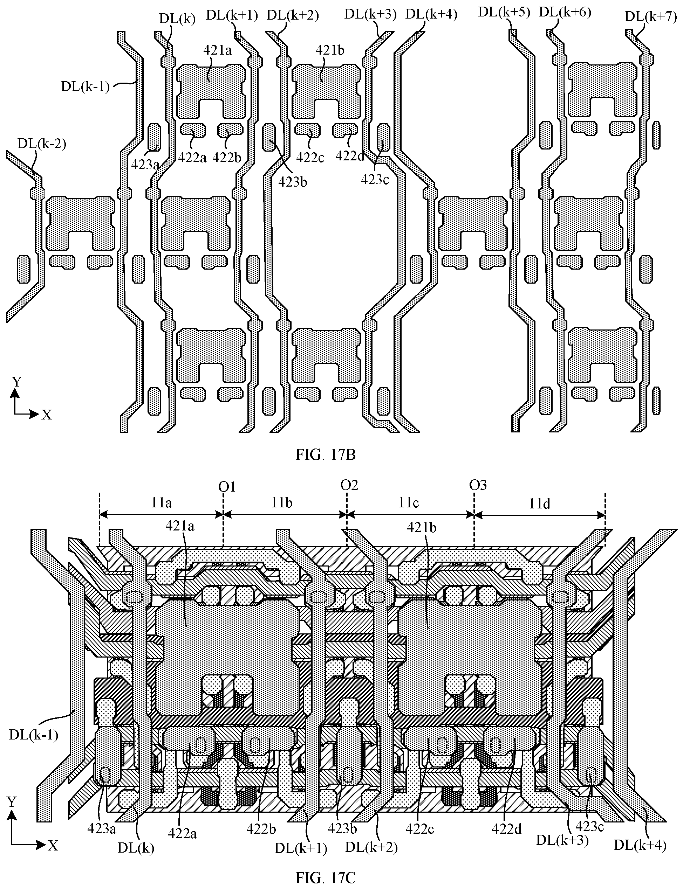

FIG. 17A is a schematic diagram of the first display area after a fifth conductive layer is formed in FIG. 7. FIG. 17B is a schematic diagram of the fifth conductive layer in FIG. 17A. FIG. 17C is a schematic diagram of one first display island region in FIG. 17A. In some examples, as shown in FIGS. 17A to 17C, the fifth conductive layer of the first display area may at least include: a plurality of data lines (e.g., data lines DL(k-2), DL(k-1), DL(k), DL(k+1), DL(k+2), DL(k+3), DL(k+4), DL(k+5), DL(k+6), and DL(k+7)), a plurality of first anode connection electrodes (e.g., first anode connection electrodes 422a, 422b, 422c, and 422d), a plurality of first power supply connection electrodes (e.g., first power supply connection electrodes 423a, 423b, and 423c), and a plurality of first shielding electrodes (e.g., first shielding electrodes 421a and 421b). Here, k is an integer greater than 0.

In some examples, the plurality of data lines may be substantially in a shape of a bend line extending in the second direction Y. The four first pixel circuits within each first display island region are electrically connected to four data lines in one-to-one correspondence. The data line DL(k) may be electrically connected to the first connection electrode 401 through the forty-first via hole V41, thereby being electrically connected to the fourth transistor of the first pixel circuit 11a. The data line DL(k+1) may be electrically connected to the eleventh connection electrode 411 through the forty-fifth via hole V45, thereby being electrically connected to the fourth transistor of the first pixel circuit 11b. The data line DL(k+2) may be electrically connected to the fourth transistor of the first pixel circuit 11c. The data line DL(k+3) may be electrically connected to the fourth transistor of the first pixel circuit 11d. In some examples, the data lines DL(k-1), DL(k+2), DL(k+3), and DL(k+5) may provide data signals to the first pixel circuits arranged in alternate rows.

In some examples, the four data lines electrically connected to the four first pixel circuits in a first display island region may be divided into two groups to bypass a light-transmitting region adjacent to the first display island region in the second direction Y. For example, the data line DL(k) to which the first pixel circuit 11a is connected, the data line DL(k+1) to which the first pixel circuit 11b is connected, and the data line DL(k+2) to which the first pixel circuit 11c is connected may bypass a light-transmitting region from a side in the opposite direction of the first direction X, and the data line DL(k+3) to which the first pixel circuit 11d is connected may bypass the light-transmitting region from a side in the first direction X. In this example, the data line is bent to bypass the light-transmitting region, which is conducive to reducing the space occupied by the wiring, thereby improving the light transmittance of the first display area.

In some examples, the first anode connection electrodes 422a, 422b, 422c, and 422d may be substantially in a shape of a rectangle. The first anode connection electrodes 422a and 422b may be located between the data lines DL(k) and DL(k+1), and the first anode connection electrodes 422c and 422d may be located between the data lines DL(k+2) and DL(k+3).

In some examples, the first anode connection electrode 422a may be electrically connected to the sixth connection electrode 406 through the forty-third via hole V43, thereby realizing electrical connection to the sixth transistor of the first pixel circuit 11a. The first anode connection electrode 422b may be electrically connected to the sixteenth connection electrode 416 through the forty-sixth via hole V46, thereby realizing electrical connection to the sixth transistor of the first pixel circuit 11b. The first anode connection electrode 422c may be electrically connected to the sixth transistor of the first pixel circuit 11c. The first anode connection electrode 422d may be electrically connected to the sixth transistor of the first pixel circuit 11d.

In some examples, the first power supply connection electrodes 423a, 423b, and 423c may be substantially in a shape of a rectangle. The first power supply connection electrode 423a may be located between the data lines DL(k) and DL(k-1), the first power supply connection electrode 423b may be located between the data lines DL(k+1) and DL(k+2), and the first power supply connection electrode 423c may be located between the data lines DL(k+3) and DL(k+3).

In some examples, the first power supply connection electrode 423a may be electrically connected to the fifth connection electrode 405 through the forty-second via hole V42, thereby realizing electrical connection to the fifth transistor and the storage capacitor of the first pixel circuit 11a. The second power supply connection electrode 423b may be electrically connected to the fifteenth connection electrode 415 through the forty-fourth via hole V44, thereby realizing electrical connection to the fifth transistors and the storage capacitors of the first pixel circuits 11b and 11c. The third power supply connection electrode 423c may be electrically connected to the fifth transistor and the storage capacitor of the first pixel circuit 11d.

In some examples, the first shielding electrodes 421a and 421b may be substantially n-shaped. The first shielding electrode 421a may be located between the data lines DL(k) and DL(k+1), and the first shielding electrode 421b may be located between the data lines DL(k+2) and DL(k+3). An orthographic projection of the first shielding electrode 511c on the base substrate may cover orthographic projections of the second connection electrode 402 and the twelfth connection electrode 412 on the base substrate, which may achieve shielding of the first node of the first pixel circuit 11a and the first node of the first pixel circuit 11b, thereby shielding an influence of other signals on the first nodes of the first pixel circuits 11a and 11b. The second shielding electrode 421b may achieve shielding of the first node of the first pixel circuit 11c and the first node of the first pixel circuit 11d, thereby shielding an influence of other signals on the first nodes of the first pixel circuits 11c and 11d.

(12) An eighth insulating layer is formed. In some examples, an eighth insulating layer is coated on the base substrate on which the aforementioned patterns are formed, and the eighth insulating layer is patterned through a patterning process to form an eighth insulating layer. In some examples, the eighth insulating layer may also be referred to as a second planarization layer.

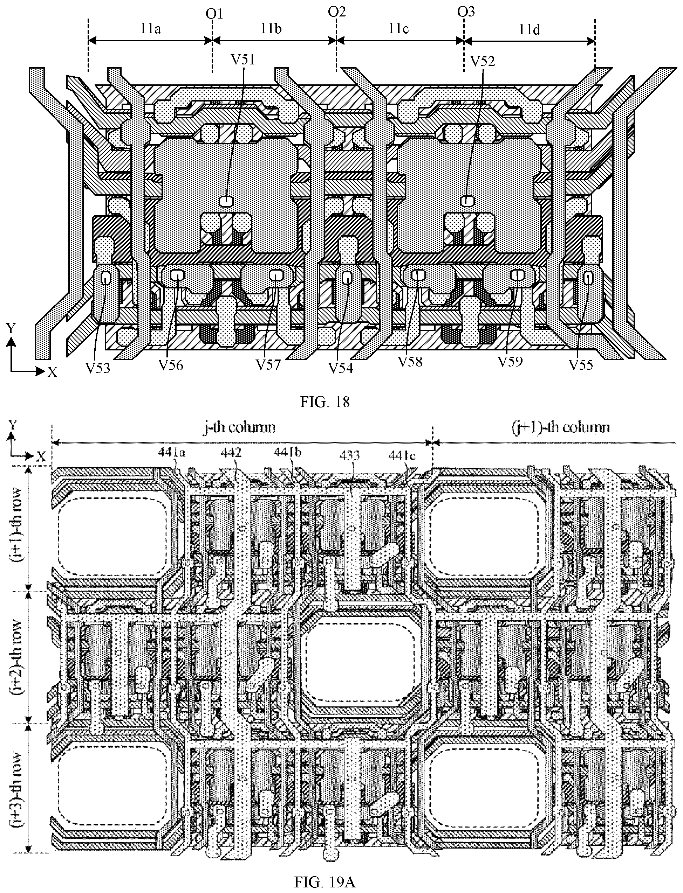

FIG. 18 is a schematic diagram of one first display island region after an eighth insulating layer is formed in FIG. 7. In some examples, as shown in FIG. 18, the eighth insulating layer 108 of the first display area may be provided with a plurality of via holes, which, for example, may include a fifty-first via hole V51 to a fifty-ninth via hole V59. The eighth insulating layer within the fifty-first via hole V51 to the fifty-ninth via hole V59 may be removed, exposing part of a surface of the fifth conductive layer.

(13) A sixth conductive layer is formed. In some examples, a sixth conductive thin film is deposited on the base substrate on which the aforementioned patterns are formed, and the sixth conductive thin film is patterned through a patterning process to form a sixth conductive layer on the eighth insulating layer. In some examples, the sixth conductive layer may also be referred to as a third source-drain metal layer.

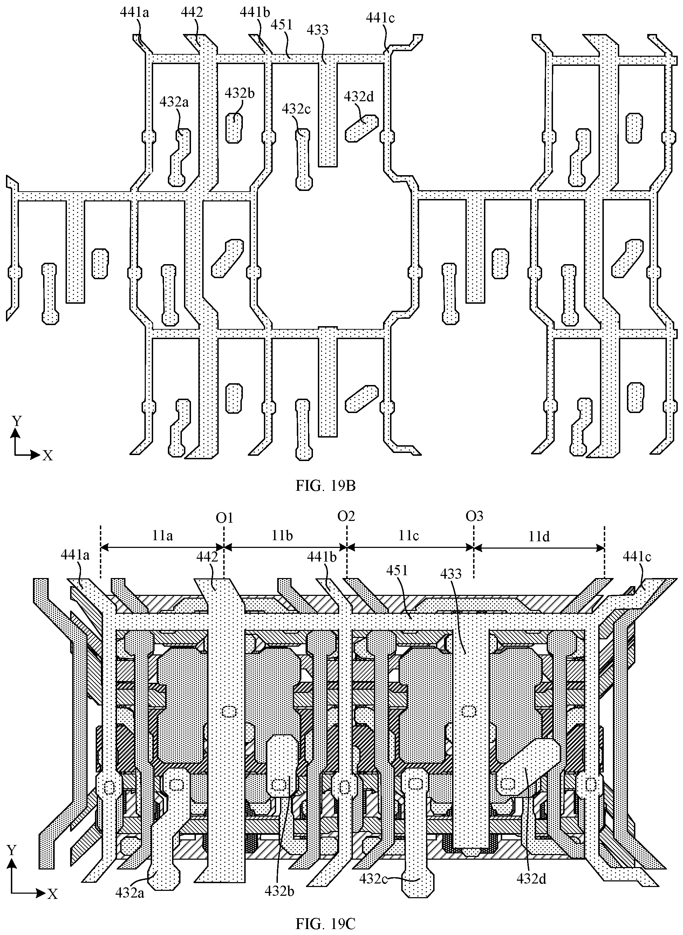

FIG. 19A is a schematic diagram of a first display area after a sixth conductive layer is formed in FIG. 7. FIG. 19B is a schematic diagram of the sixth conductive layer in FIG. 19A. FIG. 19C is a schematic diagram of one first display island region in FIG. 19A. In some examples, as shown in FIGS. 19A to 19C, the sixth conductive layer of the first display area may at least include: a plurality of second anode connection electrodes (for example, including second anode connection electrodes 432a, 432b, 432c, and 432d), a plurality of second power supply connection electrodes 433, a plurality of power supply connection bars 451, a plurality of first voltage transmission lines (for example, including first voltage transmission lines 441a, 441b, and 441c), and a plurality of second voltage transmission lines 442.

In some examples, the second anode connection electrode 432a may be located between the first voltage transmission line 441a and the second voltage transmission line 442, the second anode connection electrode 432b may be located between the second voltage transmission line 442 and the first voltage transmission line 441b, the second anode connection electrode 432c may be located between the first voltage transmission line 441b and the second power supply connection electrode 433, and the second anode connection electrode 432d may be located between the second power supply connection electrode 433 and the first voltage transmission line 441c.

In some examples, the second anode connection electrode 432a may be substantially in a shape of a polygonal structure extending in the second direction Y. The second anode connection electrode 432a may be electrically connected to the first anode connection electrode 422a through the fifty-sixth via hole V56. The second anode connection electrode 432b may be substantially in a shape of a rectangle. The second anode connection electrode 432b may be electrically connected to the first anode connection electrode 422b through the fifty-seventh via hole V57. The second anode connection electrode 432c may be substantially in a shape of a strip-like structure extending in the second direction Y. The second anode connection electrode 432c may be electrically connected to the first anode connection electrode 422c through the fifty-eighth via hole V58. The second anode connection electrode 432d may be substantially in a shape of a strip-like structure extending in a direction intersecting both the first direction X and the second direction Y. The second anode connection electrode 432d may be electrically connected to the first anode connection electrode 422d through the fifty-ninth via hole V59.

In some examples, the first voltage transmission lines 441a, 441b, and 441c and the second voltage transmission line 442 may be in a shape of a bend line extending in the second direction Y. A line width (i.e., a length in the first direction X) of the second voltage transmission line 442 may be greater than a line width of the first voltage transmission line 441a. The first voltage transmission lines 441a, 441b, and 441c may substantially have a same line width. The first voltage transmission line 441a may be electrically connected to the first power supply connection electrode 423a through the fifty-third via hole V53, the first voltage transmission line 441b may be electrically connected to the first power supply connection electrode 423b through the fifty-fourth via hole V54, and the first voltage transmission line 441c may be electrically connected to the first power supply connection electrode 423c through the fifty-fifth via hole V55. The second voltage transmission line 442 may be electrically connected to the first shielding electrode 421a through the fifty-first via hole V51. The first voltage transmission lines 441a, 441b, and 441c and the second voltage transmission line 442 may be connected to a first voltage signal. For example, the first voltage transmission lines 441a, 441b, and 441c and the second voltage transmission line 442 may extend to a peripheral region, and be electrically connected to the first power supply line in the peripheral region to realize connection to the first voltage signal.

In some examples, the second power supply connection electrode 433 may be of a strip-like structure extending in the second direction Y. The second power supply connection electrode 433 may be electrically connected to the first shielding electrode 421b through the fifty-second via hole V52.

In some examples, the power supply connection bar 451 may be substantially in a shape of a strip-like structure extending in the first direction X. The power supply connection line 451 may be connected to an adjacent voltage transmission line. The power supply connection line 451, the first voltage transmission lines 441a, 441b, and 441c, the second voltage transmission line 442, and the second power supply connection electrode 433 may be connected to each other to form an integrated structure, thereby forming a mesh connection structure for transmitting the first voltage signal, so as to ensure transmission uniformity of the first voltage signal.

In this example, the fifth conductive layer and the sixth conductive layer are provided to arrange the voltage transmission lines and the data lines, which can avoid arranging many wires on the conductive layers close to the anode layer to affect the flatness of the anode layer. Moreover, arranging the voltage transmission lines (including the first voltage transmission line and the second voltage transmission line) on the sixth conductive layer and arranging the data lines on the fifth conductive layer can increase the distance between the data lines and the anode layer, preventing signal transmission of the data lines from affecting the anode layer.

(14) A ninth insulating layer is formed. In some examples, a ninth insulating layer is coated on the base substrate on which the aforementioned patterns are formed, and the ninth insulating layer is patterned through a patterning process to form a ninth insulating layer. In some examples, the ninth insulating layer may also be referred to as a third planarization layer.

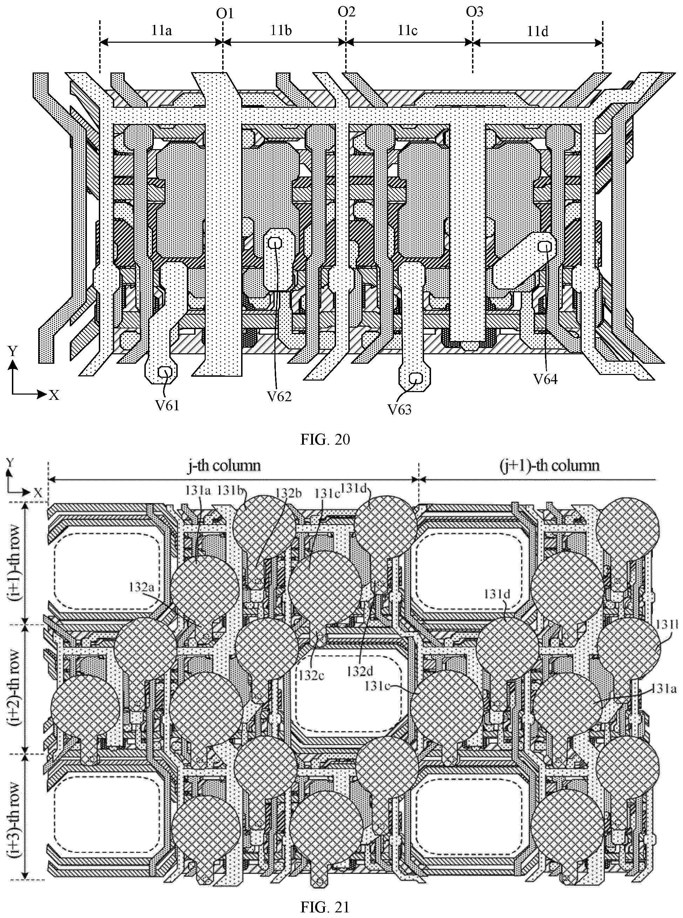

FIG. 20 is a schematic diagram of one first display island region after a ninth insulating layer is formed in FIG. 7. In some examples, as shown in FIG. 20, the ninth insulating layer of the first display area may be provided with a plurality of via holes, which, for example, may include a sixty-first via hole V61 to a sixty-fourth via hole V64. The ninth insulating layer within the sixty-first via hole V61 to the sixty-fourth via hole V64 may be removed, exposing part of a surface of the sixth conductive layer.

At this point, preparation of a circuit structure layer may be completed. A film layer structure of a circuit structure layer of the second display area is similar to a film layer structure of the first display area, and therefore, it will not be repeated herein.

(15) A light emitting structure layer is formed. In some examples, an anode thin film is deposited on the base substrate on which the aforementioned patterns are formed, and the anode thin film is patterned through a patterning process to form an anode layer.

FIG. 21 is a schematic diagram of the first display area after an anode layer is formed in FIG. 7. In some examples, as shown in FIG. 21, the anode layer of the first display area may at least include: anodes of a plurality of first light emitting elements (e.g., including an anode 131a of the first light emitting element 13a, an anode 131b of the first light emitting element 13b, an anode 131c of the first light emitting element 13c, and an anode 131d of the first light emitting element 13d), and a plurality of third anode connection electrodes (e.g., including third anode connection electrodes 132a, 132b, 132c, and 132d).

In some examples, the anodes 131a, 131b, 131c, and 131d may be substantially circular or elliptical in shape. The third anode connection electrodes 132a, 132b, 132c, and 132d may substantially have a rectangular shape. The anode 131a and the third anode connection electrode 132a may be of an interconnected integrated structure. The third anode connection electrode 132a may be electrically connected to the second anode connection electrode 432a through the sixty-first via hole V61 to realize electrical connection to the first pixel circuit 11a. The anode 131b and the third anode connection electrode 132b may be of an interconnected integrated structure. The third anode connection electrode 132b may be electrically connected to the second anode connection electrode 432b through the sixty-second via hole V62 to realize electrical connection to the first pixel circuit 11b. The anode 131c and the third anode connection electrode 132c may be of an interconnected integrated structure. The third anode connection electrode 132c may be electrically connected to the second anode connection electrode 432c through the sixty-third via hole V63 to realize electrical connection to the first pixel circuit 11c. The anode 131d and the third anode connection electrode 132d may be of an interconnected integrated structure. The third anode connection electrode 132d may be electrically connected to the second anode connection electrode 432d through the sixty-fourth via hole V64.

In some examples, a pixel definition thin film is coated on the base substrate on which the aforementioned patterns are formed, and a pixel definition layer is formed through masking, exposure, and development processes. As shown in FIG. 7, the pixel definition layer of the first display area may be formed with a plurality of first pixel openings (e.g. first pixel openings 130a, 130b, 130c, and 130d). The plurality of first pixel openings may be substantially circular in shape. The first pixel opening 130a of the first light emitting element 13b and the first pixel opening 130d of the first light emitting element 13d may have substantially a same size, the first pixel opening 130a of the first light emitting element 13a may be larger than the first pixel opening 130b of the first light emitting element 13b, and the first pixel circuit 130c of the first light emitting element 13c may be larger than the first pixel opening 130a of the first light emitting element 13a.

In some examples, an organic emitting layer is formed within a pixel opening formed above, and the organic emitting layer is connected with the anode layer. Subsequently, a cathode thin film is deposited, and the cathode thin film is patterned through a patterning process to form a pattern of a cathode, and the cathode is connected with the organic emitting layer.

In some examples, a light emitting region of a light emitting element may be a portion of the light emitting element located at a pixel opening of a pixel definition layer. The light emitting region of the first light emitting element 13a may be larger than the light emitting region of the first light emitting element 13b, the light emitting region of the first light emitting element 13c may be larger than the light emitting region of the first light emitting element 13a, and the light emitting region of the first light emitting element 13b and the light emitting region of the first light emitting element 13d may have substantially a same size.

In some examples, an encapsulation structure layer may be formed on the cathode after preparation of the light emitting structure layer. In some examples, the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer may be arranged between the first encapsulation layer and the third encapsulation layer to form a laminated structure of inorganic material/organic material/inorganic material, which may ensure that external moisture cannot enter the light emitting structure layer. In some possible implementations, the display substrate may include other film layers, such as a touch structure layer, and a color filter layer, which is not limited here in this embodiment.

In some examples, the shielding layer, the first conductive layer, the second conductive layer, the third conductive layer, the fourth conductive layer, the fifth conductive layer, and the sixth conductive layer may be made of a metal material, such as, any one or more of silver (Ag), copper (Cu), aluminum (Al), and molybdenum (Mo), or an alloy material of the above metals, such as, an aluminum-neodymium alloy (AlNd), or a molybdenum-niobium alloy (MoNb), which may be in a single layer structure, or a multi-layer composite structure, such as, Mo/Cu/Mo, etc. The first insulating layer, the second insulating layer, the third insulating layer, the fourth insulating layer, the fifth insulating layer, and the sixth insulating layer may be made of any one or more of Silicon Oxide (SiOx, x>0), Silicon Nitride (SiNy, y>0), and Silicon OxyNitride (SiON), and may be a single layer, a multi-layer, or a composite layer. The seventh insulating layer, the eighth insulating layer, and the ninth insulating layer may be made of an organic material, such as polyimide, acrylic, or polyethylene terephthalate. The pixel definition layer may be made of an organic material, such as polyimide, acrylic, or polyethylene terephthalate. The anode layer may be made of a reflective material such as a metal, and the cathode may be made of a transparent conductive material. However, the present embodiment is not limited thereto.

A structure and a preparation process of the display substrate of the embodiment are merely illustrative. In some exemplary implementations, a corresponding structure may be changed and a patterning process may be added or removed according to actual needs. The manufacturing process of the exemplary embodiment may be implemented using an existing mature manufacturing device, and may be compatible well with an existing manufacturing process, simple in process implementation, easy to implement, high in a production efficiency, low in a production cost, and high in yield.

In the display substrate in this example, compared with the second display area, in the first display area, light-transmitting regions are formed by deletion of the first pixel circuits and the first light emitting elements, and a wiring design of avoiding the light-transmitting regions is employed in the light-transmitting regions, thereby improving the light transmittance of the first display area, while ensuring the light emitting white balance of the first display area, so as to satisfy the requirements of the under-screen function for size and light transmittance.

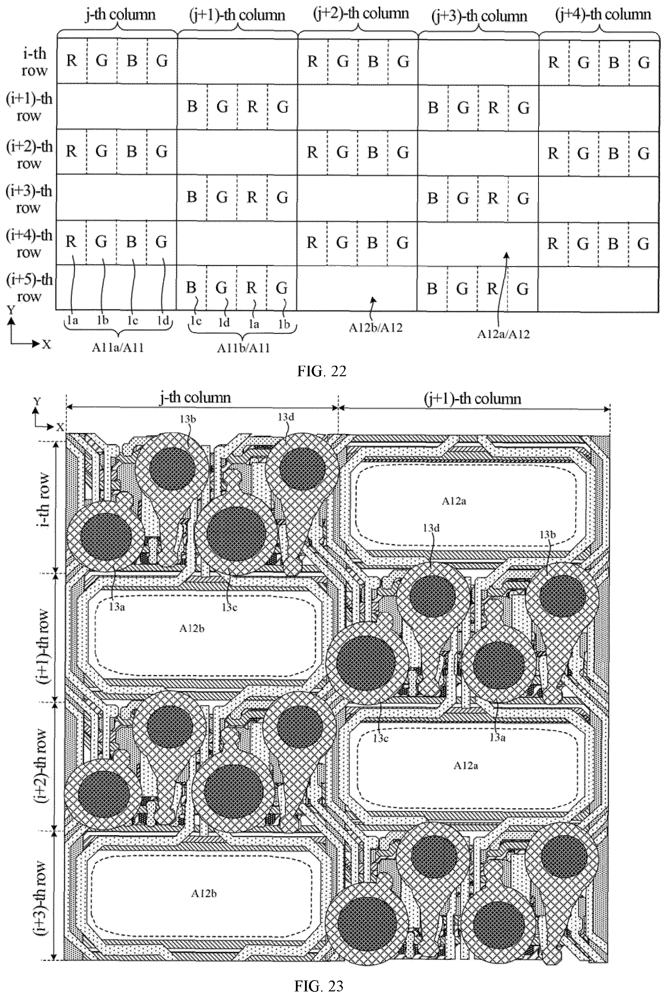

FIG. 22 is another partial schematic diagram of a first display area according to at least one embodiment of the present disclosure. FIG. 22 shows six rows (e.g., an i-th row to an (i+5)-th row) and five columns (e.g., a j-th column to a (j+4)-th column) of display island regions. In some examples, as shown in FIG. 22, the first display area A1 may include: a plurality of display island regions A11 and a plurality of light-transmitting regions A12 arranged in an array. In the first direction X, the display island regions A11 and the light-transmitting regions A12 may be arranged alternately and aligned; and in the second direction Y, the display island regions A11 and the light-transmitting regions A12 may be arranged alternately and aligned.

In some examples, as shown in FIG. 22, the plurality of display island regions A11 may include: a plurality of first display island regions A11a and a plurality of second display island regions A11b. The plurality of light-transmitting regions A12 may include: a plurality of first light-transmitting regions A12a and a plurality of second light-transmitting regions A12b. Display island regions in odd-numbered rows (e.g., an i-th row, an (i+2)-th row, and an (i+4)-th row) may include: a plurality of first display island regions A11a arranged alternately with the first light-transmitting regions A12a; and display island regions in even-numbered rows (e.g., an (i+1)-th row, an (i+3)-th row, and an (i+5)-th row) may include: a plurality of second display island regions A11b arranged alternately with the second light-transmitting regions A12b. Display island regions in odd-numbered columns (e.g., a j-th column, a (j+2)-th column, and a (j+4)-th column) may include: a plurality of first display island regions A11a arranged alternately with the second light-transmitting regions A12b; and display island regions in even-numbered columns (e.g., a (j+1)-th column and a (j+3)-th column) may include: a plurality of second display island regions A11b arranged alternately with the first light-transmitting regions A12a. The present embodiment is not limited thereto. In some other examples, display island regions in odd-numbered rows and even-numbered rows may be exchanged, and display island regions in odd-numbered columns and even-numbered columns may be exchanged.

In some examples, as shown in FIG. 22, the plurality of display island regions A11 may have substantially the same shape and size. The plurality of light-transmitting regions A12 may have substantially the same shape and size. A length of a display island region A11 in the first direction X may be greater than or equal to a length of a light-transmitting region A12 in the first direction X.

FIG. 23 is a partial top view of a first display area according to at least one embodiment of the present disclosure. FIG. 23 is a top view of four rows (e.g., an i-th row to an (i+3)-th row) and two columns (e.g., a j-th column and a (j+1)-th column) of display island regions. The structure of film layers is described below by taking the first display island region located in the i-th row and the j-th column as an example.

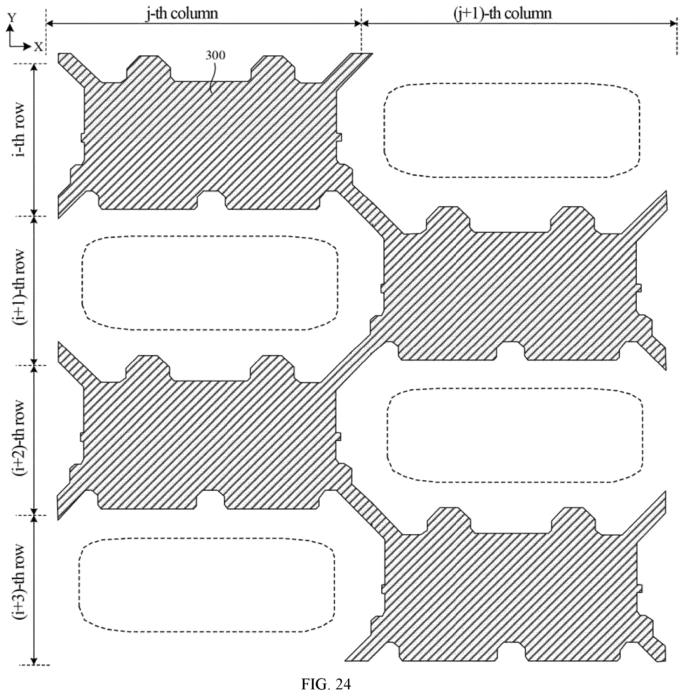

FIG. 24 is a schematic diagram of the first display area after a shielding layer is formed in FIG. 23. In some examples, as shown in FIG. 24, the shielding layer of the first display area may at least include: a shielding block 300 located in the display island region. Each display island region may be provided with one shielding block 300. The shielding block 300 may not be provided with a hollow portion. The plurality of shielding blocks 300 in the first display area may be connected to each other to form an integrated structure. In this example, arranging a light-shielding block in a display island region can provide a light-shielding effect for the transistors of the first pixel circuit in the display island region, thereby ensuring the performance of the transistors.

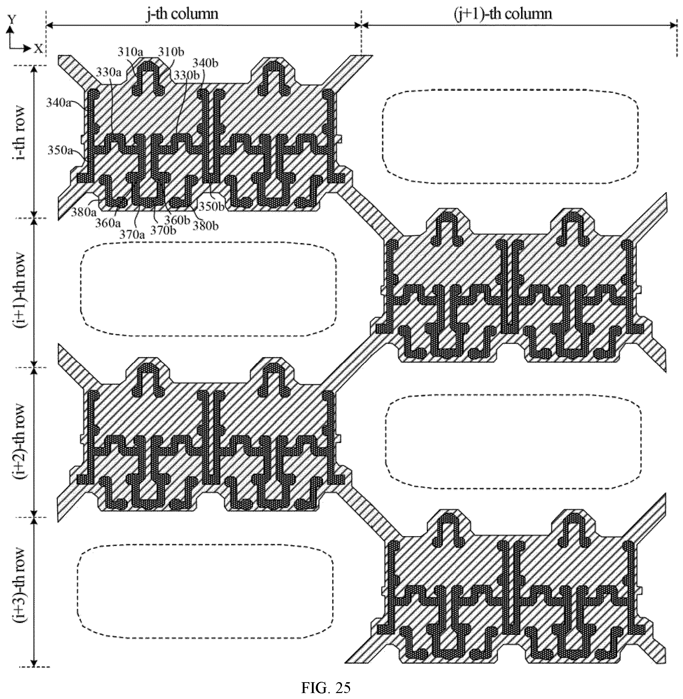

FIG. 25 is a schematic diagram of the first display area after a first semiconductor layer is formed in FIG. 23. In some examples, as shown in FIG. 25, the first semiconductor layer of the first display area may at least include: active layers of a plurality of first-type transistors of a plurality of first pixel circuits (e.g., including: a first active layer 310a of a first transistor of the first pixel circuit 11a, a third active layer 330a of a third transistor of the first pixel circuit 11a, a fourth active layer 340a of a fourth transistor of the first pixel circuit 11a, a fifth active layer 350a of a fifth transistor of the first pixel circuit 11a, a sixth active layer 360a of a sixth transistor of the first pixel circuit 11a, a seventh active layer 370a of a seventh transistor of the first pixel circuit 11a, and an eighth active layer 380a of an eighth transistor of the first pixel circuit 11a; and a first active layer 310b of a first transistor of the first pixel circuit 11b, a third active layer 330b of a third transistor of the first pixel circuit 11b, a fourth active layer 340b of a fourth transistor of the first pixel circuit 11b, a fifth active layer 350b of a fifth transistor of the first pixel circuit 11b, a sixth active layer 360b of a sixth transistor of the first pixel circuit 11b, a seventh active layer 370b of a seventh transistor of the first pixel circuit 11b, and an eighth active layer 380b of an eighth transistor of the first pixel circuit 11b). An orthographic projection of the shielding layer on the base substrate may cover an orthographic projection of the first semiconductor layer on the base substrate.

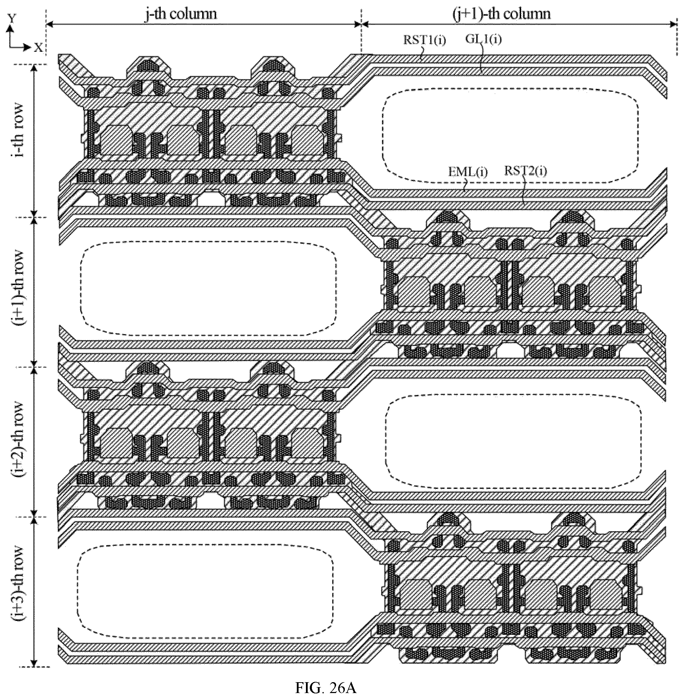

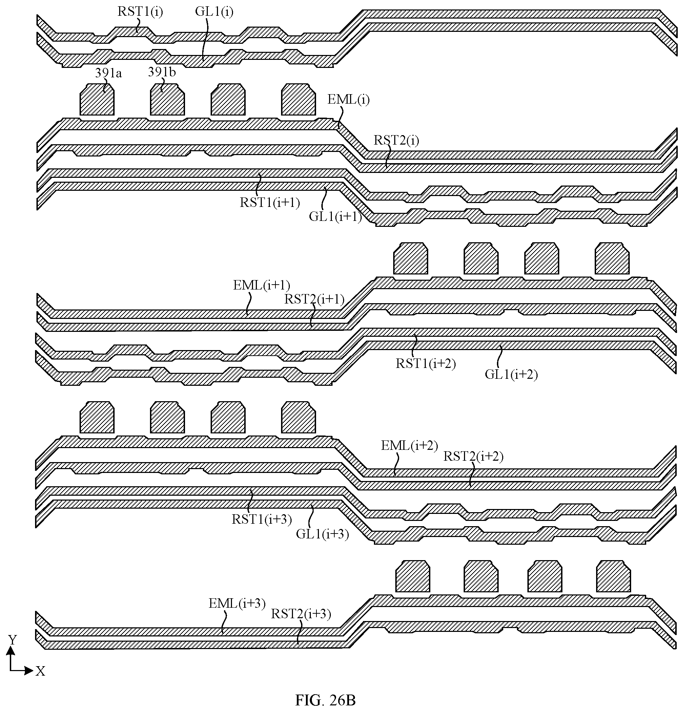

FIG. 26A is a schematic diagram of a first display area after a first conductive layer is formed in FIG. 23. FIG. 26B is a schematic diagram of the first conductive layer in FIG. 26A. In some examples, as shown in FIGS. 26A and 26B, the first conductive layer of the first display area may at least include: a plurality of first scan lines (e.g., including first scan lines GL1(i), GL1(i+1), GL1(i+2), and GL1(i+3)), a plurality of light emitting control lines (e.g., including light emitting control lines EML(i), EML(i+1), EML(i+2), and EML(i+3)), a plurality of first reset control lines (e.g., including first reset control lines RST1(i), RST1(i+1), RST1(i+2), and RST1(i+3)), a plurality of second reset control lines (e.g., including second reset control lines RST2(i), RST2(i+1), RST2(i+2), and RST2(i+3)), and first electrodes of storage capacitors of a plurality of first pixel circuits (e.g., including first electrodes 391a and 391b). The first scan line, the light emitting control line, the first reset control line, and the second reset control line may each be substantially in a shape of a bend line extending in the first direction X.

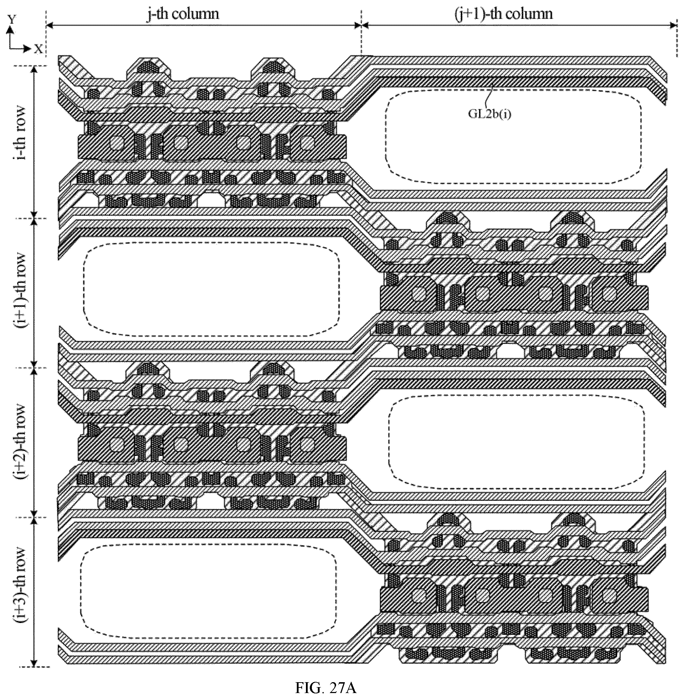

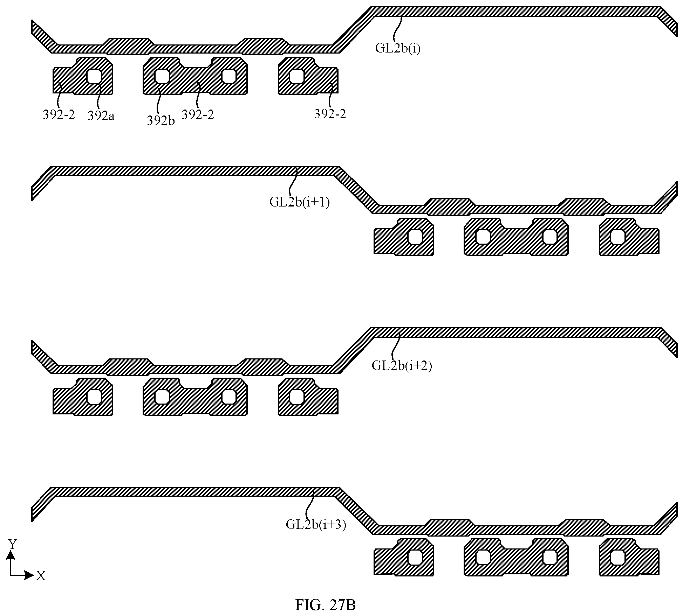

FIG. 27A is a schematic diagram of a first display area after a second conductive layer is formed in FIG. 23. FIG. 27B is a schematic diagram of the second conductive layer in FIG. 27A. In some examples, as shown in FIGS. 27A and 27B, the second conductive layer of the first display area may at least include: a plurality of second scan auxiliary lines (e.g., including second scan auxiliary lines GL2b(i), GL2b(i+1), GL2b(i+2), and GL2b(i+3)), and second electrodes of storage capacitors of a plurality of first pixel circuits (e.g., including second electrodes 392a and 392b). A shape of a second scan auxiliary line may be substantially a polyline shape extending along the first direction X. In a display island region, the second electrode 392b of the storage capacitor of the first pixel circuit 11b and the second electrode of the storage capacitor of the first pixel circuit 11c can be electrically connected through one second plate connection block 392-2, a side of the second electrode 392a of the storage capacitor of the first pixel circuit 11a away from the first pixel circuit 11b can be connected to another second plate connection block 392-a, and a side of the second electrode of the storage capacitor of the first pixel circuit 11d away from the first pixel circuit 11c can be electrically connected to another second plate connection block 392-2.

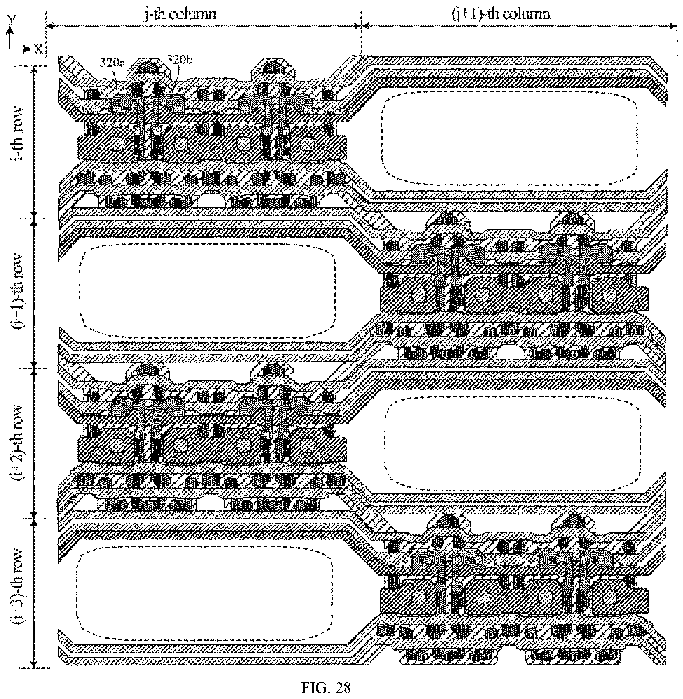

FIG. 28 is a schematic diagram of the first display area after a second semiconductor layer is formed in FIG. 23. In some examples, as shown in FIG. 28, the second semiconductor layer of the first display area may at least include: active layers of second-type transistors of a plurality of first pixel circuits (e.g., including: the second active layer 320a of the second transistor 32a of the first pixel circuit 11a, and the second active layer 320b of the second transistor 32b of the first pixel circuit 11b). In some examples, the orthographic projection of the shielding layer on the base substrate may cover an orthographic projection of the second semiconductor layer on the base substrate. The present embodiment is not limited thereto. In some other examples, the shielding block of the shielding layer may be provided with a hollow region that can cover the second semiconductor layer, to utilize the second scan auxiliary lines in the second conductive layer to shield the active layer of the second transistor.

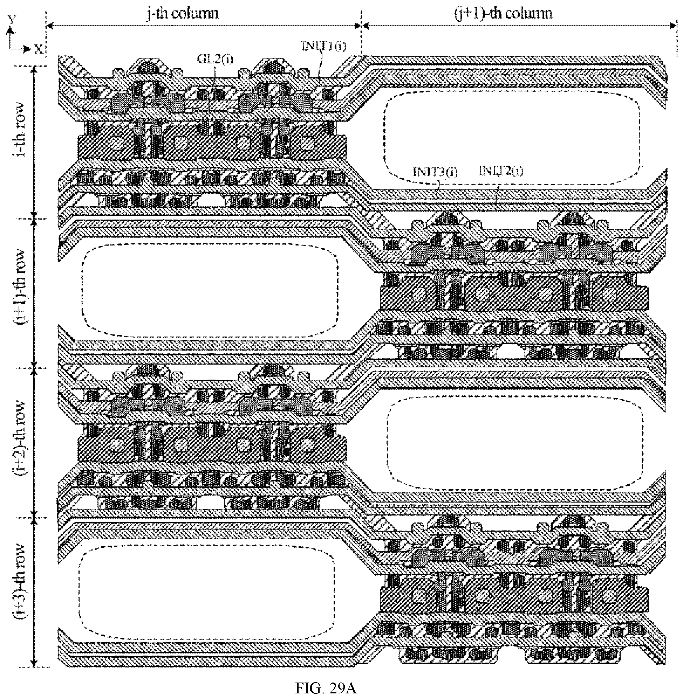

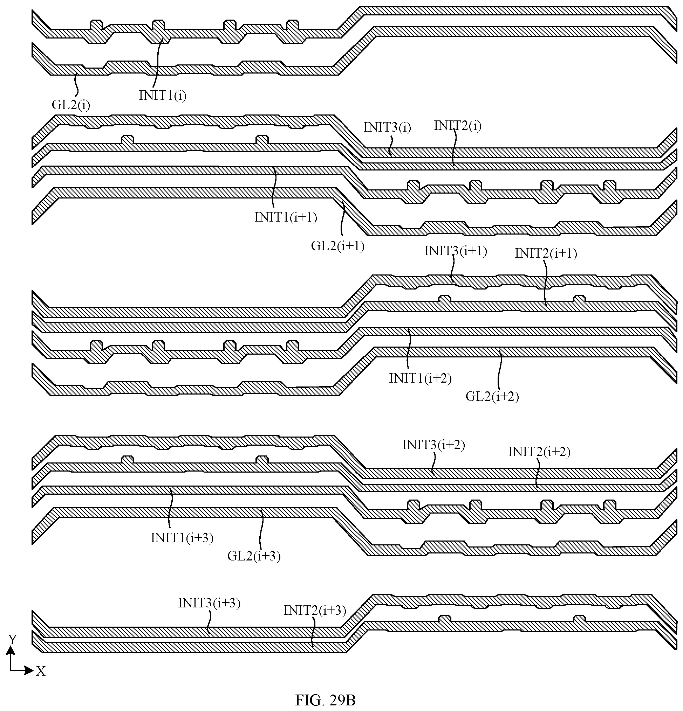

FIG. 29A is a schematic diagram of a first display area after a third conductive layer is formed in FIG. 23. FIG. 29B is a schematic diagram of the third conductive layer in FIG. 29A. In some examples, as shown in FIGS. 29A and 29B, the third conductive layer of the first display area may at least include: a plurality of second scan lines (e.g., including second scan lines GL2(i), GL2(i+1), GL2(i+2), and GL2(i+3)), a plurality of first initial signal lines (e.g., including first initial signal lines INIT1(i), INIT1(i+1), INIT1(i+2), and INIT1(i+3)), a plurality of second initial signal lines (e.g., including second initial signal lines INIT2(i), INIT2(i+1), INIT2(i+2), and INIT2(i+3)), and a plurality of third initial signal lines (e.g., including third initial signal lines INIT3(i), INIT3(i+1), INIT3(i+2), and INIT3(i+3)). Shapes of the first initial signal lines, the second scan lines, the second initial signal lines, and the third initial signal lines may each be substantially a polyline shape extending along the first direction X.

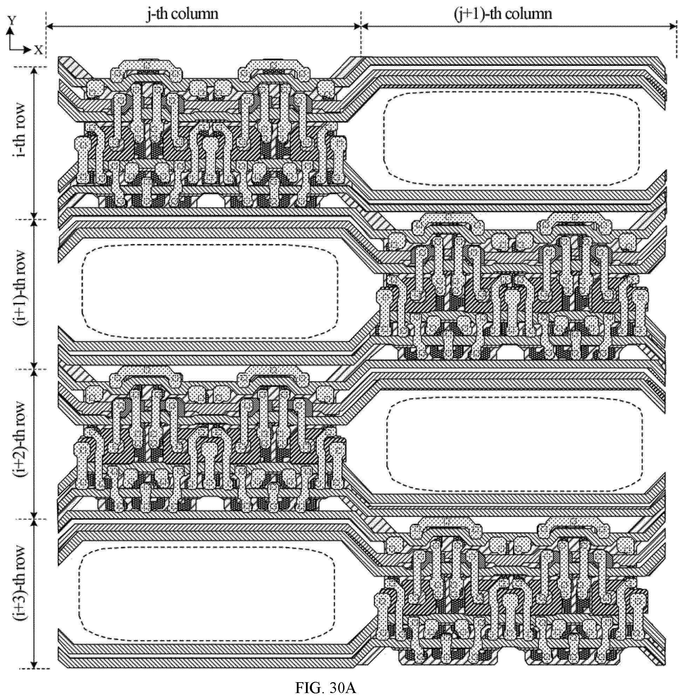

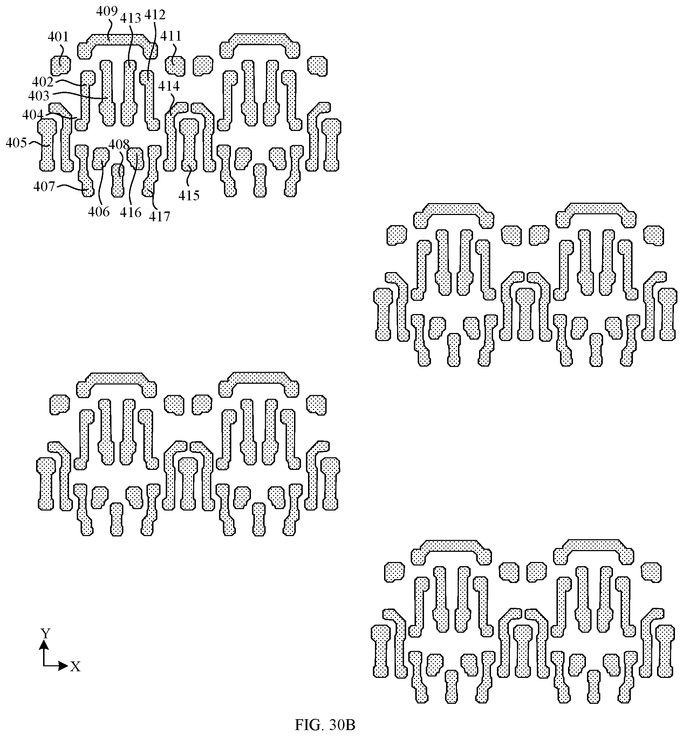

FIG. 30A is a schematic diagram of a first display area after a fourth conductive layer is formed in FIG. 23. FIG. 30B is a schematic diagram of a fourth conductive layer in FIG. 30A. In some examples, as shown in FIGS. 30A and 30B, the fourth conductive layer of the first display area may at least include: a plurality of connection electrodes (e.g., including a first connection electrode 401 to a ninth connection electrode 409, and an eleventh connection electrode 411 to a seventeenth connection electrode 417). The plurality of connection electrodes can be electrically connected to the first semiconductor layer, the first conductive layer, the second conductive layer, the second semiconductor layer, and the third conductive layer respectively through the via holes provided in the fifth insulating layer to the first insulating layer.

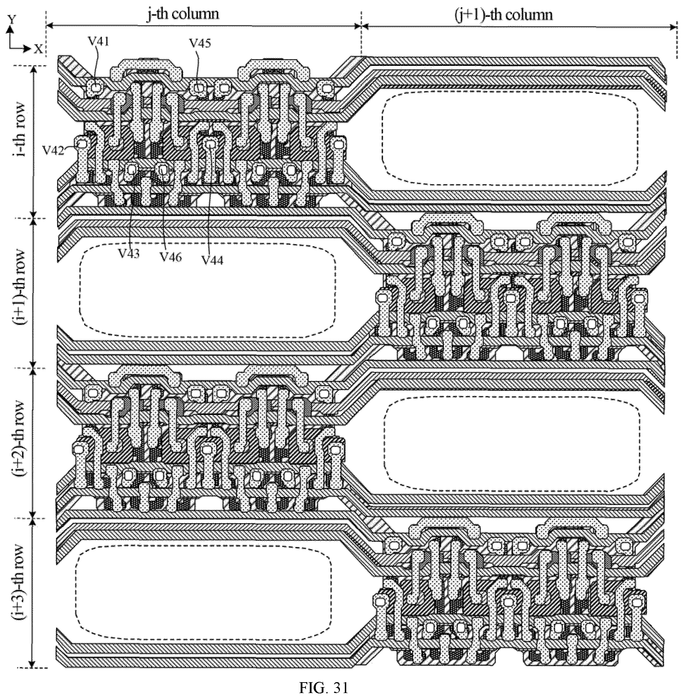

FIG. 31 is a schematic diagram of the first display area after a seventh insulating layer is formed in FIG. 23. In some examples, as shown in FIG. 31, the seventh insulating layer of the first display area may be provided with a plurality of via holes, which, for example, may include a forty-first via hole V41 to a forty-sixth via hole V46. The seventh insulating layer and the sixth insulating layer within the forty-first via hole V41 to the forty-sixth via hole V46 may be removed, exposing part of a surface of the fourth conductive layer.

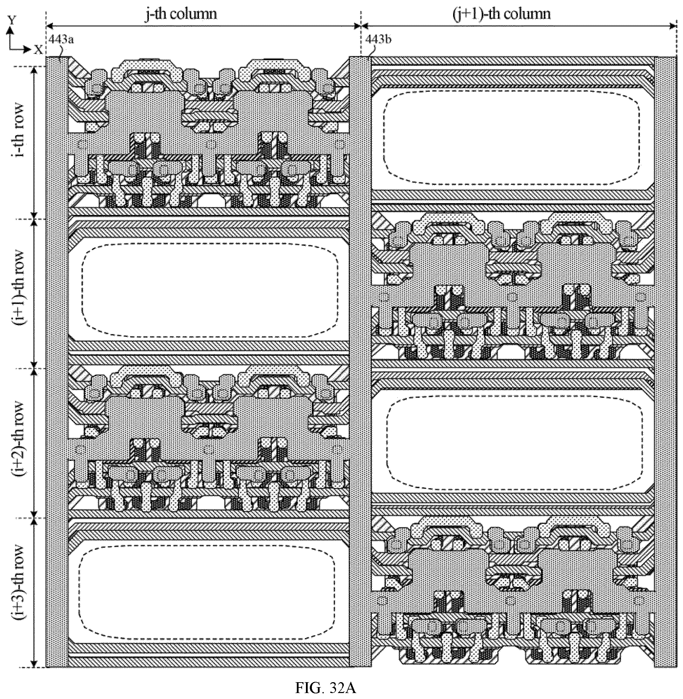

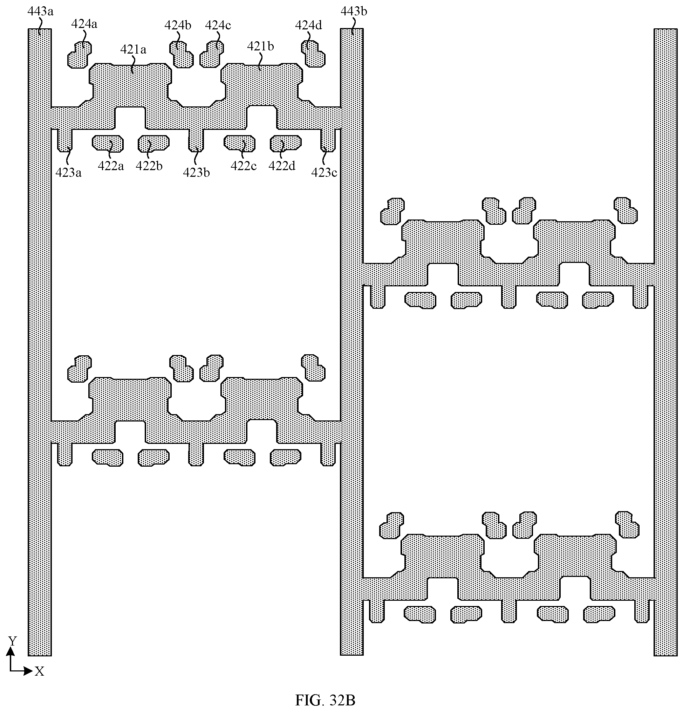

FIG. 32A is a schematic diagram of a first display area after a fifth conductive layer is formed in FIG. 23. FIG. 32B is a schematic diagram of the fifth conductive layer in FIG. 32A. In some examples, as shown in FIGS. 32A and 32B, the fifth conductive layer of the first display area may at least include: a plurality of first anode connection electrodes (e.g., first anode connection electrodes 422a, 422b, 422c, and 422d), a plurality of first power supply connection electrodes (e.g., first power supply connection electrodes 423a, 423b, and 423c), a plurality of first shielding electrodes (e.g., first shielding electrodes 421a and 421b), a plurality of first data connection electrodes (e.g., first data connection electrodes 424a, 424b, 424c, and 424d), and a plurality of third voltage transmission lines (e.g., third voltage transmission lines 443a and 443b).

In some examples, the third voltage transmission lines 443a and 443b may be straight lines extending in the second direction Y. The two first shielding electrodes 421a and 421b, the three first power supply connection electrodes 423a, 423b, and 423c, the four first anode connection electrodes 422a, 422b, 422c, and 422d, and the four first data connection electrodes 424a, 424b, 424c, and 424d may be located between the first voltage transmission lines 443a and 443b. The two first shielding electrodes 421a and 421b, and the three first power supply connection electrodes 423a, 423b, and 423c may be connected to the third voltage transmission lines 443a and 443b to form an integrated structure. In this example, the first shielding electrode and the first power supply connection electrode are connected to each other, so that the transmission of the first voltage signal in the first direction X in the display island region can be realized, and the transmission of the first voltage signal in the second direction Y in the display island region can be realized by using the third voltage transmission lines, thereby forming a mesh structure for transmitting the first voltage signal in the first display area, which can ensure transmission uniformity of the first voltage signal.

In some examples, the first power supply connection electrode 423a may be electrically connected to the fifth connection electrode 405 through the forty-second via hole V42 to realize electrical connection to the storage capacitor and the fifth transistor of the first pixel circuit 11a; the first power supply connection electrode 423b may be electrically connected to the fifteenth connection electrode through the forty-fourth via hole V44 to realize electrical connection to the storage capacitors and the fifth transistors of the first pixel circuits 11b and 11c; and the first power supply connection electrode 423c may be electrically connected to the storage capacitor and the fifth transistor of the first pixel circuit 11d.

In some examples, the first data connection electrodes 424a, 424b, 424c, and 424d may be substantially in a shape of 8. The first data connection electrode 424a may be electrically connected to the first connection electrode 401 through the forty-first via hole V41 to realize electrical connection to the fourth transistor of the first pixel circuit 11a. The first data connection electrode 424b may be electrically connected to the eleventh connection electrode 411 through the forty-fifth via hole V45 to realize electrical connection to the fourth transistor of the first pixel circuit 11b. The first data connection electrode 424c may be electrically connected to the fourth transistor of the first pixel circuit 11c. The first data connection electrode 424d may be electrically connected to the fourth transistor of the first pixel circuit 11d.

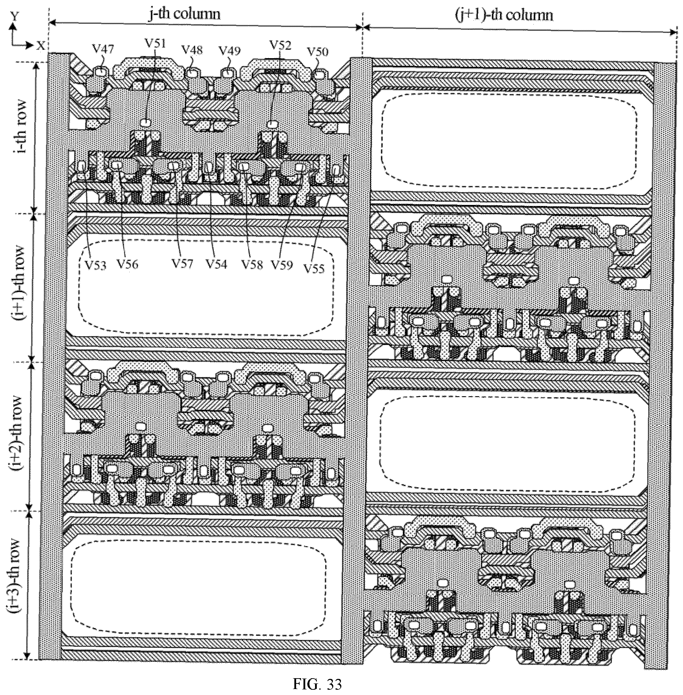

FIG. 33 is a schematic diagram of the first display area after an eighth insulating layer is formed in FIG. 23. In some examples, as shown in FIG. 33, the eighth insulating layer of the first display area may be provided with a plurality of via holes, which, for example, may include a forty-seventh via hole V47 to a fifty-ninth via hole V59. The eighth insulating layer within the forty-seventh via hole V47 to the fifty-ninth via hole V59 may be removed, exposing part of a surface of the fifth conductive layer.

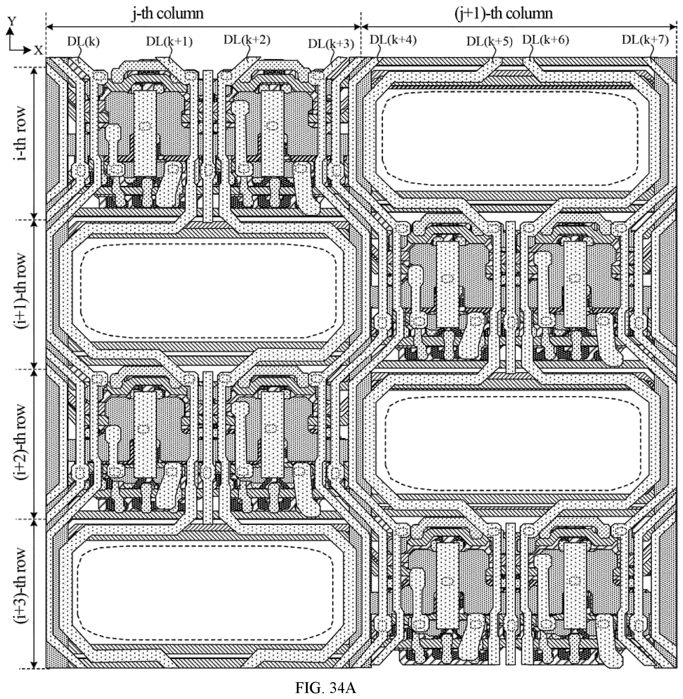

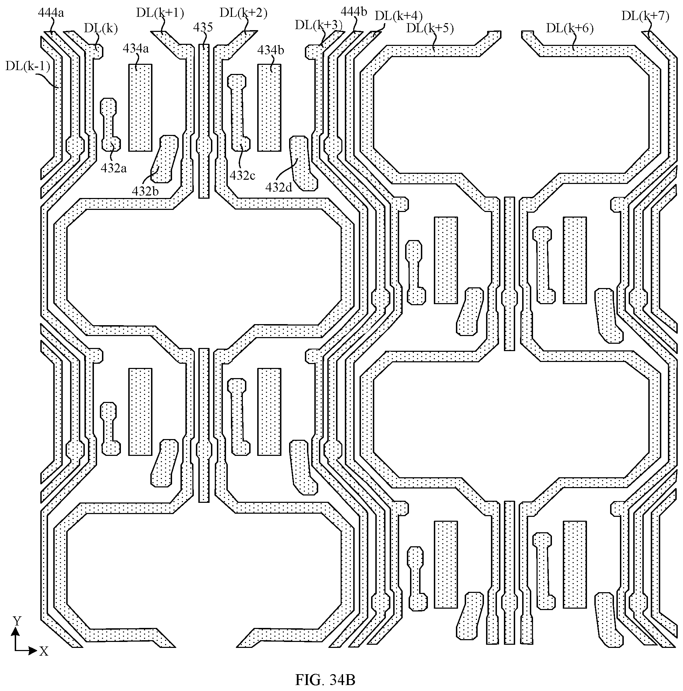

FIG. 34A is a schematic diagram of a first display area after a sixth conductive layer is formed in FIG. 23. FIG. 34B is a schematic diagram of the sixth conductive layer in FIG. 34A. In some examples, as shown in FIGS. 34A and 34B, the sixth conductive layer of the first display area may at least include: a plurality of data lines (e.g., data lines DL(k-1) to DL(k+7)), a plurality of second anode connection electrodes (e.g., second anode connection electrodes 432a, 432b, 432c, and 432d), a plurality of fourth voltage transmission lines (e.g., fourth voltage transmission lines 444a and 444b), a plurality of first auxiliary electrodes (e.g., first auxiliary electrodes 434a and 434b), and a plurality of second auxiliary electrodes 435.

In some examples, the plurality of data lines may be substantially in a shape of a bend line extending in the second direction Y. The data line DL(k) may be electrically connected to the first data connection electrode 424a through the forty-seventh via hole V47 to realize electrical connection to a first first pixel circuit. The data line DL(k+1) may be electrically connected to the first data connection electrode 424b through the forty-eighth via hole V48 to realize electrical connection to a second first pixel circuit. The data line DL(k+2) may be electrically connected to the first data connection electrode 424c through the forty-ninth via hole V48 to realize electrical connection to a third first pixel circuit. The data line DL(k+3) may be electrically connected to the first data connection electrode 424d through the fiftieth via hole V50 to realize electrical connection to a fourth first pixel circuit.

In some examples, the fourth voltage transmission lines 444a and 444b may be substantially in a shape of a bend line extending in the second direction Y. The fourth voltage transmission line 444a may be located between the data lines DL(k-1) and DL(k), and the fourth voltage transmission line 444b may be located between the data lines DL(k+3) and DL(k+4). The fourth voltage transmission line 444a may be electrically connected to the first power supply connection electrode 423a through the fifty-third via hole V53. The fourth voltage transmission line 444b may be electrically connected to the first power supply connection electrode 423c through the fifty-fifth via hole V55.

In some examples, the first auxiliary electrode 434a may be located between the data line DL(k) and the data line DL(k+1), and the first auxiliary electrode 434b may be located between the data line DL(k+2) and the data line DL(k+3). The first auxiliary electrodes 434a and 434b may be substantially in a shape of a strip-like structure extending in the second direction Y. The first auxiliary electrode 434a may be electrically connected to the first shielding electrode 421a through the fifty-first via hole V51, and the first auxiliary electrode 434b may be electrically connected to the first shielding electrode 421b through the fifty-second via hole V52.

In some examples, the second auxiliary electrode 435 may be located between the data line DL(k+1) and the data line DL(k+2). The second auxiliary electrode 435 may be substantially in a shape of a strip-like structure extending in the second direction Y. A length of the second auxiliary electrode 435 in the first direction X may be smaller than a length of the first auxiliary electrode 434a in the first direction X. The first auxiliary electrodes 434a and 434b may be substantially symmetrical with respect to the second auxiliary electrode 435. The second auxiliary electrode 435 may be electrically connected to the first power supply connection electrode 423b through the fifty-fourth via hole V54.

In this example, the first auxiliary electrode, the second auxiliary electrode, and the fourth voltage transmission line are arranged to be electrically connected to the mesh structure for transmitting the first voltage signal located in the fifth conductive layer, which can be conducive to reducing the wiring resistance for transmitting the first voltage signal, helping to improve the transmission uniformity of the first voltage signal. In this example, the fifth conductive layer and the sixth conductive layer are provided to arrange the voltage transmission lines and the data lines, which can avoid arranging many wires on the conductive layers close to the anode layer to affect the flatness of the anode layer.

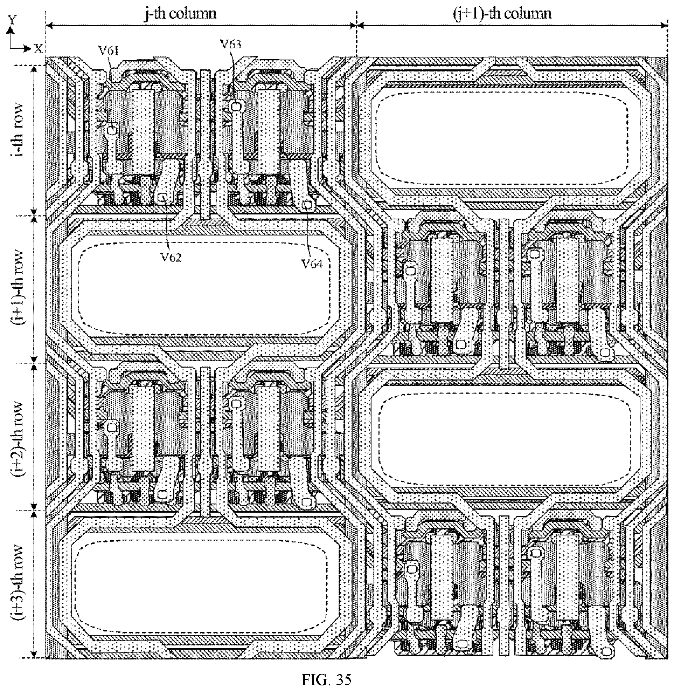

FIG. 35 is a schematic diagram of the first display area after a ninth insulating layer is formed in FIG. 23. In some examples, as shown in FIG. 35, the ninth insulating layer of the first display area may be provided with a plurality of via holes, which, for example, may include a sixty-first via hole V61 to a sixty-fourth via hole V64. The ninth insulating layer within the sixty-first via hole V61 to the sixty-fourth via hole V64 may be removed, exposing part of a surface of the sixth conductive layer.

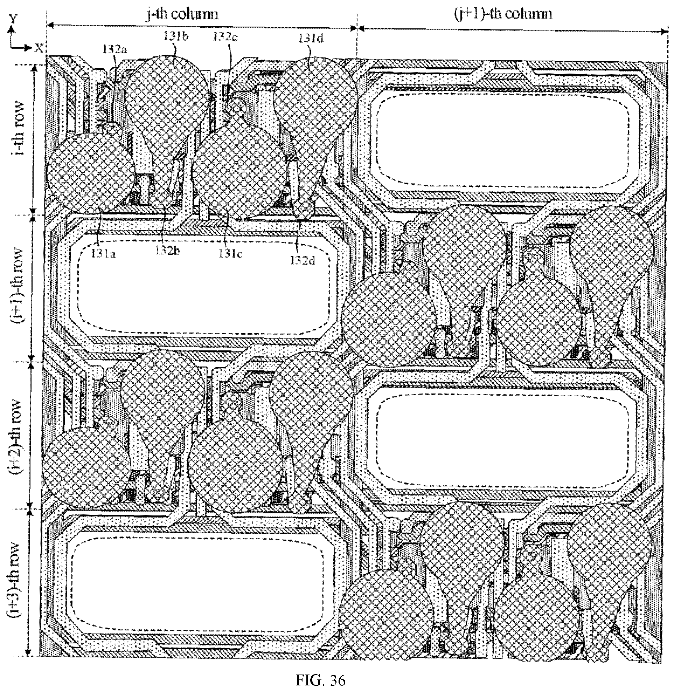

FIG. 36 is a schematic diagram of the first display area after an anode layer is formed in FIG. 23. In some examples, as shown in FIG. 36, the anode layer of the first display area may at least include: anodes of a plurality of first light emitting elements (e.g., including an anode 131a of the first light emitting element 13a, an anode 131b of the first light emitting element 13b, an anode 131c of the first light emitting element 13c, and an anode 131d of the first light emitting element 13d), and a plurality of third anode connection electrodes (e.g., including third anode connection electrodes 132a, 132b, 132c, and 132d). As to the remaining structures of the circuit structure layer and the light emitting structure layer in this example, reference may be made to the description of the foregoing embodiments, so they will not be described here in detail.

In the display substrate in this example, compared with the second display area, in the first display area, in odd-numbered rows, with RGBG as a repeating unit, RGBG units of even-numbered columns are deleted at intervals; and in even-numbered rows, with BGRG as a repeating units, BGRG units of odd-numbered columns are deleted at intervals. In this example, in the first display area, the deleted first sub-pixels account for one-half of the total first sub-pixels, and light-transmitting regions are formed at positions where the first sub-pixels are deleted. The wiring between adjacent display island regions may be connected directly by metal wires, and the light-transmitting regions are avoided. This example can improve the light transmittance of the first display area, while ensuring the light emitting white balance of the first display area, so as to satisfy the requirements of the under-screen function for size and light transmittance. For example, taking the case where the pixel density of the second display area is 426 as an example, in the first display area, by deleting the first sub-pixels, the pixel density may be reduced to 302, so that an aperture ratio of 31.62% is achieved in the light-transmitting regions. The aperture ratio of the light-transmitting regions refers to the ratio of the area of the light-transmitting regions in the first display area to the total area of the first display area. This example may achieve a light transmittance of 16.2% for 550nm light, and 19.1% for 940nm light, which can meet the needs of under-screen camera or under-screen face recognition.

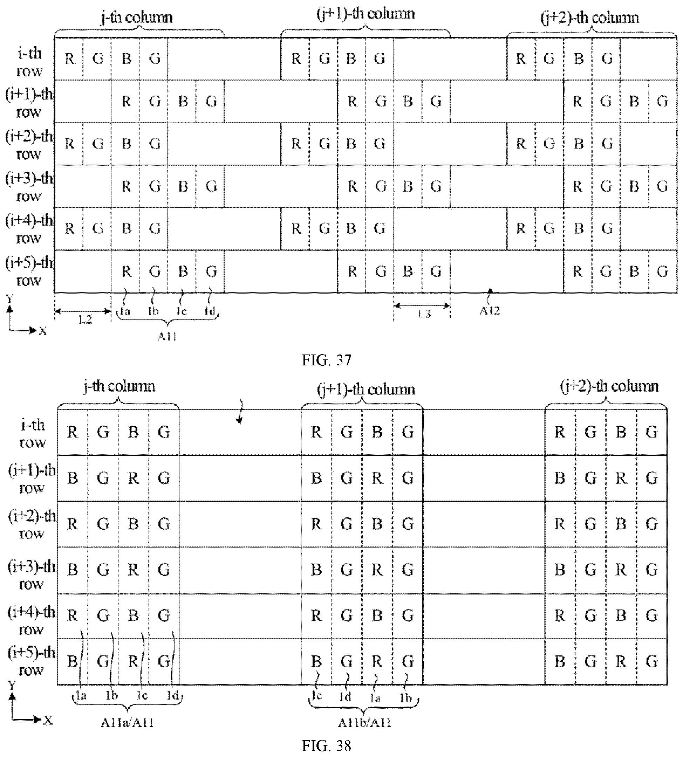

FIG. 37 is another partial schematic diagram of a first display area according to at least one embodiment of the present disclosure. FIG. 37 shows six rows (e.g., an i-th row to an (i+5)-th row) and three columns (e.g., a j-th column to a (j+2)-th column) of display island regions. In some examples, as shown in FIG. 37, the first display area A1 may include: a plurality of display island regions A11 and a plurality of light-transmitting regions A12 arranged in an array. The display island regions A11 and the light-transmitting regions A12 are arranged alternately in the first direction X, and the plurality of display island regions A11 may be arranged continuously in a staggered manner in the second direction Y. An arrangement order of the first light emitting elements is the same in the plurality of display island regions A11. For a column of display island regions, display island regions A11 in odd-numbered rows (e.g., an i-th row, an (i+2)-th row, and an (i+4)-th row) are aligned, display island regions A11 in even-numbered rows (e.g., an (i+1)-th row, an (i+3)-th row, and an (i+5)-th row) are aligned, and adjacent display island regions A11 in a column of display island regions may be arranged in a staggered manner.

In some examples, each display island region A11 may include four first sub-pixels, i.e., including four first pixel circuits and four first light emitting elements which are electrically connected correspondingly. A misalignment distance in the first direction X between adjacent display island regions in a column of display island regions may be greater than or equal to a length of one first pixel circuit in the first direction X and smaller than or equal to lengths of three first pixel circuits in the first direction X. For example, the misalignment distance L2 in the first direction X between adjacent display island regions in a column of display island regions may be approximately equal to the lengths of two first pixel circuits in the first direction X.

In some examples, adjacent light-transmitting regions A12 in the second direction Y may be arranged in a staggered manner in the first direction X. The misalignment distance L3 in the first direction X of the light-transmitting regions A12 adjacent in the second direction X may be substantially the same as the misalignment distance L2, for example, may be equal to the lengths of two first pixel circuits in the first direction X. However, the present embodiment is not limited thereto.

In the display substrate in this example, compared with the second display area, in the first display area, in each row, with RGBG as a repeating unit, RGBG units are deleted at intervals, and repeating units in adjacent rows are arranged in a staggered manner. In this example, in the first display area, the deleted first sub-pixels account for one-half of the total first sub-pixels, and light-transmitting regions are formed at positions where the first sub-pixels are deleted. This example can improve the light transmittance of the first display area, while ensuring the light emitting white balance of the first display area, so as to satisfy the requirements of the under-screen function for size and light transmittance. Rest of description of the display substrate of the example may be referred to description of the aforementioned embodiments, and thus will not be repeated here.

FIG. 38 is another partial schematic diagram of a first display area according to at least one embodiment of the present disclosure. FIG. 38 show six rows (e.g., an i-th row to an (i+5)-th row) and three columns (e.g., a j-th column to a (j+2)-th column) of display island regions. In some examples, as shown in FIG. 38, the first display area A1 may include: a plurality of display island regions A11 and a plurality of light-transmitting regions A12 arranged in an array. The display island regions A11 and the light-transmitting regions A12 are arranged alternately in the first direction X, and the plurality of display island regions A11 are arranged continuously in the second direction Y. A plurality of display island regions A11 within each column of display island regions A11 are aligned. Adjacent light-transmitting regions A12 in the second direction Y may be spaced by transverse metal wires.

In some examples, as shown in FIG. 38, the plurality of display island regions A11 may include a plurality of first display island regions A11a and a plurality of second display island regions A11b. In each column of displays island areas, the first display island regions A11a and the second display island regions A11b may be alternately arranged.

In the display substrate of this example, compared with the second display area, in the first display area, in odd-numbered rows, with RGBG as a repeating unit, RGBG units are deleted at intervals, in even-numbered rows, with BGRG as a repeating unit, BGRG units are deleted at intervals, the first sub-pixels deleted in the first display area account for one-half of the total first sub-pixels, and light-transmitting regions are formed at positions where the first sub-pixels are deleted, thereby improving the light transmittance of the first display area, while ensuring the light emitting white balance of the first display area, so as to satisfy the requirements of the under-screen function for size and light transmittance. Rest of description of the display substrate of the example may be referred to description of the aforementioned embodiments, and thus will not be repeated here.

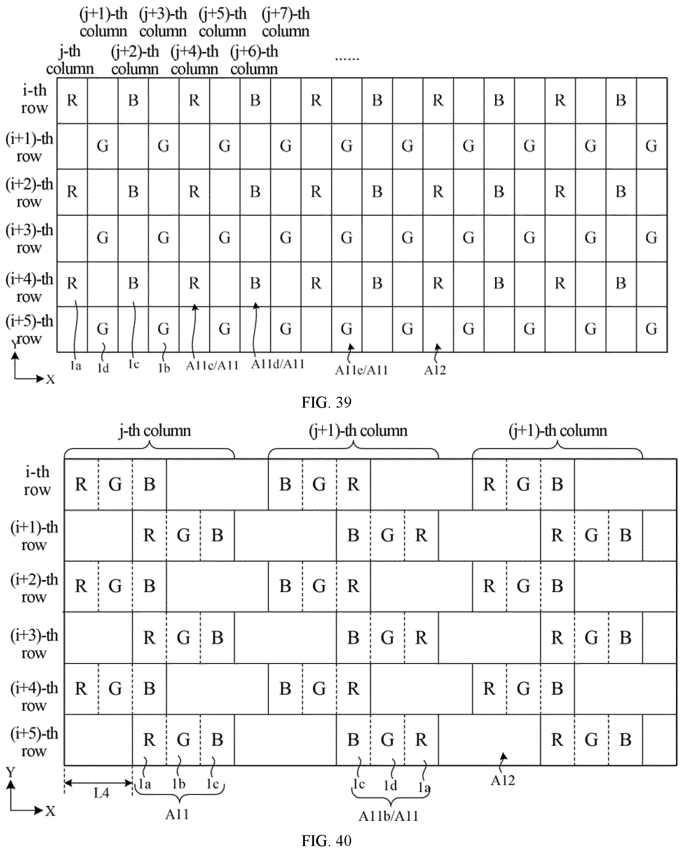

FIG. 39 is another partial schematic diagram of a first display area according to at least one embodiment of the present disclosure. FIG. 38 shows six rows (e.g., an i-th row to an (i+5)-th row) and multiple columns of display island regions. In some examples, as shown in FIG. 38, the first display area A1 may include: a plurality of display island regions A11 and a plurality of light-transmitting regions A12 arranged in an array. In the first direction X, the display island regions A11 and the light-transmitting regions A12 are arranged alternately and aligned, and in the second direction Y, the display island regions A11 and the light-transmitting regions A12 are arranged alternately and aligned.

In some examples, each display island region A11 may include one first sub-pixel, for example, including one first pixel circuit and one first light emitting element. The plurality of display island regions A11 may include: a plurality of third display island regions A11c, a plurality of fourth display island regions A11d, and a plurality of fifth display island regions A11e. The first sub-pixels in the third display island regions A11c, the fourth display island regions A11d, and the fifth display island regions A11e may emit light of different colors. For example, a third display island region A11e may include one first sub-pixel 1a emitting light of a first color, a fourth display island region A11d may include one first sub-pixel 1c emitting light of a second color, and a fifth display island region A11e may include one first sub-pixel 1b or 1d emitting light of a third color.

In some examples, in display island regions in odd-numbered rows (e.g., an i-th row, an (i+2)-th row, and an (i+4)-th row), the third display island regions A11c and the fourth display island regions A11d may be arranged alternately. A plurality of fifth display island regions A11e may be arranged in display island regions in even-numbered rows (e.g., an (i+1)-th row, an (i+3)-th row, and an (i+5)-th row). A column of display island regions may include: a plurality of third display island regions A11c, or a plurality of fourth display island regions A11d, or a plurality of fifth display island regions A11e. For example, a j-th column of display island regions include third display island regions A11c arranged alternately with the light-transmitting regions A12, a (j+1)-th column of display island regions include fifth display island regions A11e arranged alternately with the light-transmitting regions A12, a (j+2)-th column of display island regions include fourth display island regions A11d arranged alternately with the light-transmitting regions A12, and a (j+3)-th column of display island regions include fifth display island regions A11e arranged alternately with the light-transmitting regions A12. The multiple columns of display island regions are periodically arranged in an order of a column of third display island regions, a column of fifth display island regions, a column of fourth display island regions, and a column of fifth display island regions.

In the display substrate of this example, compared with the second display area, in the first display area, in odd-numbered rows, with R and B as a repeating unit, G units are deleted at intervals, in even-numbered rows, with G as a repeating unit, R and B units are deleted at intervals, the first sub-pixels deleted in the first display area account for one-half of the total first sub-pixels, and light-transmitting regions are formed at positions where the first sub-pixels are deleted, thereby improving the light transmittance of the first display area, while ensuring the light emitting white balance of the first display area, so as to satisfy the requirements of the under-screen function for size and light transmittance. Rest of description of the display substrate of the example may be referred to description of the aforementioned embodiments, and thus will not be repeated here.

FIG. 40 is another partial schematic diagram of a first display area according to at least one embodiment of the present disclosure. FIG. 40 shows six rows (e.g., an i-th row to an (i+5)-th row) and three columns (e.g., a j-th column to a (j+2)-th column) of display island regions. In some examples, as shown in FIG. 40, the first display area A1 may include: a plurality of display island regions A11 and a plurality of light-transmitting regions A12 arranged in an array. The display island regions A11 and the light-transmitting regions A12 are arranged alternately in the first direction X, and the plurality of display island regions A11 may be arranged continuously in the second direction Y. For a column of display island regions, display island regions A11 in odd-numbered rows (e.g., an i-th row, an (i+2)-th row, and an (i+4)-th row) are aligned, display island regions A11 in even-numbered rows (e.g., an (i+1)-th row, an (i+3)-th row, and an (i+5)-th row) are aligned, and adjacent display island regions A11 in a column of display island regions may be arranged in a staggered manner.

In some examples, the plurality of display island regions A11 may include a plurality of first display island regions A11a and a plurality of second display island regions A11b. In the first direction X, the first display island regions A11a, the light-transmitting regions A12, the second display island regions A11b, and the light-transmitting regions A12 may be periodically arranged in this order. In each row of display island regions, the first display island regions A11a and the second display island regions A11b may be arranged alternately, and a light-transmitting region A12 is arranged between adjacent display island regions. The display island regions in odd-numbered columns (e.g., a j-th column and a (j+2)-th column) may include a plurality of first display island regions A11a sequentially arranged in the second direction Y, and the display island regions in even-numbered columns (e.g., a (j+1)-th column) may include a plurality of second display island regions A11b sequentially arranged in the second direction Y.

In some examples, each display island region A11 may include three first sub-pixels, i.e., including three first pixel circuits and three first light emitting elements which are electrically connected correspondingly. A first display island region A11a may include: a first sub-pixel 1a emitting light of a first color, a first sub-pixel 1b emitting light of a third color, and a first sub-pixel 1c emitting light of a second color, which are sequentially arranged in the first direction X. A second display island region A11b may include: a first sub-pixel 1c emitting light of the second color, a first sub-pixel 1d emitting light of the third color, and a first sub-pixel 1a emitting light of the first color, which are sequentially arranged in the first direction X. A first display island region A11a and a second display island region A12 have different arrangement orders of first sub-pixels.

In some examples, a misalignment distance in the first direction X between adjacent display island regions in a column of display island regions may be greater than or equal to a length of one first pixel circuit in the first direction X and smaller than or equal to lengths of three first pixel circuits in the first direction X. For example, the misalignment distance L4 in the first direction X between adjacent display island regions in a column of display island regions may be approximately equal to the lengths of two first pixel circuits in the first direction X.

In the display substrate of this example, compared with the second display area, in the first display area, the display island regions in the odd-numbered columns take RGB as a repeating unit, the display island regions in the even-numbered columns take BGR as a repeating unit, GRG units or GBG units between adjacent columns are deleted at intervals, and light-transmitting regions are formed at positions where the first sub-pixels are deleted, thereby improving the light transmittance of the first display area, while meeting display white balance. Rest of description of the display substrate of the example may be referred to description of the aforementioned embodiments, and thus will not be repeated here.

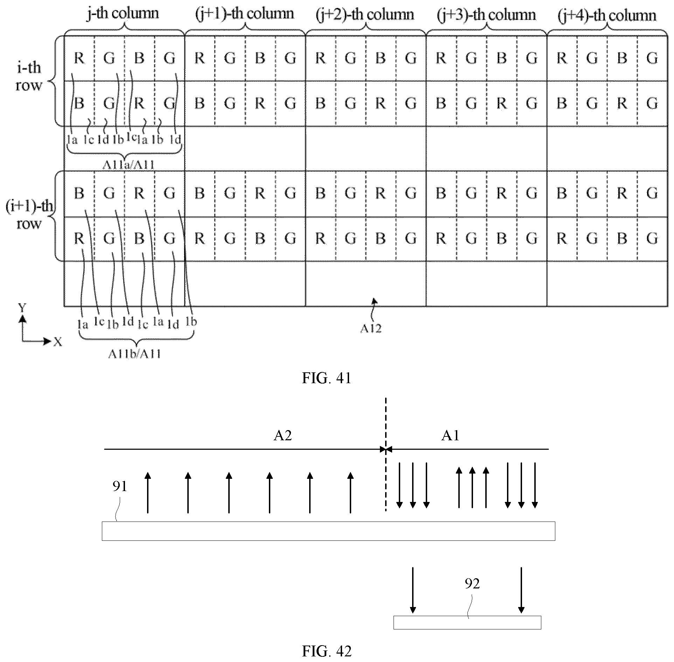

FIG. 41 is another partial schematic diagram of a first display area according to at least one embodiment of the present disclosure. FIG. 41 shows two rows (e.g., an i-th row to an (i+1)-th row) and five columns (e.g., a j-th column to a (j+4)-th column) of display island regions. In some examples, as shown in FIG. 41, the first display area A1 may include: a plurality of display island regions A11 and a plurality of light-transmitting regions A12 arranged in an array. The display island regions A11 and the light-transmitting regions A12 are arranged alternately in the second direction Y, and a plurality of display island regions A11 may be arranged continuously and aligned in the first direction X. Adjacent light-transmitting regions A12 in the first direction X may be spaced by longitudinal metal wires.

In some examples, as shown in FIG. 41, the plurality of display island regions A11 may include a plurality of first display island regions A11a and a plurality of second display island regions A11b. An i-th row may include a plurality of first display island regions A11a, and an (i+1)-th row may include a plurality of second display island regions A11b. A first display island region A11a may include eight first sub-pixels, a second display island region A11b may include eight first sub-pixels, and an arrangement order of the first sub-pixels in the first display island region A11a may be different from an arrangement order of the first sub-pixels in the second display island region A11b. For example, in the first display island region A11a, the first sub-pixels 1a, 1b, 1c, and 1d may be arranged in a first row, and the first sub-pixels 1c, 1d, 1a, and 1b may be arranged in a second row; and in the second display island region A11b, the first sub-pixels 1c, 1d, 1a, and 1b may be arranged in a first row, and the first sub-pixels 1a, 1b, 1c, and 1d may be arranged in a second row.

In the display substrate of this example, compared with the second display area, in the first display area, RGRB repeating units are deleted in alternate rows, and light-transmitting regions are formed at positions where the first sub-pixels are deleted, thereby improving the light transmittance of the first display area, while ensuring the light emitting white balance of the first display area, so as to satisfy the requirements of the under-screen function for size and light transmittance. Rest of description of the display substrate of the example may be referred to description of the aforementioned embodiments, and thus will not be repeated here.

An embodiment further provides a display substrate, including: a first display area, and a second display area located on at least one side of the first display area, a light transmittance of the first display area being greater than that of the second display area. The first display area includes: a plurality of display island regions and a plurality of light-transmitting regions arranged in an array; in a row direction, the display island regions and the light-transmitting regions are arranged alternately, or in a column direction, the display island regions and the light-transmitting regions are arranged alternately. A display island region at least includes: n first pixel circuits arranged in the row direction, n being a positive integer greater than 0; first pixel circuits in adjacent display island regions in the column direction are arranged in a staggered manner, and a misalignment distance in the row direction between adjacent display island regions is greater than or equal to a length of one first pixel circuit in the row direction and smaller than or equal to lengths of n first pixel circuits in the row direction. In some examples, n may be 1, or n may be 3, or n may be 4.

In the display substrate provided by this embodiment, a pixel circuit built-in method is employed, and display island regions and light-transmitting regions are arranged alternately in the row direction or the column direction within the first display area, so that the light transmittance of the first display area can be improved, and with the display white balance being met, the under-screen functional requirements can be satisfied, for example, an aperture of the first display area can be expanded, and functional requirements such as under-screen camera or under-screen face recognition can be satisfied synchronously.

In some exemplary implementations, in the column direction, a light-transmitting region is aligned with a half of an adjacent display island region. For this example, reference may be made to the description of the embodiment shown in FIG. 5 above.

In some examples, each display island region may also include: n first light emitting elements electrically connected to n first pixel circuits in one-to-one correspondence. The plurality of display island regions include: a plurality of first display island regions and a plurality of second display island regions; display island regions in odd-numbered columns include: a plurality of first display island regions arranged sequentially in the column direction, and display island regions in even-numbered columns include: a plurality of second display island regions arranged sequentially in the column direction; and an arrangement order of the n first light emitting elements included in the first display island region is different from an arrangement order of the n first light emitting elements included in the second display island region. Regarding the display substrate of this example, reference may be made to the description of the foregoing embodiments, so no further description is made here.

FIG. 42 is a schematic diagram of a display device according to at least one embodiment of the present disclosure. As shown in FIG. 42, an embodiment provides a display device, which includes a display substrate 91 and a sensor 92 located on a light exit side of a light emitting structure layer away from the display substrate 91. The sensor 92 may be located on a side of a non-display surface of the display substrate 91. An orthographic projection of the sensor 92 on the display substrate 91 may be overlapped with a first display area A1.

In some examples, the display substrate 91 may be a flexible OLED display substrate, a QLED display substrate, a Micro-LED display substrate, or a Mini-LED display substrate. The display device may be a product having an image (including a still image or a moving image, wherein the moving image may be a video) display function. For example, the display device may be: displays, televisions, billboards, digital photo frames, laser printers with display function, telephones, mobile phones, picture screens, personal digital assistants (PDA), digital cameras, portable camcorders, viewfinders, navigators, vehicles, large-area walls, information inquiry equipment (such as business inquiry equipment in e-government, banks, hospitals, power departments, etc.), monitors, etc. As another example, the display device may be any one of a micro-display, a VR device including a micro-display, or an AR device.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. It should be noted that the above examples or embodiments are exemplary only and not restrictive. Therefore, the present disclosure is not limited to what is specifically shown and described herein. Various modifications, substitutions or omissions may be made in forms and details of implementation modes without departing from the scope of the present disclosure.

**Claims**

1. A display substrate, comprising: a first display area, the first display area comprising: a plurality of display island regions and a plurality of light-transmitting regions arranged in an array; wherein the first display area satisfies at least one of: the display island regions and the light-transmitting regions are arranged alternately in a row direction, and the display island regions and the light-transmitting regions are arranged alternately in a column direction; a display island region comprises: at least one first pixel circuit and at least one first light emitting element, wherein the at least one first pixel circuit is electrically connected to the at least one first light emitting element and configured to drive the at least one first light emitting element to emit light.

2. The display substrate according to claim 1, wherein in the row direction, the display island regions and the light-transmitting regions are arranged alternately and aligned; and in the column direction, the plurality of display island regions are arranged continuously in a staggered manner, or the plurality of display island regions are arranged continuously and aligned, or the display island regions and the light-transmitting regions are arranged alternately and aligned.

3. The display substrate according to claim 2, wherein for a column of display island regions, display island regions in odd-numbered rows are aligned, and display island regions in even-numbered rows are aligned; and adjacent display island regions in a column of display island regions are arranged in a staggered manner.

4. The display substrate according to claim 3, wherein one of the display island regions comprises: a first pixel circuits arranged sequentially in the row direction, and a is an integer greater than 1; a misalignment distance in the row direction between adjacent display island regions in the column of display island regions is greater than or equal to a length of one first pixel circuit in the row direction and smaller than or equal to lengths of a-1 first pixel circuits in the row direction.

5. The display substrate according to claim 3, wherein each display island region in a j-th column has a first edge close to a (j-1)-th column of display island regions and a second edge close to a (j+1)-th column of display island regions in the row direction;

    a centerline of a display island region in an i-th row and the j-th column in the row direction is aligned with a first edge of a display island region in an (i+1)-th row and the j-th column; and
    a centerline of a display island region in the (i+1)-th row and the j-th column in the row direction is aligned with a second edge of a display island region in the i-th row and the j-th column, wherein i and j are each an integer greater than 0.

6. The display substrate according to claim 3, wherein in the column direction, one of the light-transmitting regions is aligned with a half of an adjacent display island region.

7. The display substrate according to any one of claims 3 to 6, wherein the plurality of display island regions comprise: a plurality of first display island regions and a plurality of second display island regions;

    display island regions in odd-numbered columns comprise a plurality of first display island regions arranged sequentially in the column direction, and display island regions in even-numbered columns comprise a plurality of second display island regions arranged sequentially in the column direction; and
    an arrangement order of a plurality of first light emitting elements comprised in a first display island region is different from an arrangement order of a plurality of first light emitting elements comprised in a second display island region.

8. The display substrate according to claim 4, wherein light-transmitting regions adjacent in the column direction are arranged in a staggered manner in the row direction.

9. The display substrate according to claim 8, wherein a misalignment distance in the row direction between light-transmitting regions adjacent in the column direction is greater than or equal to a length of one first pixel circuit in the row direction and smaller than or equal to lengths of a-1 first pixel circuits in the row direction.

10. The display substrate according to claim 8 or 9, wherein one of the display island regions comprises a plurality of first light emitting elements, and the plurality of first light emitting elements in the plurality of display island regions are arranged in a same manner.

11. The display substrate according to claim 2, wherein in the row direction, the display island regions and the light-transmitting regions are arranged alternately and aligned, and in the column direction, the display island regions and the light-transmitting regions are arranged alternately and aligned; and the plurality of display island regions comprise: a plurality of first display island regions and a plurality of second display island regions;

display island regions in odd-numbered columns comprise: a plurality of first display island regions arranged alternately with light-transmitting regions in the column direction, and display island regions in even-numbered columns comprise: a plurality of second display island regions arranged alternately with light-transmitting regions in the column direction; and

an arrangement order of a plurality of first light emitting elements comprised in a first display island region is different from an arrangement order of a plurality of first light emitting elements comprised in a second display island region.

12. The display substrate according to claim 7 or 11, wherein each display island region comprises four first pixel circuits arranged sequentially in the row direction, and four first light emitting elements electrically connected to the four first pixel circuits in one-to-one correspondence, and an orthographic projection of a first light emitting element on a base substrate is at least partially overlapped with an orthographic projection of a first pixel circuit to which the first light emitting element is connected on the base substrate;

the four first light emitting elements comprise: a first light emitting element emitting light of a first color, a first light emitting element emitting light of a second color, and two first light emitting elements emitting light of a third color; and

an arrangement order of first light emitting elements emitting light of the first color and first light emitting elements emitting light of the second color in a first display island region is opposite to an arrangement order of first light emitting elements emitting light of the first color and first light emitting elements emitting light of the second color in a second display island region.

13. The display substrate according to claim 2, wherein in the row direction, the display island regions and the light-transmitting regions are arranged alternately and aligned, and in the column direction, the display island regions and the light-transmitting regions are arranged alternately and aligned; each display island region comprises one first pixel circuit and one first light emitting element; the plurality of display island regions comprise: a plurality of third display island regions, a plurality of fourth display island regions, and a plurality of fifth display island regions; display island regions in odd-numbered rows comprise: a plurality of third display island regions and a plurality of fourth display island regions arranged alternately; and display island regions in even-numbered rows comprise: a plurality of fifth display island regions; and first light emitting elements in the third display island regions, the fourth display island regions, and the fifth display island regions emit light of different colors.

14. The display substrate according to claim 13, wherein one of the third display island regions comprises: one first light emitting element emitting light of the first color; one of the fourth display island regions comprises: one first light emitting element emitting light of the second color; and one of the fifth display island regions comprises: one first light emitting element emitting light of the third color.

15. The display substrate according to any one of claims 1 to 14, further comprising: a second display area located on at least one side of the first display area, wherein the second display area comprises: at least one second pixel circuit and at least one second light emitting element, wherein the at least one second pixel circuit is electrically connected to the at least one second light emitting element and configured to drive the at least one second light emitting element to emit light; and an arrangement density of first pixel circuits in the first display area is smaller than an arrangement density of second pixel circuits in the second display area.

16. The display substrate according to claim 15, wherein an arrangement density of first pixel circuits in the first display area in the row direction is 1/2 or 1/3 of an arrangement density of second pixel circuits in the second display area in the row direction.

17. The display substrate according to any one of claims 1 to 16, wherein in a direction perpendicular to the display substrate, the display substrate comprises: a base substrate, and a circuit structure layer and a light emitting structure layer located on the base substrate; the circuit structure layer comprises: a plurality of first pixel circuits, one of the first pixel circuits comprises: at least one first-type transistor, at least one second-type transistor, and a storage capacitor;

the circuit structure layer at least comprises: a first semiconductor layer, a first conductive layer, a second conductive layer, a second semiconductor layer, a third conductive layer, and a fourth conductive layer arranged on the base substrate;

the first semiconductor layer at least comprises: an active layer of the at least one first-type transistor of the first pixel circuit;

the first conductive layer at least comprises: a gate electrode of the at least one first-type transistor of the first pixel circuit, and a first electrode of the storage capacitor;

the second conductive layer at least comprises: a second electrode of the storage capacitor of the first pixel circuit, and a bottom gate of the at least one second-type transistor;

the second semiconductor layer at least comprises: an active layer of the at least one second-type transistor of the first pixel circuit;

the third conductive layer at least comprises: a gate electrode of the at least one second-type transistor of the first pixel circuit; and

the fourth conductive layer at least comprises: a plurality of connection electrodes.

18. The display substrate according to claim 17, wherein the circuit structure layer further comprises: a fifth conductive layer and a sixth conductive layer located on a side of the fourth conductive layer away from the base substrate; the fifth conductive layer at least comprises: a plurality of data lines; the sixth conductive layer at least comprises: a voltage transmission line; or, the fifth conductive layer at least comprises: a voltage transmission line, and the sixth conductive layer at least comprises: a plurality of data lines.

19. The display substrate according to claim 17, wherein the circuit structure layer further comprises: a shielding layer located on a side of the first semiconductor layer close to the base substrate;

an orthographic projection of the shielding layer on the base substrate covers an orthographic projection of the first semiconductor layer on the base substrate; or, the orthographic projection of the shielding layer on the base substrate covers orthographic projections of the first semiconductor layer and the second semiconductor layer on the base substrate.

20. A display device, comprising the display substrate according to any one of claims 1 to 19, and a sensor located on a non-display side of the display substrate, wherein an orthographic projection of the sensor on the display substrate is at least partially overlapped with the first display area of the display substrate.

21. A display substrate, comprising: a first display area, and a second display area located on at least one side of the first display area, wherein a light transmittance of the first display area is greater than a light transmittance of the second display area; the first display area comprises: a plurality of display island regions and a plurality of light-transmitting regions arranged in an array; in a row direction, the display island regions and the light-transmitting regions are arranged alternately, or in a column direction, the display island regions and the light-transmitting regions are arranged alternately;

one of the display island regions at least comprises: n first pixel circuits arranged in the row direction, with n being a positive integer greater than 0;

first pixel circuits in adjacent display island regions in the column direction are arranged in a staggered manner, and a misalignment distance in the row direction between adjacent display island regions is greater than or equal to a length of one first pixel circuit in the row direction and smaller than or equal to lengths of n first pixel circuits in the row direction.

22. The display substrate according to claim 21, wherein in the column direction, one of the light-transmitting regions is aligned with a half of an adjacent display island region.

23. The display substrate according to claim 21, wherein each display island region further comprises: n first light emitting elements electrically connected to the n first pixel circuits in one-to-one correspondence;

the plurality of display island regions comprise: a plurality of first display island regions and a plurality of second display island regions;

display island regions in odd-numbered columns comprise: a plurality of first display island regions arranged sequentially in the column direction, and display island regions in even-numbered columns comprise: a plurality of second display island regions arranged sequentially in the column direction; and

an arrangement order of the n first light emitting elements comprised in a first display island region is different from an arrangement order of the n first light emitting elements comprised in a second display island region.

FIG. 1

FIG. 2

FIG. 3

FIG. 4

FIG. 5

FIG. 6

FIG. 7

FIG. 8A

FIG. 8B

FIG. 9A

FIG. 9B

FIG. 10A

FIG. 10B

FIG. 10C

FIG. 11A

FIG. 11B

FIG. 11C

FIG. 12A

FIG. 12B

FIG. 13A

EP 4 586 235 A1

FIG. 13B

FIG. 13C

46

FIG. 14

FIG. 15A

FIG. 15B

FIG. 15C

FIG. 16

FIG. 17A

FIG. 17B

FIG. 17C

FIG. 18

FIG. 19A

FIG. 19B

FIG. 19C

FIG. 20

FIG. 21

FIG. 22

FIG. 23

FIG. 24

FIG. 25

FIG. 26A

RST1(i)  GL1(i)

391a  391b

EML(i)

RST2(i)

RST1(i+1)

GL1(i+1)

EML(i+1)

RST2(i+1)

RST1(i+2)

GL1(i+2)

EML(i+2)  RST2(i+2)

RST1(i+3)

GL1(i+3)

EML(i+3)  RST2(i+3)

Y
X

FIG. 26B

FIG. 27A

FIG. 27B

FIG. 28

FIG. 29A

GL2(i)

INIT1(i)

INIT3(i)    INIT2(i)

INIT1(i+1)

GL2(i+1)    INIT3(i+1)    INIT2(i+1)

INIT1(i+2)

GL2(i+2)

INIT3(i+2)    INIT2(i+2)

INIT1(i+3)

GL2(i+3)

INIT3(i+3)    INIT2(i+3)

Y

X

FIG. 29B

FIG. 30A

FIG. 30B

FIG. 31

FIG. 32A

FIG. 32B

FIG. 33

FIG. 34A

FIG. 34B

FIG. 35

FIG. 36

FIG. 37

FIG. 38

(j+1)-th (j+3)-th (j+5)-th (j+7)-th
column column column column

j-th (j+2)-th (j+4)-th (j+6)-th
column column column column          ......

| | j-th | (j+1)-th | (j+2)-th | (j+3)-th | (j+4)-th | (j+5)-th | (j+6)-th | (j+7)-th | | | | | |
|---|---|---|---|---|---|---|---|---|---|---|---|---|---|
| i-th row | R | | B | | R | | B | | R | | B | | R | | B | | | | |
| (i+1)-th row | | G | | G | | G | | G | | G | | G | | G | | G | | G | | G | | G | | G | | G |
| (i+2)-th row | R | | B | | R | | B | | R | | B | | R | | B | | R | | B | |
| (i+3)-th row | | G | | G | | G | | G | | G | | G | | G | | G | | G | | G | | G | | G |
| (i+4)-th row | R | | B | | R | | B | | R | | B | | R | | B | | R | | B | |
| (i+5)-th row | | G | | G | | G | | G | | G | | G | | G | | G | | G | | G | | G | | G |

1a  1d  1c  1b   A11c/A11   A11d/A11   A11e/A11   A12

Y
→X

FIG. 39

j-th column        (j+1)-th column        (j+1)-th column

| | | | | | | | | | |
|---|---|---|---|---|---|---|---|---|---|
| i-th row | R : G : B | | | B : G : R | | R : G : B | |
| (i+1)-th row | | R : G : B | | | B : G : R | | R : G : B |
| (i+2)-th row | R : G : B | | | B : G : R | | R : G : B | |
| (i+3)-th row | | R : G : B | | | B : G : R | | R : G : B |
| (i+4)-th row | R : G : B | | | B : G : R | | R : G : B | |
| (i+5)-th row | | R : G : B | | | B : G : R | | R : G : B |

L4   1a  1b  1c       1c  1d  1a       A12

A11                   A11b/A11

Y
→X

FIG. 40

| j-th column | (j+1)-th column | (j+2)-th column | (j+3)-th column | (j+4)-th column |
|---|---|---|---|---|

i-th row

| R | G | B | G | R | G | B | G | R | G | B | G | R | G | B | G | R | G | B | G |
| B | G | R | G | B | G | R | G | B | G | R | G | B | G | R | G | B | G | R | G |

Ia Ic Id Ib Ic Ia Ib Id

A11a/A11

(i+1)-th row

| B | G | R | G | B | G | R | G | B | G | R | G | B | G | R | G | B | G | R | G |
| R | G | B | G | R | G | B | G | R | G | B | G | R | G | B | G | R | G | B | G |

Ia Ic Ib Id Ic Ia Id Ib

A11b/A11

A12

Y
X

FIG. 41

A2    A1

91

92

FIG. 42

76

## INTERNATIONAL SEARCH REPORT

| International application No. |
|---|
| **PCT/CN2023/117826** |

### A. CLASSIFICATION OF SUBJECT MATTER

G09G3/3208(2016.01)i

According to International Patent Classification (IPC) or to both national classification and IPC

### B. FIELDS SEARCHED

Minimum documentation searched (classification system followed by classification symbols)

    IPC：G09G

Documentation searched other than minimum documentation to the extent that such documents are included in the fields searched

Electronic data base consulted during the international search (name of data base and, where practicable, search terms used)

    CNABS; CNTXT; CNKI; VEN; USTXT; EPTXT; WOTXT: 京东方, 间隔, 交替, 密度, 透光, 透明, 相邻, 传感, 区, 全面屏, transparen+, interv+, gap, density

### C. DOCUMENTS CONSIDERED TO BE RELEVANT

| Category* | Citation of document, with indication, where appropriate, of the relevant passages | Relevant to claim No. |
|---|---|---|
| X | CN 115020461 A (BOE TECHNOLOGY GROUP CO., LTD. et al.) 06 September 2022 (2022-09-06) description, paragraphs [0061]-[0178], and figures 1-17 | 1-16, 20-23 |
| Y | CN 115020461 A (BOE TECHNOLOGY GROUP CO., LTD. et al.) 06 September 2022 (2022-09-06) description, paragraphs [0061]-[0178], and figures 1-17 | 17-20 |
| Y | CN 115152031 A (BOE TECHNOLOGY GROUP CO., LTD.) 04 October 2022 (2022-10-04) description, paragraph [0018] | 17-20 |
| X | CN 110444125 A (HUAWEI TECHNOLOGIES CO., LTD.) 12 November 2019 (2019-11-12) description, paragraphs [0099]-[0453], and figures 1-30 | 1-16, 20-23 |
| X | CN 110061014 A (WUHAN TIANMA MICRO-ELECTRONICS CO., LTD.) 26 July 2019 (2019-07-26) description, paragraphs [0032]-[0073], and figures 1-17 | 1-16, 20-23 |
| X | CN 113795926 A (APPLE INC.) 14 December 2021 (2021-12-14) description, paragraphs [0038]-[0066], and figures 1-4D | 1-16, 20-23 |

☑ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **25 October 2023** | **24 November 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT

| | International application No. |
|---|---|
| | **PCT/CN2023/117826** |

| C. | DOCUMENTS CONSIDERED TO BE RELEVANT | |
|---|---|---|
| Category* | Citation of document, with indication, where appropriate, of the relevant passages | Relevant to claim No. |
| A | WO 2023050339 A1 (BOE TECHNOLOGY GROUP CO., LTD. et al.) 06 April 2023 (2023-04-06)<br>        entire document | 1-23 |
| A | CN 111192902 A (KUNSHAN GOVISIONOX OPTOELECTRONICS CO., LTD.) 22 May 2020 (2020-05-22)<br>        entire document | 1-23 |

Form PCT/ISA/210 (second sheet) (July 2022)

## INTERNATIONAL SEARCH REPORT
### Information on patent family members

| International application No. |
| --- |
| **PCT/CN2023/117826** |

| Patent document cited in search report | | | Publication date (day/month/year) | Patent family member(s) | Publication date (day/month/year) |
| --- | --- | --- | --- | --- | --- |
| CN | 115020461 | A | 06 September 2022 | None | |
| CN | 115152031 | A | 04 October 2022 | None | |
| CN | 110444125 | A | 12 November 2019 | None | |
| CN | 110061014 | A | 26 July 2019 | None | |
| CN | 113795926 | A | 14 December 2021 | None | |
| WO | 2023050339 | A1 | 06 April 2023 | None | |
| CN | 111192902 | A | 22 May 2020 | None | |

Form PCT/ISA/210 (patent family annex) (July 2022)